# EUROPÄISCHE PATENTSCHRIFT

(11) **EP 3 192 107 B1**
(45) Veröffentlichungstag und Bekanntmachung des Hinweises auf die Patenterteilung: **23.08.2023**
(21) Anmeldenummer: 15759465.6
(22) Anmeldetag: 07.09.2015
(51) Int. Cl.: H10K 71/12, H10K 85/30, H10K 50/11

(54) **STABILISIERTE OPTISCH AKTIVE SCHICHT UND VERFAHREN ZUR HERSTELLUNG**
STABILIZED OPTICALLY ACTIVE LAYER AND METHOD FOR PRODUCTION
COUCHE OPTIQUEMENT ACTIVE STABILISÉE ET PROCÉDÉ POUR LA RÉALISER

(30) Priorität: 08.09.2014 EP 14003092
(43) Veröffentlichungstag der Anmeldung: 19.07.2017
(73) Patentinhaber: Samsung Display Co., Ltd., Gyeonggi-do 17113 (KR)
(72) Erfinder: VOLZ, Daniel, 76137 Karlsruhe (DE)
(74) Vertreter: Jacobi, Markus Alexander
(86) Internationale Anmeldenummer: PCT/EP2015/070343
(87) Internationale Veröffentlichungsnummer: WO 2016/037963

(56) Entgegenhaltungen:
- US-A1- 2004 202 876
- KIM JAEHYUN ET AL: "Novel Layer-by-layer Complexation Technique and Properties of the Fabricated Films", CHEMISTRY OF MATERIALS, AMERICAN CHEMICAL SOCIETY, US, Bd. 11, Nr. 8, 14. Juli 1999 (1999-07-14), Seiten 2250-2256, XP002585554, ISSN: 0897-4756, DOI: 10.1021/CM990193T [gefunden am 1999-07-14]
- MAHMOUD M E ET AL: "Nano-sized Co(II)-8-hydroxyquinolate complex thin film via surface layer-by-layer chemical deposition method: Optimized factors and optical properties", POLYHEDRON, PERGAMON PRESS, OXFORD, GB, Bd. 28, Nr. 16, 14. Juli 2009 (2009-07-14) , Seiten 3407-3414, XP026683891, ISSN: 0277-5387, DOI: 10.1016/J.POLY.2009.07.016 [gefunden am 2009-07-14]
- DANIEL M ZINK ET AL: "Heteroleptic, Dinuclear Copper(I) Complexes for Application in Organic Light-Emitting Diodes", CHEMISTRY OF MATERIALS, AMERICAN CHEMICAL SOCIETY, WASHINGTON, DC, US, vol. 25, no. 22, 1 January 2013 (2013-01-01), pages 4471-4486, XP002751586, ISSN: 1520-5002, DOI: 10.1021/CM4018375 [retrieved on 2013-10-17]

## Beschreibung

Die vorliegende Erfindung betrifft ein Verfahren zur Aufbringung einer lichtemittierenden Schicht S auf die Oberfläche eines Bauteils T, umfassend das Aufbringen einer Zusammensetzung Z1, enthaltend mindestens ein Salz eines nicht-komplexierten Metalls M, und einer Zusammensetzung Z2, enthaltend mindestens einen nicht-komplexierten Liganden L, auf die Oberfläche des Bauteils T, wobei das Verfahren ferner wie in den Ansprüchen definiert ist. Ferner beschreibt die vorliegende Offenbarung eine lichtemittierende Schicht S, umfassend eine Emitterverbindung E, die ein Metall-Komplex aus einem oder mehreren Liganden L und einem oder mehreren Metallen M ist, und entweder ein Salz eines nicht-komplexierten Metalls M oder einen nicht-komplexierten Liganden L.

Opto-elektronische Vorrichtungen auf der Grundlage von organochemischen Verbindungen, wie beispielsweise organische Leuchtdioden (engl. "organic light emitting diodes", OLEDs), lichtemittierende elektrochemische Zellen (engl. "light emitting electrochemical cells", LECs), organische Laser, organische Solarzellen (engl. "organic solar cells", OSCs) und optische Sensoren, gewinnen zunehmend an praktischer Bedeutung. Besonders OLEDs und LECs sind vielversprechende Bauteile in elektronischen Vorrichtungen, wie beispielsweise Bildschirmen, aber auch in der Beleuchtungstechnik. Im Gegensatz zu den meisten anorganisch basierten opto-elektronischen Vorrichtungen sind solche, auf organochemischen Verbindungen basierenden Vorrichtungen häufig biegsam und in besonders dünner Schichtdicke herzustellen. Die bereits verfügbaren OLED-Bildschirme bestechen durch hohe Farbbrillanz, hohe Kontraste und Energieeffizienz.

Die hierbei verwendeten optisch aktiven Materialien (Emitter- bzw. Absorber-Verbindungen) werden in die optisch aktive Schicht (lichtemittierende bzw. absorbierende Schicht) der entsprechenden opto-elektronischen Vorrichtung eingebracht. Seit einigen Jahren werden hierzu vermehrt Metall-Komplexe eingesetzt, um die Quantenausbeute zu maximieren. Die hierbei vom Metall induzierte Spin-Bahn-Kopplung resultiert in einer erhöhten Intersystem-Crossing-Rate (engl. "intersystem crossing rate", ISC-Rate), also dem Wechsel vom angeregten Singulett zum Triplett-Zustand und umgekehrt, und führt somit zu einer Nutzung sowohl der Singulett- als auch der Triplett-Exzitonen für die Emission. Dies ermöglicht eine theoretisch erreichbare innere Quantenausbeute von 100 Prozent.

Teilweise werden die optisch aktiven Schichten mittels Sublimation durch Vakuumprozessierung hergestellt (Liu et al., Chem. Mater. 2014, 26(7), 2368-2373; Liu., J. Am. Chem. Soc. 2011, 133, 3700-3703; Schmid, Adv. Mater. 2014, 26, 878-885). Dies erfordert die Anwendung vergleichsweise komplexer Herstellungsvorrichtungen und erschwert so die ökonomische Massenproduktion der opto-elektronischen Vorrichtungen.

DE 102011017572 beschreibt das schichtweise Aufbringen von Metallen/Metallsalzen sowie Liganden aus Lösung oder Gasphase. Dieses Verfahren eignet sich nicht zur Synthese von Emitterverbindungen, da zwischen den nacheinander aufgebrachten Filmen bzw. Schichten kein Austausch durch Diffusion mehr stattfindet. Die Emitterverbindungen entstehen aber erst durch chemische Reaktion zwischen den Komponenten. In amorphen organischen Festkörpern liegen wie dem Fachmann bekannt ist nur geringe Diffusionskoeffizienten vor, sodass sich die erwünschte Emitterverbindung unter diesen Verbindungen nicht ausbilden kann. Um die in DE 102011017572 beschriebene Mehrschichtarchitektur durch einen Lösungs-basierten Prozess herzustellen, ist es auch erforderlich, mit Quervernetzungs-verfahren zu arbeiten, um die Moleküle durch kovalente Anbindung in den jeweiligen Schichten zu fixieren. Unter diesen Umständen sind die ohnehin geringen Diffusionskoeffizienten in Festkörpern weiter reduziert.

WO 2012/016074 beschreibt, dass Metallsalze und zusätzlichen Liganden in stöchiometrischem Verhältnis miteinander kombiniert durch Gasphasenabscheidung auf einem Substrat abgeschieden werden können. Dieses Verfahren hat jedoch mehrere Nachteile: erstens können für dieses Verfahren ausschließlich verdampfbare Metallsalze und Liganden verwendet werden, wodurch beispielsweise nicht verdampfbare Salze wie polymere Kupferthiolate, -acetylide sowie polymer-gebundene Liganden sowie geladene Liganden aufgrund mangelnder Verdampfbarkeit nicht verwendet werden können. Dies schränkt die Flexibilität des Verfahrens ein.

Zweitens ist es technisch durch Gasphasenabscheidung nur schwer realisierbar, mehr als zwei Komponenten zeitgleich abzuscheiden. Hostmaterialien, die für die Einstellung der Ladungsträgerbilanz und Stabilisierung der Morphologie von Bedeutung sind, lassen sich demnach nicht ohne weiteres verwenden. Drittens schränkt die kombinierte Abscheidung von Liganden und Metall aus der Gasphase, die chemisch betrachtet dem sogenannten "chemischen Transport" (vgl. Mond-Verfahren) ähnelt, die zugänglichen Moleküle *per* se ein, da nur jene Spezies verarbeitet werden können, die aufgrund von thermodynamischer Bevorzugung in der Gasphase gebildet werden. In Lösung gebildete kinetische Reaktionsprodukte sind entsprechend nicht zugänglich. Auch die Dotierung mit einem kleinen Überschuss an freiem Liganden oder Metallsalz kann aus stöchiometrischen Gründen nicht durchgeführt werden. Viertens ist die Optimierung der gleichzeitigen Aufbringung von Metallsalzen und Liganden aus der Gasphase aufgrund der Vielzahl an Parametern nur unter erheblichem Aufwand möglich. Dem steht entgegen, dass die Entwicklung von möglichst effizienten Emissionsschichten eine Vielzahl an empirischen Experimenten erfordert.

Es besteht somit ein Bedürfnis, einfache und automatisierbare Verfahren bereitzustellen, um optisch aktive Schichten mit verbesserten Eigenschaften herzustellen und auf Bauteilen aufzutragen.

Als vielversprechendes alternatives Herstellungsverfahren kann auf die Flüssigprozessierung zurückgegriffen werden. Hierbei werden die Bestandteile der optisch aktiven Schicht, einschließlich der als Emitter- bzw. Absorber-Verbindungen dienenden Metall-Komplexe, in flüssiger Form auf das Bauteil aufgebracht. Dies hat den Vorteil, dass entgegen anderen denkbarer Herstellungsverfahren, wie etwa der Vakuumprozessierung, keine komplexen Herstellungsvorrichtungen notwendig sind, da unter Normaldruck gearbeitet werden kann. Dies erleichtert die Massenproduktion der opto-elektronischen Vorrichtungen.

In der Opto-Elektronik gilt, dass unabhängig von der Prozessierungstechnik, die chemischen Komponenten in der optisch aktiven Schicht möglichst rein vorliegen müssen (So and Kondakov, Adv. Mater. 2010, 22, 3762-3777; Yamamoto et al., Appl. Phys. Lett. 2012, 100, 183306). Demnach werden, insbesondere bei der Flüssigprozessierung, die hierbei eingesetzten Metall-Komplexe in aufgereinigter Form bereitgestellt, um als Emitter- bzw. Absorber-Verbindungen in die optisch aktive Schicht auf einem Bauteil aufgebracht zu werden. Das hat zum einen den Nachteil, dass die Aufreinigungsprozesse arbeitsaufwendig sind. Zum anderen führen sie zu einem Verlust an Ausbeute.

WO 2012/016074 beschreibt das flüssigprozessuale kombinierte Abscheiden einer Mischung von Lösungen, die Metallkomplexe und Liganden enthalten. Das kombinierte Abscheiden einer Mischung von Lösungen ermöglicht jedoch nicht die vollständige Flexibilität bezüglich der Kombinationen von Metallsalzen und Liganden. Kim et al. (Chem. Mater., 1999, 11:2250-2256) lehrt ein Verfahren, bei dem eine Metall-bindende Verbindung auf einen Träger aufgebracht und dann mit Eu³⁺-Ionen in Kontakt gebracht wird. Mahmoud et al. (Polyhedron, 2009, 28:3407-3414) lehrt das zeitlich versetzte Aufbringen von Co²⁺-Ionen und einer diese komplexierenden Verbindung. US-A 2004/0202876 lehrt Porphyrin-Polymere, die auf einem Substrat fixiert werden und Metallionen binden. Zink et al. (Chem. Mater. 2013, 25:4471-4486) lehrt Cu(I)-Komplexe, die aus Cu(I)-Salz und Liganden hergestellt werden, indem die Komponenten in einer Lösung über längere Zeit durch Rühren miteinander vermischt werden.

Überraschend wurde gefunden, dass voneinander unabhängige Zusammensetzungen von ungebundenen Metallsalzen und deren Liganden und von Wirtsmolekülen, ohne miteinander kombiniert zu sein, daher vor dem Abscheiden miteinander gemischt zu werden, in flüssiger Phase auf ein Bauteil aufgebracht und anschließend getrocknet werden können. Dabei müssen Metallsalz und Ligand nicht notwendigerweise in einem stöchiometrischen Verhältnis mit einander umgesetzt werden.

Dies ermöglicht zum einen, dass für die jeweilige Komponente besonders geeignete bzw. optimale Lösungsmittel verwendet werden können, die nicht zwangsweise miteinander mischbar sein müssen. Zum anderen kann die Stöchiometrie der Komponenten frei gewählt werden. Dies ermöglicht auch, optisch aktive Schichten bereitzustellen, die ungebundenes Metallsalz oder ungebundenen Liganden enthalten, die dann als Additiv wirken können. Es ist dabei günstig, die Funktion von Ligand und Host nicht zwangsläufig in einem Molekül zu kombinieren, da unter Umständen beispielsweise die Zugabe eines Überschusses von Host den Energieübertrag von Host auf Gast/Emitter negativ beeinflussen kann, bzw. womöglich dass hinsichtlich einer Energieübertragung optimierte Verhältnis von Metallsalz und Host-Ligand von jenem Verhältnis, welches für eine gute Morphologie optimiert wurde, abweicht, sodass in binären Metallsalz-Host-Ligand-Systemen die gleichzeitige Optimierung von Morphologie und Energieübertrag schlechterdings nicht möglich ist.

Erweitert man die Zahl der Verbindungen hingegen auf drei und mehr, so ist diese gleichzeitige Optimierung aller relevanten Eigenschaften wiederum möglich. Dies kann die physikochemischen Eigenschaften der lichtemittierenden Schicht signifikant verbessern. Ein Überschuss an freiem Liganden kann dabei die unerwünschte Kristallisation einzelner Verbindungen bzw. die Co-Kristallisation von Host- und Emitter während der Prozessierung unterdrücken und so die Filmbildung und Morphologie beeinflussen. Im Gegensatz zu bisher beschriebenen Verfahren nach Thompson, bei denen aus technischen Gründen nur zwei Komponenten zeitgleich prozessiert wurden, können so über drei und mehr Stellschrauben die Morphologie eingestellt werden. Das Verhältnis an Emitter und Host ist demnach so zu optimieren, dass ein optimaler Energieübertrag zwischen Host und Gast stattfinden, während der Überschuss an freiem Liganden der Einstellung der Morphologie dient. Wird ein Überschuss an Metallsalz gewählt, so kann dies ebenfalls der Optimierung der Morphologie dienen, jedoch kommen weitere Stellschrauben wie die Optimierung des Dipolmomentes der Emissionsschicht sowie der Ladungstransporteigenschaften hinzu, die durch die hohe Polarität der verwendete Metallsalze ermöglicht wird.

Ein erster Aspekt der vorliegenden Erfindung betrifft ein Verfahren zur Aufbringung einer lichtemittierenden Schicht S auf der Oberfläche eines Bauteils T, umfassend die Schritte:
(i) Bereitstellen von:
   (a) einer Zusammensetzung Z1 enthaltend mindestens ein Salz eines nicht-komplexierten Metalls M und mindestens ein koordinierendes Lösungsmittel,
   (b) einer Zusammensetzung Z2 enthaltend mindestens einen nicht-komplexierten Liganden L, der das Metall M komplexieren kann, und optional
   (c) einer Zusammensetzung Z3 enthaltend mindestens ein Wirtsmolekül W, das eine Matrix für die lichtemittierende Schicht S bilden kann;
(ii) Aufbringen der Zusammensetzungen Z1, Z2 und optional Z3 in flüssiger Phase auf die Oberfläche des Bauteils T; und optional
(iii) Trocknen und/oder Aushärten der durch das Aufbringen erhaltenen Schicht S auf der Oberfläche des Bauteils T,
   dadurch gekennzeichnet, dass die Zusammensetzungen Z1 und Z2 als zwei separate Zusammensetzungen gleichzeitig auf die Oberfläche des Bauteils T aufgebracht werden, wobei sich die Zusammensetzungen Z1, Z2 und optional Z3 auf der Oberfläche selbst mischen.

Dieses Verfahren stellt eine Flüssigprozessierung (auch "Filmprozessierung" oder "Nassprozessierung") dar, da die Zusammensetzungen Z1, Z2 und optional Z3 in flüssiger Phase auf die Oberfläche des Bauteils T aufgebracht werden. Dieses *in* situ-Vorgehen kann auch als "Chemie in der Schicht" (engl. "chemistry in the layer", CITL) bezeichnet werden.

Erfindungsgemäß werden die Zusammensetzungen Z1, Z2 und optional Z3 nicht vor dem Aufbringen auf die Oberfläche miteinander vermischt, sondern unabhängig von einander, daher nicht miteinander kombiniert, aufgebracht. Erst auf der Oberfläche mischen sich die Zusammensetzungen Z1, Z2 und optional Z3 optional miteinander.

Dabei wird ein Austausch zwischen dem mindestens einen Salz eines nicht-komplexierten Metalls M und dem mindestens einen nicht-komplexierten Liganden L, der das Metall M komplexieren kann, ermöglicht, etwa indem sich die Zusammensetzungen Z1 und Z2 und optional Z3, die alle flüssig sind nach der Aufbringung ganz oder teilweise miteinander vermischen.

Das erfindungsgemäße Verfahren eröffnet zudem neue Wege zur Materialentwicklung. Ein kombinatorisches Screening von unterschiedlichen Kombinationen einer Reihe von Metallen M mit einer Reihe von Liganden L und optional einer Reihe von Wirtsmolekülen W wird ermöglicht. Durch Verwendung heute gängiger Automationsprozesse, etwa durch Verwendung von Pipetierrobotern, Mikrotiterplatten und optischen Ausleseeinheiten, kann ein Hochdurchsatz-Screening verschiedener Metalle M und Liganden L in variablen M:L-Stöchiometrien durchgeführt, und das Ergebnis dann ausgelesen werden. Durch Hinzufügen weiterer Komponenten, wie beispielsweise von Wirtsmolekülen W oder Additiven, die beispielsweise die Viskosität optimieren, lassen sich ganze lichtemittierende Schichten S auf diese Weise automatisiert optimieren.

Ferner ermöglicht das erfindungsgemäße Verfahren auch die Herstellung von lichtemittierenden Schichten S, umfassend schwerlösliche Metall-Komplexe, die durch klassische Herstellungsverfahren zwar selbst erhältlich aber bislang nicht zu lichtemittierenden Schichten S prozessierbar sind, da die Auftragung als Schicht misslingt. Derartige Materialien sind häufig im Verlauf der Reaktion zunächst gelöst, fallen oft während der Synthese nach der Isolierung in Substanz als unlösliche Stoffe an und können auch in der Wärme nach abgeschlossener Kristallisation nicht wieder in Lösung gebracht werden.

Eine lichtemittierende Schicht S im Sinne der vorliegenden Erfindung ist im weitesten Sinne zu verstehen als jede optisch aktive Schicht, die in der Lage ist, unter bestimmten Bedingungen in einer opto-elektronischen Vorrichtung Licht zu emittieren. Die lichtemittierende Schicht S kann demnach tatsächlich verwendet werden, um Licht zu erzeugen. Sie kann aber auch anders verwendet werden, etwa um Licht zu absorbieren und in elektrische Energie (Ladungstrennung bzw. Stromfluss) umzuwandeln.

Unter einer Schicht im Sinne der vorliegenden Erfindung ist bevorzugt eine weitgehend planare Geometrie zu verstehen. Die lichtemittierende Schicht S ist bevorzugt nicht dicker als 1 mm, stärker bevorzugt nicht dicker als 0,1 mm, stärker bevorzugt nicht dicker als 10 µm, noch stärker bevorzugt nicht dicker als 1 µm, insbesondere nicht dicker als 0,1 µm.

Ebenso ist die Emitterverbindung E im Sinne der vorliegenden Erfindung im weitesten Sinne zu verstehen als jede optisch aktive Verbindung, die in der Lage ist, unter bestimmten Bedingungen in einer opto-elektronischen Vorrichtung Licht zu emittieren. Die Emitterverbindung E kann demnach tatsächlich verwendet werden, um Licht zu erzeugen. Sie kann aber auch anders verwendet werden, etwa um Licht zu absorbieren und in elektrische Energie umzuwandeln.

Zur Erzeugung von Licht oder elektrischer Energie aus Licht wird ein Bauteil T, das mindestens eine lichtemittierende Schicht S umfasst, typischerweise in oder an die opto-elektronische Vorrichtung gebaut. Meist wird zur Erzeugung von Licht der lichtemittierenden Schicht S in der opto-elektronischen Vorrichtung elektrisch oder chemisch Energie zugeführt, insbesondere wird elektrische Energie zugeführt. Zur Zuführung von Energie kann Strom angeschlossen werden, wobei der Stromfluss durch die lichtemittierende Schicht S die darin enthaltenen Emitterverbindungen E so anregt, dass sogenannte Exzitone entstehen, die unter Abstrahlung von Licht in den Grundzustand relaxieren können.

Der Aufbau von möglichen opto-elektronischen Vorrichtungen ist dem Fachmann bekannt und wird zudem unten stehend beispielhaft erläutert.

Das Bauteil T wie hierin verwendet kann im weitesten Sinne jedes technische Element sein, das die lichtemittierende Schicht S trägt. Der Aufbau hängt davon ab, für welche Art von opto-elektronischer Vorrichtung das Bauteil T vorgesehen ist. Gemäß einer bevorzugten Ausführungsformweist das Bauteil T eine (weitgehend) planare Oberfläche auf, auf die die Zusammensetzungen Z1 und Z2 und optional Z3 aufgebracht werden.

Bei den meisten opto-elektronischen Vorrichtungen enthält das Bauteil T ein Substrat (z.B. eine Glas- oder Kunststoffplatte oder eine Metallfolie) und entweder eine Anodenschicht A (z.B. eine Indium-Zinn-Oxid-Schicht) oder eine Kathodenschicht C (z.B. aus einem Metall oder einer Metalllegierung, wie beispielhaft aus Al, Mg oder Ca). Bevorzugt enthält das Bauteil T ein Substrat und eine Anodenschicht A.

Wenn das Bauteil T beispielsweise für eine organische Leuchtdiode (OLED) vorgesehen ist, enthält das Bauteil T bevorzugt zusätzlich eine Lochleitungsschicht, z.B. aus elektronenreichen Heteroaromaten wie Triarylaminen und/oder Carbazolen, (wie beispielhaft Tris(4-carbazoyl-9-ylphenyl)amin (TCTA)). Optional kann das für eine OLED vorgesehene Bauteil T noch eine Lochinjektionsschicht (z.B. Poly-3,4-ethylendioxythiophen (PEDOT) und/oder Polystyrolsulfonat (PSS)) enthalten. Weitere Beispiele für die Zusammensetzung der einzelnen Schichten und den Aufbau einer OLED sind dem Fachmann allgemein bekannt und exemplarisch unten erläutert.

Alternativ kann eine OLED auch in umgekehrter Orientierung hergestellt werden. Dann kann das Bauteil T folgende Schichten umfassen: eine Elektronenleitungsschicht (z.B. umfassend eine elektronenarme Verbindung, wie Benzimidazole, Pyridine, Triazole, Phosphinoxide und Sulfone, einen sternförmigen Heterozyklus wie 1,3,5-Tri(1-phenyl-1H-benzo[d]imidazol-2-yl)phenyl (TPBi)), eine Kathodenschicht C (z.B. aus einem Metall oder einer Metalllegierung, wie beispielhaft aus Al, Mg oder Ca) und einer Schutzschicht bzw. Substrat.

Die Oberfläche des Bauteils T, auf die die Zusammensetzungen Z1, Z2 und optional Z3 aufgebracht werden, kann eine beliebige Oberfläche des Bauteils T sein. Auf welche Oberfläche des Bauteils T die Zusammensetzungen Z1, Z2 und optional Z3 aufgebracht werden, hängt davon ab, in welcher opto-elektronischen Vorrichtung das Bauteil T verwendet werden soll.

Wenn das Bauteil T beispielsweise für eine organische Leuchtdiode (OLED) vorgesehen ist, ist die Oberfläche bevorzugt entweder eine Lochleitungsschicht (z.B. umfassend einen elektronenreichen Heteroaromaten, wie ein Triarylamin und/oder ein Carbazol wie etwa Tris(4-carbazoyl-9-ylphenyl)amin (TCTA)) oder eine Elektronenleitungsschicht (z.B. umfassend eine elektronenarme Verbindung, wie etwa ein Benzimidazol, Pyridin, Triazol, Phosphinoxid oder Sulfon oder einen sternförmigen Heterozyklus, wie 1,3,5-Tri(1-phenyl-1H-benzo[d]imidazol-2-yl)phenyl (TPBi)). Besonders bevorzugt ist die Oberfläche eine solche einer Lochleitungsschicht. Als Elektronentransporter-Materialien können optional auch Verbindungen eingesetzt werden, wie sie in WO 2012/130571 offenbart sind.

Wenn das Bauteil T beispielsweise für eine lichtemittierende elektrochemische Zelle (LEC) vorgesehen ist, ist die Oberfläche bevorzugt eine Elektrodenschicht (z.B. eine Schicht aus Indium-Zinn-Oxid oder einem Metall oder einer Metalllegierung, wie beispielhaft aus Al, Mg oder Ca).

Die Zusammensetzungen Z1, Z2 und Z3 sind bevorzugt Lösungen, daher flüssige Zusammensetzungen, in denen die jeweiligen Komponenten in gelöster (solvatisierter) Form enthalten sind. Im Druckverfahren werden derartige Lösungen auch als Tinten bezeichnet. Auch Dispersionen sind einsetzbar.

Bevorzugt enthält die Zusammensetzung Z1 mindestens ein Salz eines nicht-komplexierten Metalls M und mindestens ein Lösungsmittel, in dem das mindestens eine Salz löslich ist. Besonders bevorzugt sind solche koordinierenden Lösungsmittel, in denen sowohl Z1 und Z2 als auch optional Z3 löslich sind. Ein koordinierendes Lösungsmittel ist beispielsweise ein Lösungsmittel ausgewählt aus der Gruppe bestehend aus Tetrahydrothiophen, Benzonitril, Pyridin, einem Nitril (z.B. Acetonitril), einem Thioether, Trihydrofuran, Triarylamin und Toluol. Es können auch Kombinationen verschiedener Lösungsmittel verwendet werden. Ganz besonders bevorzugt ist Acetonitril. Das gelöste, mindestens eine Salz kann dann in flüssiger Form auf die Oberfläche des Bauteils T aufgebracht werden.

Ein in der Zusammensetzung Z1 enthaltenes Salz kann ein Salz eines beliebigen nicht-komplexierten Metalls M sein. Das Metall M kann jedes Metall sein, das in der Lage ist, komplexiert zu werden, und dabei einen Metall-Komplex zu bilden, der in der Lage ist, als Emitterverbindung E zu dienen. Bevorzugt ist das Metall M ein Übergangsmetall (Schwermetall).

Bevorzugt ist das Metall M ausgewählt aus: der Gruppe bestehend aus Cu, Ag, Au, Pd, Pt, Zn, Sn, Ir, Ni, Fe, Cd, Hg, Os und Re. Noch stärker bevorzugt ausgewählt aus der Gruppe bestehend aus Cu, Ag und Au, insbesondere Cu. Bevorzugt ist das Metall M ein Metall(I). Stärker bevorzugt ist das Metall M ausgewählt aus der Gruppe bestehend aus Cu(I), Ag(I) und Au(I), insbesondere Cu(I).

Ein in der Zusammensetzung Z1 enthaltenes Salz kann ein Salz eines beliebigen Anions sein. Das Salz des Metalls M ist bevorzugt ein Halogenidsalz (insbesondere ein Salz mit Cl⁻-Anionen), ein Cyanidsalz (daher ein Salz mit CN⁻-Anionen), ein Thiocyanatsalz (daher ein Salz mit SCN⁻-Anionen), ein Thiolatsalz (daher ein Salz mit R-S⁻-Anionen, wobei R ein beliebiger organischer Rest mit 1-40 Kohlenstoffatomen ist, bevorzugt ein unsubstituierter oder substituierter C₁₋₂₀-Alkylrest, ein unsubstituierter oder substituierter C₂₋₂₀-Alkyenrest, ein unsubstituierter oder substituierter C₂₋₂₀-Alkinylrest, ein unsubstituierter oder substituierter Phenylrest, ein unsubstituierter oder substituierter Benzylrest, ein unsubstituierter oder substituierter Pyridylrest, ein unsubstituierter oder substituierter Pyrimidinrest, ein unsubstituierter oder substituierter Purinrest, ein unsubstituierter oder substituierter Indolylrest oder ein unsubstituierter oder substituierter Naphtylrest) oder ein Acetylidsalz (daher ein Salz mit R-C≡C⁻-Anionen, wobei R ein beliebiger organischer Rest mit 1-40 Kohlenstoffatomen ist, bevorzugt wobei das der Acetylidgruppe benachbarte Kohlenstoffatom keine Mehrfachbindung trägt, besonders bevorzugt ist R hierbei ein unsubstituierter oder substituierter C₁₋₂₀-Alkylrest, ein unsubstituierter oder substituierter C₃₋₂₀-Alkyenrest, ein unsubstituierter oder substituierter C₃₋₂₀-Alkinylrest, ein unsubstituierter oder substituierter Phenylrest, ein unsubstituierter oder substituierter Benzylrest, ein unsubstituierter oder substituierter Pyridylrest, ein unsubstituierter oder substituierter Pyrimidinrest, ein unsubstituierter oder substituierter Purinrest, ein unsubstituierter oder substituierter Indolylrest oder ein unsubstituierter oder substituierter Naphtylrest).

Bevorzugt ist das Anion des Salzes ausgewählt aus der Gruppe bestehend aus I⁻, Br⁻, Cl⁻, SCN⁻ und CN⁻. Noch stärker bevorzugt ist das Salz ein lodid- oder Chloridsalz. Besonders bevorzugt ist das Salz ein Iodidsalz. Besonders bevorzugt wird ein Salz ausgewählt aus der Gruppe bestehend aus: Cul, Agl, Aul, CuBr, AgBr, AuBr, CuCI, AgCl, AuCl, CuSCN, AgSCN, AuSCN, CuCN, AgCN und AuCN. Ganz besonders bevorzugt ist das Salz CuI (Kupferiodid).

Bevorzugt enthält die Zusammensetzung Z2 mindestens einen nicht-komplexierten Liganden L, der das Metall M komplexieren kann, und mindestens ein Lösungsmittel, in dem der Ligand L löslich ist. Jeder Ligand L ist bevorzugt niedermolekular, daher weist L bevorzugt eine Molekulargewicht von nicht mehr als 5 kDa, stärker bevorzugt von nicht mehr als 2 kDa, insbesondere nicht mehr als 1 kDa auf. Häufig ist das Molekulargewicht nicht größer als 500 kDa.

Besonders bevorzugt sind solche Lösungsmittel, in denen sowohl Z1 und Z2 als auch optional Z3 löslich sind, oder das mit einem Lösungsmittel mischbar ist, in dem diese löslich sind. Daher sind koordinierende Lösungsmittel bevorzugt, wie solche ausgewählt aus der Gruppe bestehend aus der Gruppe bestehend aus Tetrahydrothiophen, Benzonitril, Pyridin, einem Nitril (z.B. Acetonitril), einem Thioether, Trihydrofuran, Triarylamin und Toluol. Es können auch Kombinationen verschiedener Lösungsmittel verwendet werden. Der gelöste, mindestens eine Ligand L kann dann in flüssiger Form auf die Oberfläche des Bauteils T aufgebracht werden.

Der Ligand L ist bevorzugt ein organochemischer Ligand, daher überwiegend aus Kohlenstoff, Stickstoff, Phosphor und Wasserstoff besteht. Der Ligand L kann ein solcher sein, der mit dem Metall M einen monodentaten oder einen bidentaten Metall-Komplex bilden kann. Bevorzugt werden zwei Metalle M in einem Metall-Komplex komplexiert.

Der Metall-Komplex kann homoleptisch (gleichartige Liganden) oder heteroleptisch (verschiedenartige Liganden) sein.

Beispielsweise kann ein Ligand L ein solcher sein, wie er in WO 2013/072508, WO 2013/007709, WO 2013/007710 oder WO 2013/014066 beschrieben ist. In diesen Dokumenten wird auch beschrieben, wie ein derartiger Ligand L hergestellt werden kann und wie ein Metall-Komplex daraus gebildet werden kann.

Der Ligand L kann jeder Ligand sein, der in der Lage ist, allein oder zusammen mit anderen Liganden das Metall M zu komplexieren.

Beispielsweise kann ein Ligand L ausgewählt sein aus der Gruppe bestehend aus: 4-Methyl-2-(diphenylphosphino)-pyridin (MePyrPHOS), 4-Heptyl-2-(diphenylphosphino)-pyridin, 4-Butin-1-yl-(diphenylphosphino)-pyridin (ButinylPyrPHOS), 2-Diphenylphosphino-4-(4-vinyl-phenethyl)-pyridine und Poly-(2-diphenylphosphino-4-(4-vinyl-phenethyl)-pyridin) (poly-16). Besonders bevorzugt ist der Ligand L MePyrPHOS.

Auch kann ein Ligand wie in unten stehenden Ausführungsformen dargestellt verwendet werden.

Besonders bevorzugte Ausführungsformen sind auch in den unten stehenden experimentellen Beispielen gezeigt.

Bevorzugt enthält die Zusammensetzung Z3, sofern vorhanden, mindestens ein Wirtsmolekül W und mindestens ein Lösungsmittel, in dem das Wirtsmolekül W löslich ist. Besonders bevorzugt sind solche Lösungsmittel, in denen sowohl Z1 und Z2 als auch optional Z3 löslich sind. Daher sind koordinierende Lösungsmittel bevorzugt, in denen sowohl Z1 und Z2 als auch optional Z3 löslich sind, oder die mit einem Lösungsmittel mischbar sind, in dem diese löslich sind. Daher sind koordinierende Lösungsmittel bevorzugt wie solche ausgewählt aus der Gruppe bestehend aus: Tetrahydrothiophen, Benzonitril, Pyridin, Acetonitril, Trihydrofuran, Triarylamin und Toluol. Ganz besonders bevorzugt ist Acetonitril. Das gelöste mindestens eine Wirtsmolekül W kann dann in flüssiger Form auf die Oberfläche des Bauteils T aufgebracht werden.

Ein Wirtsmolekül W kann beispielsweise eine polymere Struktur aufweisen. Diese sind häufig besonders gut in der Flüssigprozessierung einsetztbar. Ein Wirtsmolekül W sollte im Idealfall weitere Aufgaben übernehmen, wie eine räumliche Trennung zwischen der Emitterverbindung E und von Farbstoffen F zur Vermeidung unerwünschter (Konzentrations-)Quenchprozesse (engl. "quenching") und Triplett-Triplett-Annihilierung unter Emissionsminderung, sowie möglicherweise verbesserte Ladungsträgerinjektion, verbesserten Ladungstransport und eine erhöhte Rekombinationswahrscheinlicheit direkt auf den Emitterverbindungen E ermöglichen. Es können die in WO 2013/007709 oder WO 2013/007710 beschriebenen Wirtsmoleküle W (Hostmoleküle, Matrixmoleküle) verwendet werden, die auch nichtkovalent vorliegen können. Insbesondere zur Herstellung von LECs können auch Guanidium-Verbindungen, wie in WO 2012/130571 beschrieben und/oder Polyethylenoxid (PEO), verwendet werden.

Der Schritt (i) des Bereitstellens kann auf beliebige Weise erfolgen. Beispielhaft können derartige Zusammensetzungen Z1, Z2 und/oder optional Z3 kommerziell erhältlich sein. Alternativ kann ein Ligand L, ein Metall M und/oder ein Wirtsmolekül W jeweils in einem geeigneten Lösungsmittel gelöst und so die jeweilige Zusammensetzung erhalten werden.

Der Schritt (ii) des Aufbringens der Zusammensetzungen Z1, Z2 und optional Z3 auf die Oberfläche des Bauteils T kann mittels eines beliebigen Verfahrens, wie beispielsweise durch Rotationsbeschichtung (engl. "spin coating"), Dropcasting, Schlitzguss, Vorhangguss, einem Walzverfahren oder einem Druckverfahren (z.B. Tintenstrahldruck (engl. "inkjet printing"), Tiefdruck oder Rakeln) erfolgen.

Hierbei können die Zusammensetzungen Z1, Z2 und/oder optional Z3 auch ein verdampfbares organisches Lösungsmittel enthalten, wie beispielsweise ein Lösungsmittel ausgewählt aus der Gruppe bestehend aus:
Tetrahydrofuran, Dioxan, Chlorbenzol, Diethylenglykoldiethylether, Diethylenglykolmonoethylether, gamma-Butyrolacton, N-Methylpyrollidinon, Ethoxyethanol, Xylol, Toluol, Anisol, Phenetol, Acetonitril, Tetrahydrothiophen, Benzonitril, Pyridin, Trihydrofuran, Triarylamin und PGMEA (Propylenglykol-Monoethyletheracetat). Es können auch Kombinationen aus zwei oder mehr Lösungsmitteln verwendet werden.

Optional können der auf die Oberfläche aufzubringenden flüssigen Zusammensetzung Z1, Z2 und/oder optional Z3 auch Mittel zur Verbesserung der Flusseigenschaften beigemischt werden. Derartige Mittel sind dem Fachmann wohlbekannt. Beispielsweise kann ein solches Mittel bzw. Komponente ausgewählt sein aus der Gruppe bestehend aus:
Polyethyloxiden ( Polyethylenglykolen), Polyethylendiaminen, Polyacrylaten (z.B. Polymethylmethacrylat (PMMA), Polyacrylsäure und deren Salze (Superabsorber)), substituierten oder unsubstituierten Polystyrolen (z.B. Polyhydroxystyrol), Polyvinylalkoholen, Polyestern oder Polyurethanen, Polyvinylcarbazolen, Polytriaryaminen, Polythiophenen und Polyvinylidenphenylenen. Es können auch Kombinationen aus zwei oder mehr Mitteln verwendet werden.

Durch das Aufbringen der Zusammensetzung in flüssiger Phase entsteht eine, einen Metall(I)-Komplex bzw. die Zusammensetzung Z enthaltende Nassphase, die anschließend mit üblichen, im Stand der Technik bekannten Verfahren getrocknet und/oder ausgehärtet werden kann.

Durch das Aufbringen der Zusammensetzungen Z1, Z2 und optional Z3 in flüssiger Phase auf die Oberfläche des Bauteils T entsteht ein Nassfilm, in dem sich an Ort und Stelle (*in situ*) aus dem/den Metall(en) M, aus dem in Z1 enthaltenen Salz und dem/den Liganden L aus Z2 die Metall-Komplexe bilden, die Emitterverbindungen E darstellen.

Der aus dem einen oder den mehreren Metall(en) M und dem einen oder den mehreren Ligand(en) L gebildete Metall-Komplex kann im Prinzip jede denkbare Stöchiometrie annehmen. Bevorzugt handelt es sich um einen Komplex, der eine Stöchiometrie aufweist, ausgewählt aus der Gruppe bestehend aus M₂L₂, M₂L₃, M₁L₁, M₁L₂, M₁L₃, M₁L₄, M₂L₁ und M₂L₄. Stärker bevorzugt wird er ausgewählt aus der Gruppe bestehend aus M₂L₂, M₂L₃, M₁L₁ und M₁L₂, insbesondere M₂L₂ oder M₂L₃. Hierbei stellt L nur die organochemischen Liganden L dar, die gleichartige (homoleptische) oder verschiedenartige (heteroleptische) Liganden sein können. Eventuelle anorganische Ionen sind in der vorgenannten Stöchiometrie nicht einbezogen. Ein zwei Metalle M enthaltender Komplex (z.B. M₂L₂ oder M₂L₃) kann eine planare oder schmetterlingsartige Struktur (engl. "butterfly structure") aufweisen oder auch eine Struktur, die abhängig von der Umgebung die Konformation wechseln kann.

Bevorzugt ist ein Metall-Komplex im Sinne der Erfindung ein M(I)-Komplex. Stärker bevorzugt weist der M(I)-Komplex eine der folgenden Strukturen (a), (b) oder (c) auf: 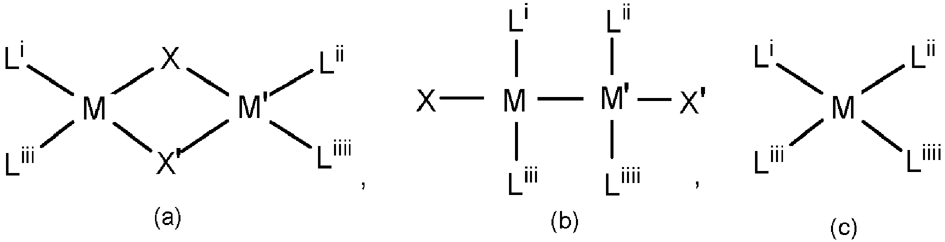
worin M und M'unabhängig von einander jeweils Metall(I) darstellen, bevorzugt Cu(I), Ag(I) oder Au(I), insbesondere Cu(I);
worin Lⁱ - Lⁱⁱⁱⁱ jeweils unabhängig von einander darstellen:
   A) geeignete organische Liganden L, die entweder gleich oder verschieden sein können, oder
   B) Teile von organischen Liganden L, die entweder gleich oder verschieden sein können, wobei zwei oder mehr aus Lⁱ - Lⁱⁱⁱⁱ kovalent miteinander verbunden sein können, so wie etwa Lⁱ mit Lⁱⁱⁱ Lⁱⁱ mit Lⁱⁱⁱⁱ, L' mit Lⁱⁱ, Lⁱⁱⁱ mit Lⁱⁱⁱⁱ Lⁱ mit Lⁱⁱⁱⁱ und/oder Lⁱⁱ mit Lⁱⁱⁱ, wobei dann das Konjugat einen organischen Liganden L darstellt; und
worin X und X' jeweils unabhängig von einander ein geeigneter anionischer Ligand ist, wie beispielsweise ein Anion ausgewählt aus der Gruppe bestehend aus Cl⁻, Br⁻, I⁻, SCN⁻, CN⁻, RS⁻, RSe⁻, RR'N⁻, RR'P⁻ und R-C≡C⁻ vorliegen,
wobei R und R` unabhängig von einander ausgewählt sind aus der Gruppe bestehend aus einem C₁₋₂₀-Alkyl-Rest (z.B. Methyl-, Ethyl-, n-Propyl-, iso-Propyl-, n-Butyl- oder tert.-Butyl-Rest), Adamantyl-Rest, C₆₋₁₄-Aryl-Rest (z.B. Phenyl-, Tolyl-, Napthyl-, C₆F₅-Rest), C₂₋₁₃-Heteroaryl-Rest (z.B. Furyl-, Thienyl-, Pyridyl- oder Pyrimidyl-Rest), C₂₋₂₀-Alkenyl-Rest (z.B. CR=CR"R‴), C₂₋₂₀-Alkinyl-Rest (-C=C-R"), -OR", und -NR"R‴,
wobei R" und R‴ wie R definiert sind und auch H sein können.

Bevorzugt sind die Liganden Lⁱ - Lⁱⁱⁱⁱ ausgewählt aus ein- und zweizähnigen Phosphan- und Arsanliganden sowie Liganden mit mindestens einem N-Donoratom. Die Liganden können entweder neutral oder einfach negativ geladen sein.

Die Liganden können entweder einzähnige Liganden sein oder miteinander verbunden sein und mehrzähnige, insbesondere zweizähnige, Liganden bilden. Die Strukturen enthalten daher entweder vier einzähnige Liganden oder zwei zweizähnige Liganden oder einen zweizähnigen und zwei einzähnige Liganden oder einen dreizähnigen und einen einzähnigen Liganden oder einen vierzähnigen Liganden.

Ein M₂L₂-Komplex kann demnach beispielsweise ein Cu₂L₂-Komplex, ein Au₂L₂-Komplex oder ein Ag₂L₂-Komplex sein, besonders bevorzugt ist ein Cu₂L₂-Komplex. Ein M₂L₃-Komplex kann beispielsweise ein Cu₂L₃-Komplex, ein Au₂L₃-Komplex oder ein Ag₂L₃-Komplex sein, besonders bevorzugt ist ein Cu₂L₃-Komplex.

Der Schritt (iii) des Trocknens und/oder Aushärtens der durch das Aufbringen erhaltenen Schicht S auf der Oberfläche des Bauteils T kann im Prinzip beliebig erfolgen. Das Trocknen kann optional unter vermindertem Druck und/oder unter erhöhter Temperatur erfolgen. Beispielshaft kann das Trocknen bei Normaldruck und 50°C erfolgen. Alternativ kann das Trocknen bei Normaldruck und einer Temperatur von 50-60°C, insbesondere 60°C erfolgen.

Das Aushärten kann mit einer Polymerisation, etwa eines Acrylharzes, einhergehen, in das die Verbindungen eingebettet sind.

Durch den Schritt des Trocknens wird der Nassfilm in einen Trockenfilm überführt. Optional kann hierbei zudem der Ligand L chemisch mit einem oder mehreren Wirtsmolekülen kovalent oder unkovalent gebunden werden, wie dies beispielsweise in WO 2013/007709 und WO 2013/007710 beschrieben ist.

Bevorzugt wird beim erfindungsgemäßen Verfahren, dass zur Aufbringung einer lichtemittierenden Schicht S auf der Oberfläche eines Bauteils T in bzw. für eine opto-elektronische Vorrichtung die folgenden Schritte angewandt werden:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T.

Besonders bevorzugt wird ein Verfahren, bei dem zur Aufbringung einer lichtemittierenden Schicht S auf der Oberfläche eines Bauteils T folgende Schritte angewandt werden:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 auf die Lochleitungsschicht des Bauteils T; und
(iii) Trocknen der durch das Aufbringen erhaltenen Schicht S auf der Lochleitungsschicht des Bauteils T.

Es wird offenbart, dass das Aufbringen der Zusammensetzungen in flüssiger Phase auf die Oberfläche des Bauteils T gemäß Schritt (ii) beliebig erfolgen kann. In einem nicht erfindungsgemäßen Verfahren können die Zusammensetzungen Z1 und Z2 auch nacheinander auf die Oberfläche des Bauteils T aufgebracht werden können.

In einem nicht erfindungsgemäßen Verfahren kann zuerst Z1 dann Z2 auf die Oberfläche des Bauteils T aufgebracht werden oder zuerst Z2 dann Z3 auf die Oberfläche des Bauteils T aufgebracht werden. Dies kann beispielsweise durch ein Druckverfahren erreicht werden, bei dem zunächst Z1, dann Z2 auf dieselbe Stelle der Oberfläche des Bauteils T gedruckt werden. Alternativ kann beispielsweise durch ein Druckverfahren erreicht werden, bei dem zunächst Z2, dann Z1 auf dieselbe Stelle der Oberfläche des Bauteils T gedruckt werden.

So kann beispielsweise zunächst Z1 in flüssiger Phase aufgebracht und, während Z1 noch flüssig ist, kann Z2 in flüssiger Phase dazu gegeben werden, so dass sich die Flüssigkeiten *in situ* mischen können. Alternativ kann beispielsweise zunächst Z2 in flüssiger Phase aufgebracht werden und, während Z2 noch flüssig ist, kann Z1 in flüssiger Phase dazu gegeben werden, so dass sich die Flüssigkeiten *in situ* mischen können.

In einem nicht erfindungsgemäßen Verfahren kann beispielsweise zunächst Z1 in flüssiger Phase aufgebracht werden, dann *in situ* trocknen und danach Z2 in flüssiger Phase zu dem getrockneten Z1 gegeben werden. Alternativ kann beispielsweise zunächst Z2 in flüssiger Phase aufgebracht werden, dann *in situ* trocknen und danach Z1 in flüssiger Phase zu dem getrockneten Z2 gegeben werden.

In einem nicht erfindungsgemäßen Verfahren kann der zeitliche Abstand zwischen der nacheinander folgenden Aufbringung der Zusammensetzungen in flüssiger Phase auf die Oberfläche des Bauteils T gemäß Schritt (ii) beliebig sein. Beispielhaft kann der zeitliche Abstand kurz sein und weniger als 1 s betragen oder zwischen 1 und 10 s betragen, zwischen 5 und 20 s betragen, zwischen 10 und 30 s betragen, zwischen 20 s und 1 min betragen, zwischen 30 s und 2 min betragen, zwischen 1 und 5 min betragen, zwischen 2 min und 10 betragen oder mehr als 10 min betragen.

Gemäß einem nicht erfindungsgemäßen Verfahren werden zur Aufbringung einer lichtemittierenden Schicht S auf der Oberfläche eines Bauteils T einer opto-elektronischen Vorrichtung folgende Schritte angewandt:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
   wobei die Lösung Z1 vor der Lösung Z2 auf die Oberfläche des Bauteils T aufgebracht wird.

Gemäß einem nicht erfindungsgemäßen Verfahren werden zur Aufbringung einer lichtemittierenden Schicht S auf der Oberfläche eines Bauteils T einer opto-elektronischen Vorrichtung alternativ die folgenden Schritte angewandt:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei die Lösung Z2 vor der Lösung Z1 auf die Oberfläche des Bauteils T aufgebracht wird.

Erfindungsgemäß werden die Zusammensetzungen Z1 und Z2 gleichzeitig auf die Oberfläche des Bauteils T aufgebracht.

Erfindungsgemäß werden sie dann als zwei separate Zusammensetzungen (in der Regel Lösungen) gleichzeitig auf die Oberfläche des Bauteils T aufgebracht, wobei sich die Zusammensetzung auf der Oberfläche selbst mischen.

Bevorzugt wird beim erfindungsgemäßen Verfahren, dass zur Aufbringung einer lichtemittierenden Schicht S auf der Oberfläche eines Bauteils T folgende Schritte erfolgen:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei die Lösungen Z1 und Z2 gleichzeitig auf die Oberfläche des Bauteils T aufgebracht werden.

Die Stöchiometrie zwischen Metall(en) M und Ligand(en) L kann optional so gewählt werden, dass bei dem Inkontaktreten zwischen den Zusammensetzungen Z1 und Z2 (nahezu) das gesamte Metall M und der gesamte Ligand L in Metall-Komplexe komplexiert wird.

Bevorzugt ist jedoch eine Abweichung von dieser Stöchiometrie, so dass in der lichtemittierenden Schicht S nach dem Trocknungs- bzw. Aushärtungs-Schritt (iii) des erfindungsgemäßen Verfahrens noch nicht-komplexiertes Metall M oder nicht-komplexierter Ligand L vorliegt.

Das Vorliegen von nicht-komplexiertem Metall M oder nicht-komplexiertem Ligand L in der lichtemittierenden Schicht S kann eine sogenannte Selbstheilung einer solchen Schicht ermöglichen. So kann zum Beispiel ein Verlust an Metall M aus dem Metall-Komplex durch nicht-komplexiertes Metall M ausgeglichen werden.

Gemäß einer bevorzugten Ausführungsform werden die Zusammensetzungen Z1 und Z2 so gewählt, dass ein Überschuss von mindestens 0,1 Mol-%, bevorzugt mindestens 0,5 Mol-%, stärker bevorzugt mindestens 1 Mol-%, insbesondere mindestens 5 Mol-% an Metall M gegenüber Ligand L auf die Oberfläche des Bauteils T aufgebracht wird.

Dadurch kann erreicht werden, dass in der lichtemittierenden Schicht S nach dem Trocknungs- bzw. Aushärtungs-Schritt (iii) des erfindungsgemäßen Verfahrens noch nicht-komplexiertes Metall M vorliegt.

Bevorzugt wird beim erfindungsgemäßen Verfahren, dass zur Aufbringung einer lichtemittierenden Schicht S auf der Oberfläche eines Bauteils T folgende Schritte erfolgen:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei ein Überschuss von mindestens 0,1 Mol-% an Cu(I) gegenüber Ligand L auf die Oberfläche des Bauteils T aufgebracht wird.

Besonders bevorzugt umfasst das erfindungsgemäße Verfahren die Schritte:
(i) Bereitstellen von:
   (a) einer Lösung Z1 von nicht-komplexiertem Kupferiodid (Cul)
   (b) einer Lösung Z2 eines nicht-komplexierten organochemischen Liganden L, der Cu(I) in Form eines Cu₂L₃- oder Cu₂L₂-Komplexes komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei ein Überschuss von mindestens 0,1 Mol-% an CuI gegenüber Ligand L auf die Oberfläche des Bauteils T aufgebracht wird.

Aufgrund der lochleitenden Eigenschaften von Metallsalzen (insbesondere von Metall(I)-Salzen wie beispielsweise Kupferiodid) kann ein Überschuss dieser zu einer Erhöhung der Leitfähigkeit beitragen.

Gemäß einer alternativen Ausführungsform werden die Zusammensetzungen Z1 und Z2 so gewählt, dass ein Überschuss von mindestens 1 Mol-%, bevorzugt mindestens 5 Mol-%, stärker bevorzugt mindestens 10 Mol-%, insbesondere mindestens 20 Mol-% an Ligand L gegenüber Metall M auf die Oberfläche des Bauteils T aufgebracht wird.

Der Überschuss bezieht sich wie hierin verwendet auf die Gesamtmenge, an Z1 und Z2, die auf die Oberfläche des Bauteils T aufgebracht werden.

Dadurch kann erreicht werden, dass in der lichtemittierenden Schicht S nach dem Trocknungs- bzw. Aushärtungs-Schritt (iii) des erfindungsgemäßen Verfahrens noch nicht-komplexierter Ligand L vorliegt.

Bevorzugt umfasst das erfindungsgemäße Verfahren die Schritte:
(i) Bereitstellen von:
   (a) einer Lösung Z1 eines nicht-komplexierten Cu(I)-Salzes,
   (b) einer Lösung Z2 eines nicht-komplexierten organochemischen Liganden L, der Cu(I) komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei ein Überschuss von mindestens 1 Mol-% an Ligand L gegenüber Cu(I) auf die Oberfläche des Bauteils T aufgebracht wird.

Besonders bevorzugt umfasst das erfindungsgemäße die Schritte:
(i) Bereitstellen von:
   (a) einer Lösung Z1 von nicht-komplexiertem Kupferiodid (Cul)
   (b) einer Lösung Z2 eines nicht-komplexierten organochemischen Liganden L, der Cu(I) in Form eines Cu₂L₃- oder Cu₂L₂-Komplexes komplexieren kann, und optional
   (c) einer Lösung Z3 eines Wirtsmoleküls W, das eine Matrix für die lichtemittierende Schicht S bilden kann;
(ii) Aufbringen der Lösungen Z1, Z2 und optional Z3 in flüssiger Phase auf die Oberfläche des Bauteils T; und
(iii) Trocknen der durch das Aufbringen erhaltenen Schicht S auf der Oberfläche des Bauteils T,
wobei ein Überschuss von mindestens 1 Mol-% an Ligand L gegenüber CuI auf die Oberfläche des Bauteils T aufgebracht wird.

Aufgrund der strukturstabilisierenden Eigenschaften der nicht-komplexierten Liganden kann ein Überschuss dieser zu einer Verbesserung der molekularen Struktur der lichtemittierenden Schicht S beitragen.

Alternativ kann auch eine Stöchiometrie gewählt werden, die eine (nahezu) vollständige Komplexierung des/der Metall(e) M und des/der Liganden L erreicht, und somit (nahezu) kein nicht-komplexiertes Metall M und (nahezu) kein nicht-komplexierter Ligand in der lichtemittierenden Schicht S nach dem Trocknungs- bzw. Aushärtungs-Schritt (iii) des erfindungsgemäßen Verfahrens vorliegt.

Wie oben dargelegt kann der Schritt (ii) des Aufbringens der Zusammensetzungen Z1, Z2 und optional Z3 auf die Oberfläche des Bauteils T mittels eines beliebigen Verfahrens vorgenommen werden. Beispielsweise können Rotationsbeschichtung (engl. "spin coating"), Dropcasting, Schlitzguss, Vorhangguß, Walzverfahren oder Druckverfahren (z.B. Inkjet Printing) eingesetzt werden.

Gemäß einer bevorzugten Ausführungsform wird der Schritt (ii) des Aufbringens der Zusammensetzungen Z1, Z2 und optional Z3 auf die Oberfläche des Bauteils T mittels Rotationsbeschichtung durchgeführt.

Wie oben dargelegt kann das Metall M jedes Metall sein, das in der Lage ist, komplexiert zu werden und dabei einen Metall-Komplex zu bilden, der in der Lage ist als Emitterverbindung E zu dienen. Bevorzugt ist das Metall M ein Übergangsmetall.

Bevorzugt ist das Metall M ausgewählt aus der Gruppe bestehend aus Cu, Ag, Au, Pd, Pt, Zn, Sn, Ir, Ni, Fe, Cd, Hg, Os und Re. Gemäß einer bevorzugten Ausführungsform ist das Metall M ausgewählt aus der Gruppe bestehend aus Cu, Ag und Au. Bevorzugt ist das Metall M ein Metall M ein Metall(I). Gemäß einer stärker bevorzugten Ausführungsform ist das Metall M ein Metall(I) ausgewählt aus der Gruppe bestehend aus Cu(I), Ag(I) und Au(I). Gemäß einer besonders bevorzugten Ausführungsform ist das Metall M Cu(I).

Wie bereits oben beschrieben, kann das erfindungsgemäße Verfahren verwendet werden, um eine lichtemittierende Schicht S herzustellen. Diese hat andere Eigenschaften als lichtemittierende Schichten S, bei denen vorab hergestellte Metall-Komplexe prozessiert werden.

Offenbart ist auch eine lichtemittierende Schicht S herstellbar (bzw. hergestellt) nach einem Verfahren gemäß der vorliegenden Erfindung.

Bei einer lichtemittierenden Schicht S handelt es sich bevorzugt um eine organochemische lichtemittierende Schicht S, die überwiegend aus organischen Werkstoffen, d.h. aus Kohlenwasserstoffverbindungen besteht, wobei die Kohlenwasserstoffverbindungen mit Heteroatomen wie beispielsweise Stickstoff, Phosphor, Sauerstoff und/oder Halogenen substituiert sein können. Mindestens eine der Kohlenwasserstoffverbindungen stellt einen Liganden L im Sinne der Erfindung dar. Bevorzugt enthält die lichtemittierende Schicht S einen Metall-Komplex aus Metall M und Ligand L, und mindestens eine Wirtsverbindung W, und optional nicht-komplexiertes Metallsalz oder Liganden L. Optional kann die lichtemittierende Schicht S zudem fluoreszente Polymere (z.B. Superyellow (SY)), photolumineszierende Nanopartikel (etwa aus Silizium), Quantenpunkte (engl. "quantum dots"), Cadmiumselenid und/oder Exciplexe ("excited complexes"), optional verdünnt mit Wirtsmolekülen (engl. "hosts"), enthalten.

Wenn nicht-komplexiertes Metallsalz oder Ligand L enthalten ist, kann die lichtemittierende Schicht S, wie oben beschrieben, ganz besonders positive Eigenschaften aufweisen.

Daher wird auch eine lichtemittierende Schicht S offenbart, enthaltend:
(a) eine Emitterverbindung E, die ein Metall-Komplex aus einem oder mehreren Liganden L und einem oder mehreren Metallen M ist; und
(b) entweder ein Salz eines nicht-komplexierten Metalls M, das in der Lage ist, von dem Liganden L komplexiert zu werden, oder einen nicht-komplexierten Liganden L, der in der Lage ist, das Metall M zu komplexieren.

Bevorzugt ist eine solche lichtemittierende Schicht S gemäß dem erfindungsgemäßen Verfahren hergestellt.

Bevorzugt ist die lichtemittierende Schicht S herstellbar (bzw. hergestellt) nach einem Verfahren gemäß der vorliegenden Erfindung, enthaltend:
(a) die dabei gebildete Emitterverbindung E, die ein Metall-Komplex aus einem oder mehreren Liganden L und einem oder mehreren Metallen M ist; und
(b) ein Salz des nicht-komplexierten Metalls M, das in der Lage ist, von dem Liganden L komplexiert zu werden.

Bevorzugt ist die lichtemittierende Schicht S herstellbar (bzw. hergestellt) nach einem Verfahren gemäß der vorliegenden Erfindung, enthaltend:
(a) die dabei gebildete Emitterverbindung E, die ein Metall-Komplex aus einem oder mehreren Liganden L und einem oder mehreren Metallen M ist; und
(b) einen nicht-komplexierten Liganden L, der in der Lage ist, das Metall M zu komplexieren.

Um die Farbe und/oder das Emissionsspektrum des abgestrahlten Lichts weiter zu modifizieren bzw. das Absorptionsspektrum zu modifizieren, kann optional die lichtemittierende Schicht S zusätzlich einen Farbstoff F enthalten. Gemäß einer bevorzugten Ausführungsform enthält die lichtemittierende Schicht S zusätzlich einen Farbstoff F.

Hierbei kann jeder gewünschte Farbstoff F oder auch eine Farbstoffkombination eingesetzt werden. Der Farbstoff F kann auch ein fluoreszenter und/oder phosphoreszenter Farbstoff F sein, der das Emissions- und/oder Absorptionsspektrum der lichtemittierenden Schicht S verschieben kann. Optional können auch Diphoton-Effekte genutzt werden, daher das Absorbieren zweier Photonen mit der Hälfte der Energie des Absorptionsmaximums. Durch einen fluoreszenten und/oder phosphoreszenten Farbstoff F wird meist ein bathochromer Effekt erzielt (etwa durch Wärmeverluste). Es kann jedoch auch ein hypsochromer Effekt erzielt werden (etwa durch Diphoton-Effekte). Bevorzugt stellt der Farbstoff F kein metallkomplex aus Ligand/en) L und Metall(en) M dar.

Die lichtemittierende Schicht S kann zusätzlich, besonders wenn es sich bei der opto-elektronischen Vorrichtung um eine LEC handelt, eine ionische Flüssigkeit oder eine Kombination von zwei oder mehr ionischen Flüssigkeiten enthalten. Beispielsweise kann eine solche ionische Flüssigkeit oder Kombination von zwei oder mehr ionischen Flüssigkeiten ausgewählt sein aus der Gruppe bestehend aus:
Methyl-imidazoliumhexafluorophosphaten (z.B. 1-Alkyl-3-methyl-imidazoliumhexa-fluorophosphate wie beispielsweise 1-Methyl-3-methyl-imidazoliumhexafluoro-phosphat, 1-Ethyl-3-methyl-imidazoliumhexafluorophosphat, 1-Propyl-3-methyl-imi-dazoliumhexafluoro-phosphat, 1-Butyl-3-methyl-imidazoliumhexafluorophosphat, 1-Benzyl-3-methylimidazo-linium-Hexafluorophosphat), Dimethyl-imidazoliumhexa-fluorophosphaten (z.B. 1-Alkyl-2,3-dimethyl-imidazoliumhexafluorophosphate wie beispielsweise 1-Butyl-2,3-dimethyl-imidazoliumhexafluorophosphat), 3-Methyl-imidazoliumhexafluorophosphaten (z.B. 1-Alkyl-methyl-imidazoliumhexafluorophosphate wie beispielsweise 1-Methyl-3-methyl-imidazoliumhexafluorophosphat, 1-Ethyl-3-methyl-imidazoliumhexafluorophosphat, 1-Propyl-3-methyl-imidazoliumhexa-fluorophosphat, 1-Butyl-3-Methyl-imidazoliumhexafluorophosphat, 1-Pentyl-3-methyl-imidazoliumhexafluorophosphat, 1-Hexyl-3-methyl-imidazoliumhexafluoro-.phosphat), 1-Butyl-1-(3,3,4,4,5,5,6,6,7,7,8,8,8-tridecafluorooctyl)-imidazoliumhexa-fluorophos-phat, 1-Methyl-3-(3,3,4,4,5,5,6,6,7,7,8,8,8-tridecafluorooctyl)-imidazolium-hexafluoro-phosphat, 1-Methyl-3-octyl-imidazoliumhexafluorophosphat, Methyl-imidazolium-tetrafluoroboraten (z.B. 1,3-Dimethyl-imidazoliumtetrafluoroborat, 1-Ethyl-3-methyl-imidazoliumtetrafluoroborat, 1-Propyl-3-methyl-imidazoliumtetrafluoroborat, 1-Butyl-3-methyl-imidazoliumtetrafluoroborat), 1-Butyl-2,3-dimethyl-imidazoliumtetrafluoro-borat, 1-Hexyl-3-methyl-imidazoliumtetrafluoroborat, 1-Methyl-3-octyl-imidazolium-tetrafluoroborat, Methylimidazoliumtrifluoromethanesulfonaten (z.B. 1-Methyl-3-methyl-imidazoliumtrifluoromethane-sulfonat, 1-Ethyl-3-methyl-imidazoliumtrifluoro-methanesulfonat, 1-Propyl-3-methyl-imidazoliumtrifluoromethanesulfonat, 1-Butyl-3-methy-limidazoliumtrifluoromethanesulfonat), 1,2,3-Trimethylimidazoliumtrifluoro-methanesulfonat, 1-Ethyl-3-methyl-imidazolium-bis(pentafluoroethylsulfonyl)imid, 1-Butyl-3-methylimidazolium-bis(trifluoromethylsulfonyl)imid, 1-Butyl-3-methyl-imida-zoliummethanesulfonat, Tetrabutyl-ammonium-bis-trifluoromethanesulfonimidat, Tetrabutylammoniummethanesulfonat, Tetrabutyl-ammonium nonafluorobutane-sulfonate, Tetrabutyl-ammoniumheptadecafluorooetanesulfonat, Tetrahexyl-ammonium tetrafluoroborat, Tetrabutyl-ammoniumtrifluoromethanesulfonat, Tetrabutylammoniumbenzoate, Tetrabutyl-ammoniumhalogenide (z.B. Tetrabutylammoniumchlorid, Tetrabutyl-ammoniumbromid), 1-Benzyl-3-methyl-imidazoliumtetrafluoroborat, Trihexyl-tetradecylphosphoniumhexafluorophosphate, Tetrabutyl-phosphoniummethanesulfonate,Tetrabutyl-phosphoniumtetrafluoro-borate,Tetrabutyl-phosphoniumbromid,1-Butyl-3-methylpyridinium-bis(trifluormethyl-sulfonyl)im id, 1-Butyl-4-methylpyridiniumhexafluorophosphat, 1-Butyl-4-methyl-pyridiniumtetrafluoroborat, Natriumtetraphenylborat, Tetrabutyl-ammoniumtetra-phenylborat, Natriumtetrakis(1-imidazolyl)borat und Cäsiumtetraphenylborat. Zusätzlich oder alternativ kann die lichemittierende Schicht S einen oder mehrere Elektrolyten, wie beispielsweise KCF₃SO₃, enthalten.

Die Stöchiometrie zwischen Metall(en) M und Ligand(en) L in der lichtemittierenden Schicht kann optional so gewählt werden, dass das gesamte Metall M und der gesamte Ligand L in Metall-Komplexe komplexiert ist. Bevorzugt ist jedoch eine Abweichung von dieser Stöchiometrie, so dass in der lichtemittierenden Schicht S noch nicht-komplexiertes Metall M oder nicht-komplexierter Ligand L vorliegt. Das Vorliegen von nicht-komplexiertem Metall M oder nicht-komplexiertem Ligand L in der lichtemittierenden Schicht S kann die Selbstheilung einer solchen ermöglichen. So kann zum Beispiel ein Verlust an Metall M aus dem Metall-Komplex durch nicht-komplexiertes Metall M ausgeglichen werden.

Gemäß einer bevorzugten Ausführungsform liegt in der lichtemittierenden Schicht S mindestens 0,1 Mol-%, bevorzugt mindestens 0,5 Mol-%, stärker bevorzugt mindestens 1 Mol-%, insbesondere mindestens 5 Mol-% des gesamten Metalls M als nicht-komplexiertes Metall vor.

Gemäß einer alternativen bevorzugten Ausführungsform liegt in der lichtemittierenden Schicht S mindestens 1 Mol-%, bevorzugt mindestens 5 Mol-%, stärker bevorzugt mindestens 10 Mol-%, insbesondere mindestens 20 Mol-% des gesamten Liganden L als nicht-komplexierter Ligand L vor.

Dies kann jeweils die oben beschriebenen vorteilhaften technischen Wirkungen hervorrufen.

Wie oben beschrieben wird eine derartige lichtemittierende Schicht S in der Regel in eine opto-elektronische Vorrichtung eingebracht, um Licht zu erzeugen. Daher wird auch eine opto-elektronische Vorrichtung offenbart, enthaltend eine lichtemittierende Schicht S gemäß der vorliegenden Erfindung.

Bei einer opto-elektronischen Vorrichtung handelt es sich bevorzugt um eine organochemische opto-elektronische Vorrichtung, bei der die lichtemittierende Schicht S zumindest überwiegend aus organischen Werkstoffen besteht. Diese können aus Kohlenwasserstoffverbindungen bestehen, wobei die Kohlenwasserstoffverbindungen mit Heteroatomen wie Stickstoff, Phosphor, Sauerstoff und/oder Halogenen substituiert sein können.

Die lichtemittierende Schicht S ist hierbei im weitesten Sinne so wie oben beschrieben zu verstehen. Daher enthält die lichtemittierende Schicht S, wie oben beschrieben, einen Metall-Komplex aus mindestens einem Metall M und mindestens einem Liganden L als Emitterverbindung E, sowie optional ein oder mehrere Wirtsmoleküle W.

Der Anteil an Metall-Komplex in der lichtemittierenden Schicht S kann bei 0,1 bis 100% liegen. Demnach kann die lichtemittierende Schicht S vollständig oder weitgehend aus dem Metall-Komplex bestehen oder aber den Metall-Komplex nur als kleinen oder großen Anteil neben anderen Verbindungen (wie beispielsweise einem oder mehreren ungebundenen Salz(en) des Metalls M und/oder auch anderer Metalle, einem oder mehreren ungebundenen Liganden L oder einem oder mehreren Wirtsmolekülen W) enthalten. Bei vielen opto-elektronischen Vorrichtungen, wie etwa LECs, liegt der Anteil an Metall-Komplex in der lichtemittierenden Schicht S bevorzugt bei mehr als 30 Gew.-%, mehr als 40 Gew.-%, mehr als 50 Gew.-%, mehr als 60 Gew.-%, mehr als 70 Gew.-%, mehr als 80 Gew.-% oder mehr als 90 Gew.-%.

Die opto-elektronische Vorrichtung kann intransparent, semi-transparent oder (weitgehend) transparent sein.

Die opto-elektronische Vorrichtung kann jede beliebige opto-elektronische Vorrichtung sein, die eine hierin offenbarte lichtemittierende Schicht S beinhaltet.

Gemäß einer bevorzugten Ausführungsform ist die opto-elektronische Vorrichtung eine organische Leuchtdiode (OLED), ein organischer Laser, eine organische Solarzelle (OSC) oder ein optischer Sensor. Besonders bevorzugt ist die opto-elektronische Vorrichtung organische Leuchtdiode (OLED) oder eine organische Solarzelle (OSC). Eine organische Solarzelle (OSC) kann auch als organochemische photovoltaische Vorrichtung (OPV) bezeichnet werden.

Ein optischer Sensor kann beispielsweise ein optischer Sensor sein, der die Lichtintensität misst. Auch kann der optische Sensor optional die Lichtintensität von Licht eines bestimmten Wellenlängenbereichs bestimmen. Ein optischer Sensor kann auch Teil einer Anordnung von optischen Sensoren (daher eines Arrays), wie dies beispielsweise als Bildsensor in einer Digitalkamera zum Einsatz kommt.

Gerade wenn die opto-elektronische Vorrichtung eine organische Leuchtdiode (OLED), eine lichtemittierende elektrochemische Zelle (LEC), eine organische Solarzelle (OSC) oder ein optischer Sensor ist, kann die opto-elektronische Vorrichtung optional auch als dünne Schicht ausgestaltet sein, die insgesamt nicht dicker als 5 mm, nicht dicker als 2 mm, nicht dicker als 1 mm, nicht dicker als 0,5 mm, nicht dicker als 0,25 mm, nicht dicker als 100 µm oder nicht dicker als 10 µm ist. Die opto-elektronische Vorrichtung kann auch eine Dicke im Bereich von 8-9 µm, 7-8 µm, 6-7 µm, 5-6 µm, 4-5 µm, 3-4 µm, 2-3 µm, 1-2 µm oder weniger als 1 µm aufweisen.

Gemäß einer besonders bevorzugten Ausführungsform ist die opto-elektronische Vorrichtung organische Leuchtdiode (OLED). OLEDs sind bekanntlich aus mehreren Schichten aufgebaut. Meist befindet sich auf einem Substrat eine Anodenschicht A. Das Substrat kann aus einem beliebigen Material oder einer Kombination von Materialien bestehen. Am häufigsten werden Glasplatten verwendet. Alternativ können jedoch auch dünne Metallfolien (beispielsweise Kupfer-, Gold-, Silber- oder Aluminiumfolien) oder Kunststoffe verwendet werden, was eine höhere Biegsamkeit der OLED ermöglicht.

In der Anodenschicht A werden als Anodenmaterialien häufig transparente Stoffe verwendet. Da mindestens eine der Elektroden transparent sein muss, um das in der OLED erzeugte Licht auskoppeln zu können, muss entweder die Anodenschicht A oder die Kathodenschicht C weitgehend, bevorzugt (nahezu) vollständig, transparent für das auszukoppelnde Licht sein. Anodenschicht A besteht meist zu großen Teilen oder (nahezu) vollständig aus einem oder mehreren (weitgehend) transparenten, leitfähigen Oxiden (engl. "transparent conductive oxides", TCOs). Eine derartige Anodenschicht A kann beispielsweise Indium-Zinn-Oxid, Aluminium-Zink-Oxid, Fluor-Zinn-Oxid, Indium-Zink-Oxid, PbO, SnO, Zirkoniumoxid, Molybdänoxid, Vanadiumoxid, Wolframoxid, Grafit, dotiertes Si, dotiertes Ge, dotiertes GaAs, dotiertes Polyanilin, dotiertes Polypyrrol und/oder dotiertes Polythiophen enthalten. Die Anodenschicht A kann auch aus einem oder mehreren der vorgenannten Materialen bestehen. Besonders bevorzugt besteht die Anode aus Indium-Zinn-Oxid (ITO) (meist (InO₃)_{0,9}(SnO₂)_{0,1}).

Die Rauigkeit der in der Anodenschicht A verwendeten transparenten, leitfähigen Oxide kann durch den Einsatz einer zusätzlichen Lochinjektionsschicht (engl. "hole injection layer", HIL) ausgeglichen werden. Ferner kann die Lochinjektionsschicht die Injektion von positiven Quasiladungsträgern erleichtern, indem der Ladungsträgerübertritt vom transparenten, leitfähigen Oxid zur Lochleitungsschicht erleichtert wird. In der Lochinjektionsschicht kann Poly-3,4-ethylendioxythiophen (PEDOT), Polystyrolsulfonat (PSS), MoO₂, V₂O₅ oder Cul, besonders eine Mischung aus PEDOT und PSS, eingesetzt werden. Diese Schicht kann auch die Eindiffusion von Metallen aus der Anodenschicht A in den Übergang in der Lochleitungsschicht verhindern.

Auf der Anodenschicht A oder Lochinjektionsschicht ist typischerweise eine Lochleitungsschicht (engl. "hole transport layer", HTL) angeordnet. Hier kann ein beliebiger Lochleiter eingesetzt werden. Beispielsweise können elektronenreiche Heteroaromaten wie Triarylamine oder Carbazole als Lochleiter eingesetzt werden. Auch die Lochleitungsschicht kann eine nivellierende Funktion erfüllen und die Energiebarriere zu der lichtemittierenden Schicht S (Emitterschicht, engl. "emitting layer", EML, oder "light emitting layer", LEL) überbrücken. Die Lochleitungsschicht kann auch als Elektronenblockierschicht (engl. "electron blocking layer", EBL) bezeichnet werden. Bevorzugt weisen die Lochleiter hohe Triplett-Energien auf. Beispielsweise kann die Lochleitungsschicht als Lochleiter einen sternförmigen Heterozyklus wie Tris(4-carbazoyl-9-ylphenyl)amin (TCTA) enthalten.

Auf der Lochleitungsschicht ist in aller Regel die lichtemittierende Schicht S aufgebracht, die im Zusammenhang mit einem Verfahren der vorliegenden Erfindung mindestens einen Metall-Komplex aus mindestens einem Metall M und mindestens einem Liganden L enthält. Optional kann die lichtemittierende Schicht S auch aus diesem Metall-Komplex bestehen. Die Zusammensetzung einer lichtemittierenden Schicht S wird im Detail oben beschrieben.

Auf der lichtemittierenden Schicht S kann abschließend eine Elektronenleitungsschicht (engl. "electron transport layer", ETL) aufgebracht werden. Hier kann ein beliebiger Elektronenleiter eingesetzt werden. Beispielsweise können hierin elektronenarme Verbindungen wie Benzimidazole, Pyridine, Triazole, Oxadiazole (beispielsweise 1,3,4-Oxadiazol), Phosphinoxide und Sulfone verwendet werden. Beispielsweise kann die Elektronenleitungsschicht als Elektronenleiter einen sternförmigen Heterozyklus wie 1,3,5-Tri(1-phenyl-1H-benzo[d]imidazol-2-yl)phenyl (TPBi) enthalten. Die Elektronentransportschicht kann zur energetischen Nivellierung zwischen Kathodenschicht C und lichtemittierender Schicht S dienen und andererseits Löcher blocken.

Auf die Elektronenleitungsschicht wird typischerweise eine Kathodenschicht C aufgebracht. Diese kann beispielsweise aus einem Metall oder einer Metalllegierung bestehen. Diese kann beispielsweise Al, Au, Ag, Pt, Cu, Zn, Ni, Fe, Pb, In, W, Pd und/oder Mischungen oder Legierungen aus zwei oder mehr dieser Metalle umfassen. Aus praktischen Gründen kann die Kathodenschicht C aus weitgehend optisch intransparenten Metallen, wie Mg, Ca oder Al, bestehen.

Alternativ kann die Kathodenschicht C auch Graphit und/oder Kohlenstoffnanoröhren (engl. "carbon nanotubes", CNTs) enthalten. In diesen Fällen einer intransparenten Kathodenschicht C sollte die Anodenschicht A möglichst transparent sein. Auch kann die Kathodenschicht C auch weitgehend aus semitransparenten Materialen wie beispielsweise nanoskaligen Silberdrähten bestehen. Die Kathodenschicht kann beispielsweise im Hochvakuum aufgedampft werden.

Als Schutzschicht und zur Verringerung der Injektionsbarriere für Elektronen kann zwischen Kathodenschicht C und der ETL gegebenenfalls noch eine dünne Schutzschicht aufgebracht werden. Diese kann beispielsweise Lithiumfluorid, Cäsiumfluorid und/oder Silber enthalten und kann optional aufgedampft werden.

OLEDs lassen sich beispielsweise auch als Leuchtfolien, als leuchtende Etiketten in intelligenten Verpackungen (engl. "smart packaging") oder als innovative Designelemente herstellen. Weiterhin ist der Einsatz in der Zellerkennung und - untersuchung (engl. "bio labelling") möglich.

Bevorzugt umfasst eine OLED zumindest folgende Schichten:
A) eine Anodenschicht A, bevorzugt umfassend Indium-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen;
S) eine lichtemittierende Schicht S; und
C) eine Kathodenschicht C, bevorzugt umfassend Al, Ca, Au, Ag, Pt, Cu, Zn, Ni, Fe, Pb, In, W, Pd und/oder Mischungen oder Legierungen aus zwei oder mehr dieser Metalle,
bevorzugt wobei S) zwischen A) und C) angeordnet ist.

Stärker bevorzugt umfasst eine OLED zumindest folgende Schichten:
A) eine Anodenschicht A, insbesondere eine solche umfassend Indium-Zinn-Oxid;
HTL) eine Lochleitungsschicht;
S) eine lichtemittierende Schicht S;
ETL) eine Elektronenleitungsschicht; und
C) eine Kathodenschicht C, bevorzugt umfassend Al, Ca und/oder Mg.
bevorzugt in der Anordnung A) - HTL) - S) - ETL) - C), wobei die Schichten entweder unmittelbar angrenzen oder noch eine oder mehrere Schicht(en) dazwischen sein können.

Weitere bevorzugte Beispiele sind im experimentellen Beispielteil dargestellt.

In der OLED wandern die Elektronen (daher negative Ladungsträger) im Betrieb von der Kathode in Richtung Anode, welche die Löcher (daher positive Quasiladungsträger) bereitstellt. Löcher und Elektronen treffen sich im Idealfall in der lichtemittierenden Schicht S, weshalb diese auch als Rekombinationsschicht bezeichnet werden kann. Aufeinandertreffende Elektronen und Löcher bilden einen gebundenen Zustand (Exziton). Von einem Exziton kann durch Energieübertrag ein Metall-Komplex, der wie hierin beschrieben als Emitterverbindung dient, angeregt werden. Dieser Metall-Komplex kann in den Grundzustand relaxieren und dabei ein Photon emittieren. Die Farbe des ausgesendeten Lichts hängt dabei vom Energieabstand (ΔE) zwischen dem angeregten und dem Grundzustand ab und kann durch Variation des MetallKomplexes bzw. des/der Liganden L gezielt variiert werden.

Wenn es sich bei der hierin offenbarten opto-elektronischen Vorrichtung um eine organische Solarzelle (OSC) handelt, ist es bevorzugt, dass die Vorrichtung den Metall-Komplex aus M und L als Bestandteil einer Absorberschicht umfasst, wobei der Anteil an Metall-Komplex in der Absorberschicht bevorzugt zwischen 30 und 100 Gew.-% beträgt. Wie bei OLEDs sind auch bei OSCs zwei Elektroden vorgesehen. Zwischen diesen ist die Absorberschicht angeordnet, in welcher der in der vorliegenden Anmeldung beschriebene Metall-Komplex zum Einsatz kommt.

Der vorstehend beschriebene Metall-Komplex kann Licht emittieren, daher als Emitterverbindung E dienen. Durch Variation des/der Liganden L und/oder des/der Metall(e) M kann dabei der ΔE-Abstand zwischen dem ersten angeregten Triplett-Zustand T1 und dem Singulett-Grundzustand S0 sowie dem ersten angeregten Singulett-Zustand S1 und dem Singulett-Grundzustand S0 variiert werden, so dass es möglich ist, die Wellenlänge des emittierten Lichtes zu variieren. Insbesondere mit Cu(I)-Komplexen, die einen ein- oder zweizähnigen Liganden L aufweisen, wurden diesbezüglich hervorragende Ergebnisse erzielt.

Bevorzugt stellt der Metall-Komplex eine Emitterverbindung E dar, die in der Lage ist, Licht durch Fluoreszenz, daher durch Relaxation eines angeregten Singulett-Zustandes (etwa S1) in den Grundzustand (S0) abzustrahlen, wobei der Energieabstand ΔE zwischen dem angeregten Singulett-Zustand S1 und dem angeregten Triplett-Zustand T1 so klein ist, dass auch bei Raumtemperatur (20°C) Energie vom angeregten T1-Zusand zum darüberliegenden S1-Zustand mittels Reverse-Intersystem-Crossing (RISC) übertragen werden kann. Daher ist bevorzugt der Energieabstand ΔE zwischen S1 und T1 (die Singulett-Triplett-Energieaufspaltung, ΔE(S1-T1)) nicht größer als 3000 cm⁻¹, stärker bevorzugt nicht größer als 2500 cm⁻¹, insbesondere nicht größer als 2000 cm⁻¹. Optional beträgt ΔE(S1-T1) sogar nicht mehr als 1500 cm⁻¹ oder gar nicht mehr als 1000 cm⁻¹.

Ist die opto-elektronische Vorrichtung eine OSC, kann eine Einschicht- oder eine Mehrschicht-OSC sein. Eine Einschicht-OSC kann beispielsweise folgende Schichten aufweisen:
A) eine erste Elektrodenschicht zu großen Teilen oder (nahezu) vollständig bestehend aus einem oder mehreren (weitgehend) transparenten, leitfähigen Oxiden (engl. "transparent conductive oxides", TCOs), beispielsweise Indium-Zinn-Oxid, Aluminium-Zink-Oxid, Fluor-Zinn-Oxid, Indium-Zink-Oxid, PbO, SnO, Grafit, dotiertes Si, dotiertes Ge, dotiertes GaAs, dotiertes Polyanilin, dotiertes Polypyrrol und/oder dotiertes Polythiophen, insbesondere Indium-Zinn-Oxid (ITO) (z.B.(InO₃)_{0,9}(SnO₂)_{0,1});
B) eine Absorberschicht S (entsprechend der lichtemittierenden Schicht S bei OLEDs) enthaltend mindestens einen Metall-Komplex aus mindestens einem Metall M und mindestens einem Liganden L enthält; und
C) Eine zweite Elektrodenschicht aus einem Metall oder einer Metalllegierung, wie beispielsweise Al, Au, Ag, Pt, Cu, Zn, Ni, Fe, Pb, In, W, Pd und/oder Mischungen oder Legierungen aus zwei oder mehr dieser Metalle, Kohlenstoffnanoröhren (engl. "carbon nanotubes", CNTs) und/oder nanoskaligen Silberdrähten, insbesondere Mg, Ca oder Al,
wobei die Einschicht-OSC in der Regel auf ein Substrat aufgebracht ist (etwa mit der ersten Elektrodenschicht) und auf der anderen Außenseite mit einer Schutzschicht geschützt werden kann.

Eine Mehrschicht-OSC kann entsprechend einer OLED aufgebaut sein, wobei die Schicht S bei der OSC als Absorberschicht S bezeichnet wird, ansonsten aber der lichtemittierenden Schicht S einer OLED entsprechen kann und somit auch in der Lage ist unter geeigneten Bedingungen Licht zu emittieren.

Eine opto-elektronische Vorrichtung kann auch verwendet werden, um Licht zu emittieren. Entsprechend ist auch ein Verfahren zur Erzeugung von Licht einer bestimmten Wellenlänge offenbart, umfassend den Schritt der Bereitstellung einer opto-elektronischen Vorrichtung wie hierin gelehrt.

Beispielsweise kann die Wellenlänge des emittierten Lichts auch auf kurzwellige Emission eingestellt werden, so dass blaues Licht emittiert wird. Entsprechend wird auch ein Verfahren zur Erzeugung von blauer, grüner, gelber, orangener oder roter Emission offenbart.

Beispielhaft ist das erzeugte Licht von einer bestimmten Wellenlänge Licht im sichtbaren Bereich des Wellenlängenspektrums daher von 400-800 nm, so etwa im Bereich von 400-500 nm, von 450-550 nm, von 500-600 nm, von 550-650 nm, von 600-700 nm, von 650-750 nm und/oder von 700-800 nm.

Ist die opto-elektronische Vorrichtung eine OLED, kann sie beispielsweise auch als großflächiges Leuchtmittel, als leuchtende Tapete, leuchtendes Fenster, selbstleuchtendes Etikett, selbstleuchtendes Plakat oder biegsamer Bildschirm verwendet werden.

Ist die opto-elektronische Vorrichtung eine OSC, kann sie beispielsweise auch als aufrollbare Solarzelle (etwa für mobile Anwendungen wie z.B. Smartphones, Laptops, Tablets, etc.), als Architekturelement (z.B. Wand- oder Dach-Verkleidungselement) oder als Bauelement im verkehrstechnischen Bereich (z.B. im Automobil-, Flugzeug-, Zug-, und/oder Schiffsbereich) verwendet werden. Auch derartige Produkte, die die opto-elektronische Vorrichtung enthalten, sind hierin offenbart.

Ein weiterer Aspekt der Erfindung betrifft ein Verfahren gemäß der vorliegenden Erfindung, bei dem ein Me(I)-Komplex gebildet wird, der eine Struktur gemäß WO 2014/102079 aufweist.

Ein weiterer Aspekt der Erfindung betrifft ein Verfahren gemäß der vorliegenden Erfindung, bei dem ein Cu(I)-Komplex gebildet wird, der eine Struktur gemäß einer der folgenden Formeln A oder A' aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für entsprechende Komplexe sind auch in WO 2013/007707 (siehe beispielsweise Beispiele 1-6 hieraus) 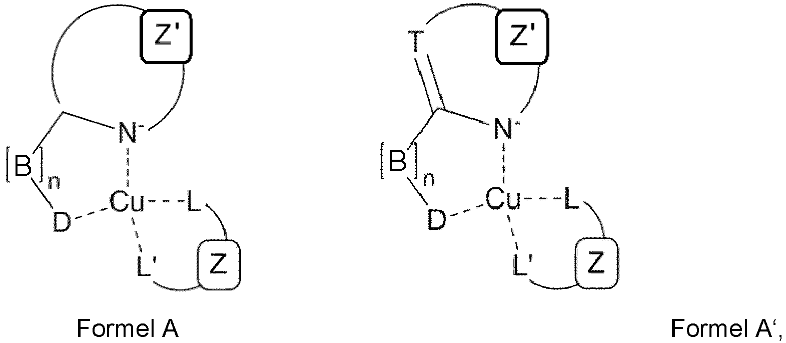
bei der der L, L' und Z umfassende Ligand (L^L') ein neutraler, zweizähniger Ligand ist, der über nicht-ionische Gruppen an das Cu gebunden ist;
bei der der D, [B]ₙ und N⁻ umfassende Ligand (D^N⁻) über eine anionische Gruppe an das Cu gebunden ist;
bei der D ein Rest ist, der mindestens einen Substituenten D* ausgewählt aus der Gruppe bestehend aus einem divalenten Carben C*, N, O, P, S, As und Sb aufweist oder aus D* besteht,
wobei D* eine Bindung zu Cu eingeht,
wobei D darüber hinaus einen Rest mit bis zu 40 Kohlenstoffatomen ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest enthalten kann, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern, und CF₃-Gruppen, substituiert sein kann, wobei die Substituenten miteinander und/oder mit dem Rest D optional eine zyklisierte und/oder anellierte Struktur ausbilden können;
bei der N⁻ anionische Stickstoff ist;
bei der Z' -R^{u}-, -R^{u}-NR^{u"}-, -NR^{u"}-R^{u}-, -R^{u}-NR^{u"}-R^{u'}-, -R^{u}-SiR^{u"}R^{u‴}-R^{u}'-, -R^{u}-SiR^{u"}R^{u‴}-, -SiR^{u"}R^{u‴}-, -R^{u}-GeR^{u"}R^{u‴}-R^{u'}-, -R^{u}-GeR^{u"}R^{u‴}-, -GeR^{u"}R^{u‴}-, R^{u}-, -R^{u}-O-R^{u'}- , -R^{u}-CO-R^{u'}-, -R^{u}-CO-O-R^{u'}-, -R^{u}-O-CO-O-R^{u'}-, -R^{u}-O-CO-R^{u'}-, -O-R^{u}-, -R^{u}-CS-R^{u'}-, -R^{u}-CO-S-R^{u'}-, -R^{u}-S-CO-R^{u'}-, -R^{u}-CO-NH-R^{u'}-, -R^{u}-NH-CO-R^{u'}-, -R^{u}-O-, -R^{u}-S-R^{u'}-, -S-R^{u'}-, -R^{u}-S-, -R^{u}-SO-R^{u'}-, -SO-R^{u'}-, -R^{u}-SO-, -R^{u}-SO₂-R^{u'}-, -SO₂-R^{u'}- oder -R^{u}-SO₂-ist,
wobei R^{u} und R^{u'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{u"} und R^{u‴} unabhängig voneinander jeweils ein Rest mit bis zu 40 Kohlenstoffatomen sind, unabhängig voneinander ausgewählt aus der Gruppe bestehend aus Wasserstoff, Halogen, -R^{t}, -OC(O)R^{t}, -COOH, -OR^{t}, -NR^{t}R^{t'}, - SiR^{t}R^{t'}R^{t"}, -GeR^{t}R^{t'}R^{t"}, -SR^{t}, -SOR^{t}, -SO₂R^{t} und weiteren Donor- und Akzeptor-Gruppen, wie beispielsweise Carboxylaten und deren Estern und CF₃-Gruppen,
wobei R^{t}, R^{t'} und R^{t"} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t}, R^{t'}, R^{t"}, R^{u}, R^{u'}, R^{u"} und R^{u‴} optional auch zu anellierten Ringsystemen führen können;
bei der jedes B eine divalente organische Brücke unabhängig voneinander ausgewählt aus der Gruppe bestehend aus =CR^{z}-, -CR^{z}R^{y}-, -NR^{z}-, -O-, -SiR^{z}R^{y}-, - GeR^{z}R^{y}-, -S-, -S(O)- und -S(O)₂- oder eine Bindung ist,
wobei R^{z} und R^{y} unabhängig voneinander ausgewählt sind aus der Gruppe bestehend aus Wasserstoff, Halogen -OR^{x}, -O-C(O)-R^{x}, -NR^{x}R^{x'}, -SiR^{x}R^{x'}R^{x"}, - GeR^{x}R^{x'}R^{x"}, -SR^{x}, -SOR^{x} und -SO₂R^{x},
wobei R^{x}, R^{x'} und R^{x"} unabhängig von einander ausgewählt sind aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{x}, R^{y} und R^{z} optional auch zu anellierten Ringsystemen führen können, wobei beispielhaft B Bestandteil einer Phenyl- und/oder substituierten Phenyleinheiten sein kann/können,
wobei mehrere B sowohl gleich als auch verschieden sein können,
wobei sich zwischen N⁻ und D* mindestens ein Kohlenstoffatom befindet,
wobei ein oder mehrere Substituenten von D und/oder von N⁻ mit B optional zyklische, aliphatische, konjugierte, aromatische und/oder anellierte Systeme ausbilden können;
bei der T CR^{w} oder Stickstoff ist,
wobei R^{w} ein Rest, ausgewählt aus der Gruppe bestehend aus Wasserstoff, Halogen, -R^{v}, -OC(O)R^{v}, -COOH, -OR^{v}, -NR^{v}R^{v'}, -SiR^{v}R^{v'}R^{v"}, -GeR^{v}R^{v'}R^{v"}, -SR^{v}, - SOR^{v}, -SO₂R^{v} und weiteren Donor- und Akzeptor-Gruppen, wie beispielsweise Carboxylaten und deren Estern und CF₃-Gruppen,
wobei R^{v}, R^{v'} und R^{v"} unabhängig von einander ausgewählt sind aus der Gruppe bestehend aus H, OH, NH₂, NHR^{v‴}, NHR^{v‴}R^{vʺʺ}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest.
wobei R^{v‴} und R^{vʺʺ} unabhängig von einander ausgewählt sind aus der Gruppe bestehend aus OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest.
wobei zwei oder mehr der Reste R^{v}, R^{v"}, R^{v‴} und R^{w} optional auch ein oder mehr anellierte Ringsysteme bilden können,
wobei T optional mit einem oder mehreren B ein oder mehrere Ringsysteme ausbilden kann;
bei der n für die ganzen Zahlen von 1 bis 9 steht;
bei der L und L' unabhängig voneinander jeweils ein an das Cu gebundener Substituent sind,
wobei L einen Substituenten L* enthält und L' einen Substituenten L`*enthält, wobei L* und L'* unabhängig voneinander ausgewählt sind aus der Gruppe bestehend aus einem divalenten Carben C*, N, O, P, S, As und Sb und L* und L`* jeweils eine Bindung zu dem Cu eingehen,
wobei L ein oder mehr, bevorzugt drei, Substituenten enthält, die an L* gebunden sind und wobei L' ein oder mehr, bevorzugt drei, Substituenten enthält, die an L*' gebunden sind,
wobei die an L* und L'* gebundenen Substituenten unabhängig voneinander jeweils ein Substituent mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei jeweils ein an L* gebundener Substituent und ein an L'* gebundener Substituent über Z miteinander verbunden sein können, insbesondere wobei die übrigen an L* und L`* gebundenen Substituenten jeweils Arylreste sind,
bei der Z -O-, eine Bindung, -R^{ub}- -R^{ub}-NR^{ub"}-, -NR^{ub"}-R^{ub}-, -R^{ub}-NR^{ub"}-R^{ub'}-, -R^{ub}-SiR^{ub"}R^{ub‴}-R^{ub'}-, -R^{ub}-SiR^{ub"}R^{ub‴}-, -SiR^{ub"}R^{ub‴}-R^{ub}-, -R^{ub}-GeR^{ub"}R^{ub‴}-R^{ub'}-, -R^{ub}-GeR^{ub"}R^{ub‴}-, -GeR^{ub"}R^{ub‴}-R^{ub}-, -R^{ub}-O-R^{ub'}-, -R^{ub}-CO-R^{ub'}-, -R^{ub}-CO-O-R^{ub}'-, -R^{ub}-O-CO-O-R^{ub'}-, -R^{ub}-O-CO-R^{ub'}-, -O-R^{ub'},-R^{ub}-CS-R^{ub'}-, -R^{ub}-CO-S-R^{ub'}-, -R^{ub}-S-CO-R^{ub'}-, -R^{ub}-CO-NH-R^{ub'}-, -R^{ub}-NH-CO-R^{ub'}-, -R^{ub}-CO-NR^{v‴}-R^{ub'}-, -R^{ub}-NR^{v‴}-CO-R^{ub'}-, -R^{ub}-O-, -R^{ub}-S-R^{ub'}-, -S-R^{ub'}, -R^{ub}-S-, -R^{ub}-SO-R^{ub'}-, -SO-R^{ub'}, -R^{ub}-SO-, -R^{ub}-SO₂-R^{ub'}-, -SO₂-R^{ub'} oder -R^{ub}-SO₂- ist oder Z fehlt und somit keine Bindung zwischen L und L' vorliegt,
wobei R^{ub} und R^{ub'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{ub"} und R^{ub‴} unabhängig voneinander jeweils ein Rest mit bis zu 40 Kohlenstoffatomen sind, unabhängig voneinander ausgewählt aus der Gruppe bestehend aus Wasserstoff, Halogen, -R^{t‴}, -OC(O)R^{t‴}, -COOH, -OR^{t‴}, -NR^{t‴}R^{tʺʺ},-SiR^{t‴}R^{tʺʺ}R^{tʺ‴}, -GeR^{t‴}R^{tʺʺ}R^{tʺ‴} -SR^{t‴}, -SOR^{t‴}, -SO₂R^{t‴} und weiteren Donor- und Akzeptor-Gruppen, wie beispielsweise Carboxylaten und deren Estern und CF₃-Gruppen,
wobei R^{t‴}, R^{tʺʺ} und R^{t‴ʺ} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t‴}, R^{tʺʺ}, R^{tʺ‴}, R^{ub}, R^{ub'}, R^{ub"} und R^{ub‴} optional auch zu anellierten Ringsystemen führen können.
Z kann auch fehlen, so dass L udn L' jeweils unabhängig voneinander an das Cu gebunden sind. Alternativ können auch zwei oder mehr Z L und L' mit einander verbinden.

In einer Ausführungsform bildet N⁻ zusammen mit Z' der Formel A oder A' für ein Anion einer ungesättigten oder aromatischen N-heterozyklischen Einheit mit 5 bis 14 Ring-Atomen, die nach N-Deprotonierung eines Rests ausgewählt aus der Gruppe bestehend aus Purinyl, Pyrryl, Indyl, Carbazolyl, Triazolyl, Benzotriazolyl, Pyrazolyl, Benzopyrazolyl, Imidazolyl, Benzimidazolyl, und Tetrazolyl erhalten werden kann und die optional weiter substituiert sein kann.

In einer Ausführungsform ist der Rest D des D, [B]ₙ und N- umfassenden Liganden (N⁻^D) der Formel A oder A' ausgewählt aus der Gruppe bestehend aus (wobei der Ligand nicht mehr als 20 Kohlenstoffatome aufweist):
(i) einem Carben C*, das Teil eines Carbenliganden ist, ausgewählt aus der Gruppe bestehend aus 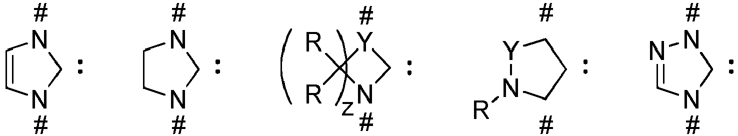 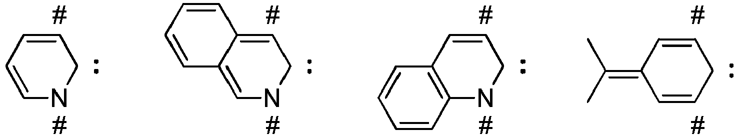 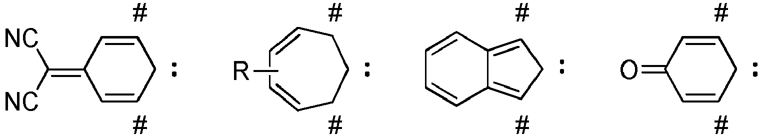 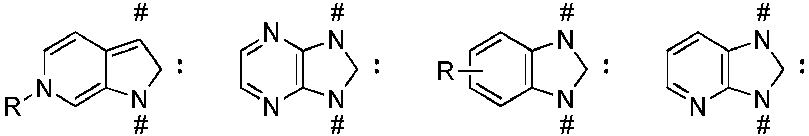
   wobei die zwei Punkte ":" für ein divalentes Carben stehen, das an das Cu-Atom koordiniert, und die Verknüpfung zu B an einer der mit # gekennzeichneten Stellen stattfindet;
   wobei die andere die andere mit #- gekennzeichnete Bildungsstelle dann mit einem Rest ausgewählt aus der Gruppe bestehend aus Wasserstoff, Deuterium, Halogen -OR^{s}, -O-C(O)-R^{s}, -NR^{s}R^{s'}, -SiR^{s}R^{s'}R^{s"}, -GeR^{s}R^{s'}R^{s"}, - SR^{s}, -SOR^{s} und -SO₂R^{s} verbunden sein kann
   wobei R jeweils unabhängig ausgewählt ist aus der Gruppe bestehend aus Wasserstoff, Deuterium, Halogen, -R^{s} -OR^{s}, -O-C(O)-R^{s}, -NR^{s}R^{s'}, - SiR^{s}R^{s'}R^{s"},-GeR^{s}R^{s'}R^{s"}, -SR^{s}, -SOR^{s} und -SO₂R^{s},
   wobei R^{s}, R^{s'} und R^{s"} unabhängig von einander ausgewählt sind aus Wasserstoff, Deuterium, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei die Reste R, R^{s}, R^{s'} und R^{s"} optional auch zu anellierten Ringsystemen führen können;
   wobei Y Stickstoff oder CR^{r} ist,
   wobei R^{r} ein Rest, ausgewählt aus der Gruppe bestehend aus Wasserstoff, Deuterium, Halogen, -R^{q}, -OC(O)R^{q}, -COOH, -OR^{q}, -NR^{q}R^{q'}, -SiR^{q}R^{q'}R^{q"}, - GeR^{q}R^{q'}R^{q"}, -SR^{q}, -SOR^{q}, -SO₂R^{q} und weiteren Donor- und Akzeptor-Gruppen, wie beispielsweise Carboxylaten und deren Estern und CF₃-Gruppen,
   wobei R^{q}, R^{q'} und R^{q"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei zwei oder mehr der Reste R^{q}, R^{q'}, R^{q"} und R^{r} optional auch zu anellierten Ringsystemen führen können,
   wobei hierbei z für die ganzen Zahlen 1, 2, 3 oder 4 steht;
(ii) einer ungesättigten oder aromatischen N-heterozyklischen Einheit mit 4 bis 8 Ring-Atomen, wobei die Koordination an das Cu-Atom über ein Stickstoffatom der N-heterozyklischen Einheit stattfindet, die ausgewählt ist aus der Gruppe bestehend aus Pyridyl, Pyrimidyl, Pyridazyl, Pyrazyl, Pyranyl, Cumaryl, Pteridyl, Thiophenyl, Benzothiophenyl, Furyl, Benzofuryl, Oxazolyl, Thiazolyl, Imidazolyl, Pyrazolyl, Thienothienyl, Dithiaindacenyl, Chinolyl, Isochinolyl, Chinoxalyl, Acridyl, Azanaphthyl, Phenanthrolyl, Triazinyl, Thienyl, Thiadiazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl und 1,2,3,4-Thiatriazolyl, die optional weiter substituiert und/oder anelliert sind, und einer N-heterozyklischen Einheit ausgewählt aus der Gruppe bestehend aus: 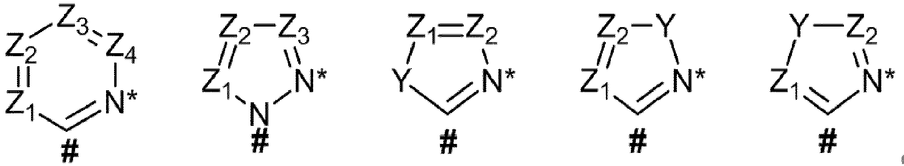
   wobei die Verknüpfung zu B an der mit # gekennzeichneten Stelle stattfindet und * das Atom kennzeichnet, das die Komplexbindung eingeht, wobei Z₁, Z₂, Z₃ und Z₄ jeweils unabhängig voneinander ausgewählt CR^{I} oder Stickstoff sind,
   wobei R^{I} ein Rest, ausgewählt aus der Gruppe bestehend aus Wasserstoff, Deuterium, Halogen, -R^{k}, -OC(O)R^{k}, -COOH, -OR^{k}, -NR^{k}R^{k'}, -SiR^{k}R^{k'}R^{k"}, - GeR^{k}R^{k'}R^{k"}, -SR^{k}, -SOR^{k}, -SO₂R^{k} und weiteren Donor- und Akzeptor-Gruppen, wie beispielsweise Carboxylaten und deren Estern und CF₃-Gruppen,
   wobei R^{k}, R^{k'} und R^{k"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei der/die Reste R^{k}, R^{k'}, R^{k"} und R^{I} optional auch zu anellierten Ringsystemen führen können,
(iii) einer Phosphanyl-, Arsenyl- oder Antimonyleinheit der Form -ERⁱR^{j},
   wobei E ausgewählt ist aus der Gruppe bestehend aus P, As und Sb, die an das Cu-Atom koordinieren,
   wobei Rⁱ und R^{j} unabhängig von einander jeweils ein Rest ausgewählt aus der Gruppe bestehend aus Wasserstoff, Deuterium, Halogen, -R^{k}, - OC(O)R^{k}, -COOH, -OR^{k}, -NR^{k}R^{k'}, -SiR^{k}R^{k'}R^{k"}, -GeR^{k}R^{k'}R^{k"}, -SR^{k}, -SOR^{k}, - SO₂R^{k} und weiteren Donor- und Akzeptor-Gruppen, wie beispielsweise Carboxylaten und deren Estern und CF₃-Gruppen, sind,
   wobei R^{k}, R^{k'} und R^{k"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
   wobei der/die Reste R^{h}, R^{h'}, R^{h"}, Rⁱ und R^{j} optional auch zu anellierten Ringsystemen führen können,

In einer Ausführungsform ist das Carben C* des D, [B]ₙ und N- umfassenden Liganden (N⁻^D) der Formel A oder A' Teil einer Struktur ausgewählt aus der Gruppe bestehend aus: 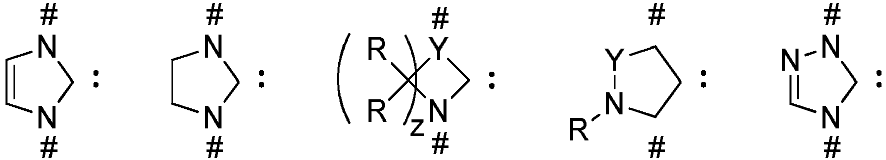 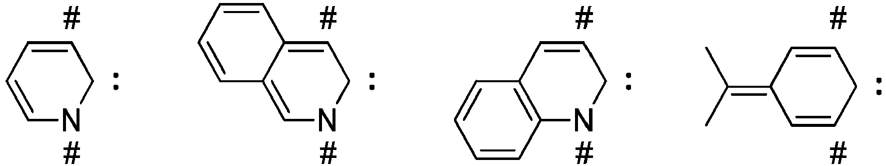 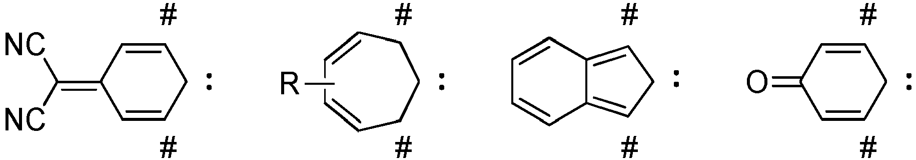 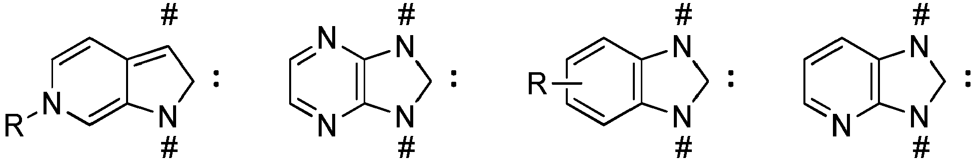
wobei die zwei Punkte ":" für ein divalentes Carben stehen, das an das Cu-Atom koordiniert, und die Struktur mit einer der mit # gekennzeichneten Stellen mit B verknüpft ist;
wobei die andere die andere mit # gekennzeichnete Bildungsstelle dann mit einem Rest ausgewählt aus der Gruppe bestehend aus Wasserstoff, Halogen -OR^{g}, -O-C(O)-R^{g}, -NR^{g}R^{g'}, -SiR^{g}R^{g'}R^{g"},-GeR^{g}R^{g'}R^{g"}, -SR^{g}, -SOR^{g} und -SO₂R^{g},
wobei R jeweils unabhängig ausgewählt ist aus der Gruppe bestehend aus Wasserstoff, Deuterium, Halogen, -R^{g}, -OR^{g}, -O-C(O)-R^{g}, -NR^{g}R^{g'}, -SiR^{g}R^{g'}R^{g"},-GeR^{g}R^{g'}R^{g"}, -SR^{g}, -SOR^{g} und -SO₂R^{g},
wobei R^{g}, R^{g}' und R^{g}" unabhängig von einander ausgewählt sind aus H, OH, NH₂, NR^{s}R^{s}', NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R, R^{g}, R^{g}' und R^{g}" optional auch zu anellierten Ringsystemen führen können; und
wobei Y Stickstoff oder CR^{f} ist,
wobei R^{f} ein Rest, ausgewählt aus der Gruppe bestehend aus Wasserstoff, Deuterium, Halogen, -R^{e}, -OC(O)R^{e}, -COOH, -OR^{e}, -NR^{e}R^{e}', -SiR^{e}R^{e}'R^{e}", - GeR^{e}R^{e}'R^{e}", -SR^{e}, -SOR^{e}, -SO₂R^{e} und weiteren Donor- und Akzeptor-Gruppen, wie beispielsweise Carboxylaten und deren Estern und CF₃-Gruppen,
wobei R^{e}, R^{e}' und R^{e"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R^{e}, R^{e'}, R^{e"} und R^{f} optional auch zu anellierten Ringsystemen führen können,
wobei hierbei z für die ganzen Zahlen 1, 2, 3 oder 4 steht.

In einer Ausführungsform handelt es sich bei dem Liganden L^L' der Formeln A und A' um einen zweizähnigen Liganden der Form L-G-L`,
bei dem G ein substituierter oder unsubstituierter C₁₋₉-Alkylen-, C₂₋₈-Alkenylen-, C₂₋₈-Alkinylen- oder Arylenrest, -R^{d}-NR^{d}"-, -NR^{d"}-R^{d}-, -R^{d}-NR^{d"}-R^{d}-, -R^{d}-SiR^{d"}R^{d‴}-R^{d'}-, -R^{d}-SiR^{d"}R^{d‴}-, -SiR^{d"}R^{d‴}- -R^{d}-GeR^{d"}R^{d‴}-R^{d'}-, -R^{d}-GeR^{d"}R^{d‴}-, -GeR^{d"}R^{d‴}-, -R^{d}, -R^{d}-O-R^{d'}-, -R^{d}-CO-R^{d'}- , -R^{d}-CO-O-R^{d'}- , -R^{d}-O-CO-O-R^{d'}-, -R^{d}-O-CO-R^{d'}-, -O-R^{d'}-, -R^{d}-CS-R^{d'}-, -R^{d}-CO-S-R^{d'}-, -R^{d}-S-CO-R^{d'}-, -R^{d}-CO-NH-R^{d'}-, -R^{d}-NH-CO-R^{d'}-, -R^{d}-O-,-R^{d}-S-R^{d'}-, -S-R^{d'}-, -R^{d}-S-, -R^{d}-SO-R^{d'}-, -SO-R^{d'}-, -R^{d}-SO-, -R^{d}-SO₂-R^{d'}-, -SO₂-R^{d'}-, oder -R^{d}-SO₂- ist,
wobei R^{d} und R^{d'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit einem oder beiden der Reste L und/oder L' optional eine zyklisierte und/oder anellierte Struktur ausbilden können,
wobei R^{d"} und R^{d‴} unabhängig voneinander jeweils ein Rest mit bis zu 20 Kohlenstoffatomen sind, unabhängig voneinander ausgewählt aus der Gruppe bestehend aus Wasserstoff, Halogen, -R^{c}, -OC(O)R^{c}, -COOH, -OR^{c}, -NR^{c}R^{c'}, - SiR^{c}R^{c'}R^{c"}, -GeR^{c}R^{c'}R^{c"}, -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NR^{s}R^{s'}, NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{d}, R^{d'}, R^{d"} und R^{d‴} optional auch zu anellierten Ringsystemen führen können;
bei dem L und L' Substituenten sind, die gleich oder verschieden sind und die unabhängig voneinander ausgewählt sind aus der Gruppe bestehend aus (wobei der Ligand nicht mehr als 20 Kohlenstoffatome aufweist):
   (i) dem Fragment X^{b} oder einer ungesättigten oder aromatischen N-heterozyklischen Einheit mit 4 bis 8 Ring-Atomen, die ausgewählt ist aus der Gruppe bestehend aus Pyridyl, Pyrimidyl, Pyridazyl, Pyrazyl, Pyranyl, Cumaryl, Pteridyl, Thiophenyl, Benzothiophenyl, Furyl, Benzofuryl, Oxazolyl, Thiazolyl, Imidazolyl, Pyrazolyl, Thienothienyl, Dithiaindacenyl, Chinolyl, Isochinolyl, Chinoxalyl, Acridyl, Azanaphthyl, Phenanthrolyl, Triazinyl, Thienyl, Thiadiazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl und 1,2,3,4-Thiatriazolyl, die optional weiter substituiert und/oder anelliert sind,
      wobei die Koordination an das Cu-Atom über das Stickstoffatom des Fragments X^{b} oder ein Stickstoffatom der N-heterozyklischen Einheit stattfindet,
      wobei das Fragment X^{b} ausgewählt ist aus der Gruppe bestehend aus: 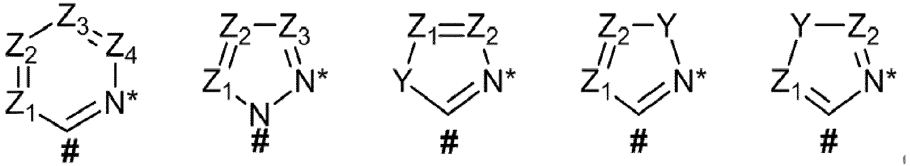
      wobei die Verknüpfung zu G an der mit # gekennzeichneten Stelle stattfindet und * das Atom, das die Komplexbindung eingeht, kennzeichnet,
      wobei Z₁, Z₂, Z₃ und Z₄ jeweils unabhängig voneinander CR^{az} oder Stickstoff sind,
      wobei R^{az} ein Rest, ausgewählt aus der Gruppe bestehend aus Wasserstoff, Halogen, -R^{ay}, -OC(O)R^{ay}, -COOH, -OR^{ay}, -NR^{ay}R^{ay'}, - SiR^{ay}R^{ay'}R^{ay"}, -GeR^{ay}R^{ay'}R^{ay"}, -SR^{ay}, -SOR^{ay}, -SO₂R^{ay} und weiteren Donor- und Akzeptor-Gruppen, wie beispielsweise Carboxylaten und deren Estern und CF₃-Gruppen,
      wobei R^{ay}, R^{ay'} und R^{ay"} unabhängig von einander ausgewählt sind aus der Gruppe bestehend aus H, OH, NH₂, NR^{s}R^{s}', NHR^{s}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
      wobei der/die Reste R^{ay}, R^{ay'}, R^{ay'} und R^{az} optional auch zu anellierten Ringsystemen führen können,
   (ii) einer Phosphanyl-, Arsenyl- oder Antimonyleinheit der Form -ERⁱR^{j} wie oben definiert; und/oder
   (iii) einer das C* enthaltende Gruppe D, die ausgewählt ist aus der Gruppe bestehend aus:

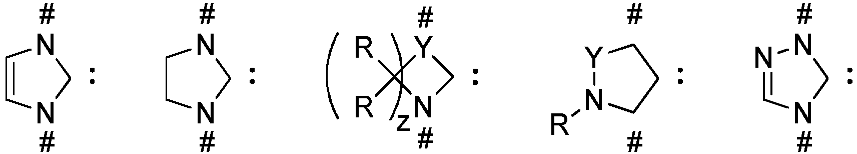

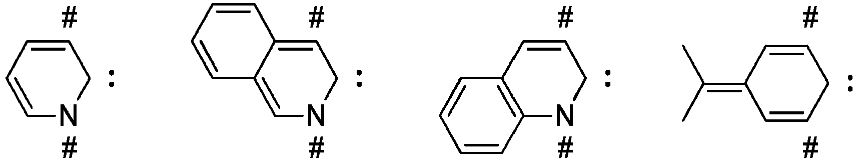

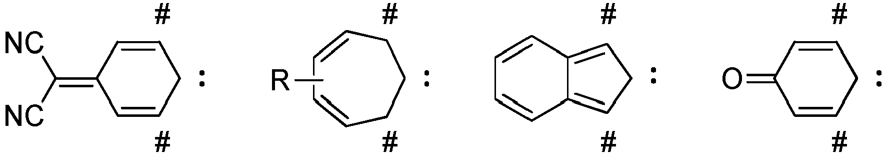

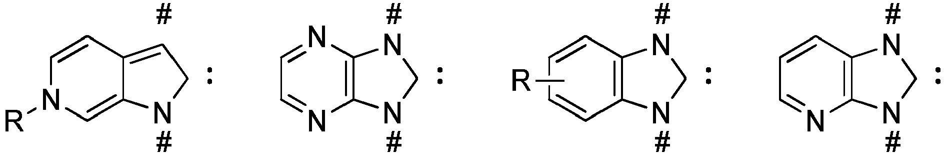

   wobei die zwei Punkte ":" für ein divalentes Carben stehen, das an das Cu-Atom koordiniert, und die Struktur mit einer der mit # gekennzeichneten Stellen mit B verknüpft ist;
   wobei die andere die andere mit # gekennzeichnete Bildungsstelle dann mit einem Rest ausgewählt aus der Gruppe bestehend aus Wasserstoff, Halogen -OR^{g}, -O-C(O)-R^{g}, -NR^{g}R^{g'}, -SiR^{g}R^{g'}R^{g"},-GeR^{g}R^{g'}R^{g"}, -SR^{g}, -SOR^{g} und -SO₂R^{g} substituiert sein kann,
   wobei die Reste R, R^{g}, R^{g'}, R^{g"} und Y und z wie oben definiert sind.

Ein weiterer Aspekt der Erfindung betrifft ein Verfahren gemäß der vorliegenden Erfindung, bei dem ein Cu(I)-Komplex gebildet wird, der eine Struktur gemäß der folgenden Formel B aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/007707 (Formeln I und A hieraus) und in WO 2010/031485 (siehe beispielsweise Formeln II, IV und VI-IX hieraus) gezeigt. 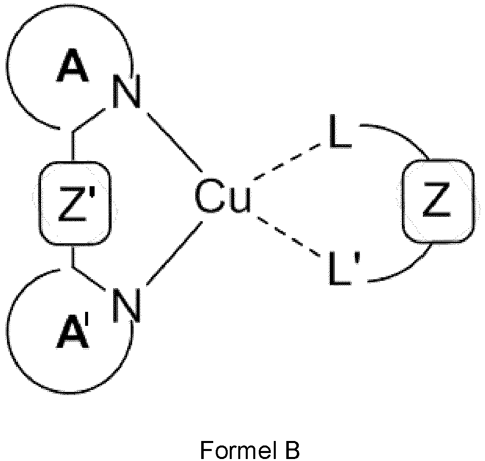
bei der der L, L' und Z umfassende Ligand (L^L') ein neutraler, zweizähniger Ligand ist, der über nicht-ionische Gruppen an das Cu gebunden ist;
bei der der die Ringsysteme A und A' und den überbrückenden Liganden Z' umfassende Ligand (N^N) optional über eine anionische Gruppe an das Cu gebunden sein kann, wobei der Ligand N^N dann die positive Ladung des Cu(I) neutralisieren kann;
wobei die Ringsysteme A und A' eine der folgenden Strukturen aufweisen: 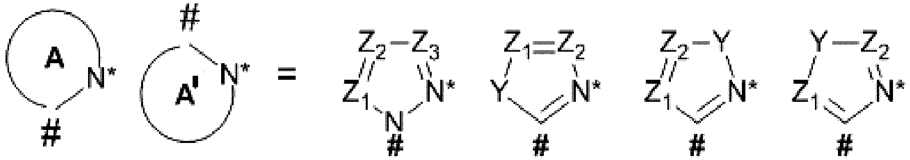
wobei Z₁, Z₂ und Z₃ jeweils unabhängig von einander Stickstoff oder CR sind,
wobei R unabhängig von einander ausgewählt ist aus der Gruppe bestehend aus - H, -D, -F, -Cl, -Br, -I, -CN, -NO₂, -SO, -SO₂, -OH, -OR^{a}, -SH, -SR^{a}, -R^{a}-NR¹R², - NR¹R², -R^{a}-C(=O)R¹, -C(=O)R¹, -R^{a}-SiR¹R²R³, -SiR¹R²R³, -R^{a}-GeR¹R²R³, - GeR¹R²R³, -R^{a}-SeR¹R²R³, -SeR¹R²R³, -R^{a}-R¹C=CR²R³, -R¹C=CR²R³, -R^{a}-C≡C-R¹, -C≡C-R¹, -R^{a}-C=O, -R^{a}-C=S, -R^{a}-C=Se, -R^{a}-C=NR¹, -C=O, -C=S, -C=Se, - C=NR¹, -R^{a}-C-N=R¹, -C-N=R¹, -R^{a}-POR¹ R² R³, -R^{a}-N=R⁴, -CO-NH-R¹, -R^{a}-CO-NH-R¹, -NH-CO-R¹, -R^{a}-NH-CO-R¹,
wobei R¹, R² und R³ unabhängig von einander ausgewählt sind aus der Gruppe bestehend aus H, D, F, I, Br, Cl, CN, einem aliphatischen Kohlenwasserstoffrest mit 1 bis 20 Kohlenstoffatomen, aromatischen oder heteroaromatischen Ringsystem mit 5 bis 30 aromatischen Ringatomen, in dem ein oder mehrere Wasserstoffatome optional durch D, F, Cl, Br, I oder CN ersetzt sein können,
wobei R⁴ ausgewählt ist aus der Gruppe bestehend aus einem aliphatischen Kohlenwasserstoffrest mit 1 bis 20 Kohlenstoffatomen, in dem ein oder mehrere Wasserstoffatome optional durch D, F, Cl, Br, I oder CN ersetzt sein können und der optional mit einem oder mehreren aromatischen oder heteroaromatischen Ringen substituiert sein kann,
wobei R^{a} ausgewählt ist aus der Gruppe bestehend aus einem substituierten oder unsubstituierten C₁₋₉-Alkylen-, C₂₋₈-Alkenylen-, C₂₋₈-Alkinylen- oder Arylenrest, -R^{a'}-NR^{a‴}-, -NR^{a‴}-R^{a'}-, -R^{a'}-NR^{a‴}-R^{a"}-, -R^{a'}-SiR^{a‴}R^{aʺʺ}-R^{a"}-, -R^{a'}-SiR^{a‴}R^{aʺʺ}-, -SiR^{a‴}R^{aʺʺ}-R^{a'}-, -R^{a'}-O-R^{a"}-, -R^{a}-CO-R^{a"}-, -R^{a}-CO-O-R^{a"}-, -R^{a'}-O-CO-O-R^{a"}-, -R^{a}'-O-CO-R^{a"}-,-O-R^{a"}, -R^{a'}-CS-R^{a"}-, -R^{a'}-CO-S-R^{a"}-, -R^{a'}-S-CO-R^{a"}-, -R^{a'}-CO-NH-R^{a"}-, -R^{a'}-NH-CO-R^{a"}-, -R^{a'}-O-, -R^{a'}-S-R^{a"}-, -S-R^{a"}-, -R^{a'}-S-, -R^{a'}-SO-R^{a"}-, -SO-R^{a"}-, -R^{a'}-SO-, -R^{a'}-SO₂-R^{a"}-, -SO₂-R^{a"}- und -R^{a'}-SO₂- ist,
wobei R^{a'} und R^{a"} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest Z` optional eine zyklisierte und/oder anellierte Struktur ausbilden können,
wobei R^{a‴} und R^{aʺʺ} unabhängig voneinander jeweils ein Rest mit bis zu 20 Kohlenstoffatomen sind, unabhängig voneinander ausgewählt aus der Gruppe bestehend aus Wasserstoff, Halogen, -R^{c}, -OC(O)R^{c}, -COOH, -OR^{c}, -NR^{c}R^{c'}, - SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{a‴}, NR^{a‴}R^{aʺʺ}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a'}, R^{a"}, R^{a‴} und R^{aʺʺ} optional auch zu anellierten Ringsystemen führen können,
wobei zwei oder mehr benachbarte Substituenten miteinander ein mono-, di-, tri- oder polycyclisches, aliphatisches, aromatisches oder heteroaromatisches Ringsystem bilden können; und
wobei Y O, S oder NR ist, wobei R wie oben definiert ist;
wobei Z' BR¹R² ist, wobei R¹ und R² wie oben definiert sind und B für ein Boratom steht, insbesondere wobei Z' ausgewählt ist aus der Gruppe bestehend aus H₂B, BPh₂, B(CH₃)₂ und B(NR¹R²)₂, wobei Ph ein Phenylrest ist, wobei R¹ und R² wie oben definiert sind und B für ein Boratom steht, insbesondere wobei Z' ausgewählt ist aus der Gruppe bestehend aus H₂B, BPh₂, B(CH₃)₂ und B(NR¹R²)₂, wobei Ph ein Phenylrest ist,
wobei "*" das Atom kennzeichnet, das die Komplexbindung eingeht und "#" das Atom kennzeichnet, das über Z' mit der zweiten Einheit verbunden ist,
bei der L und L' wie oben unter Formel A definiert sein können,
wobei Z wie oben unter Formel A definiert sein kann und/oder ein Rest ist ausgewählt aus der Gruppe bestehend aus -R^{ub}- -R^{ub}-NR^{ub"}-, -NR^{ub"}-R^{ub}-, -R^{ub}-NR^{ub"}-R^{ub'}-, -R^{ub}-SiR^{ub"}R^{ub‴}-R^{ub'}-, -R^{ub}-SiR^{ub"}R^{ub‴}-, -SiR^{ub"}R^{ub‴}-R^{ub}-, -R^{ub}-O-R^{ub'}-, - R^{ub}-CO-R^{ub'}-, -R^{ub}-CO-O-R^{ub'}-, -R^{ub}-O-CO-O-R^{ub'}-, -R^{ub}-O-CO-R^{ub'}-, -O-R^{ub'}-, -R^{ub}-CS-R^{ub'}-, -R^{ub}-CO-S-R^{ub'}-, -R^{ub}-S-CO-R^{ub'}- , -R^{ub}-CO-NH-R^{ub'}-, -R^{ub}-NH-CO-R^{ub'}-, - R^{ub}-O-, -R^{ub}-S-R^{ub'}-, -S-R^{ub'}-, -R^{ub}-S-, -R^{ub}-SO-R^{ub'}-, -SO-R^{ub'}-, -R^{ub}-SO-, -R^{ub}-SO₂-R^{ub'}-, -SO₂-R^{ub'} oder -R^{ub}-SO₂- ist,
wobei R^{ub} und R^{ub'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest Z optional eine zyklisierte und/oder anellierte Struktur ausbilden können,
wobei R^{ub"} und R^{ub‴} unabhängig voneinander jeweils ein Rest mit bis zu 40 Kohlenstoffatomen sind, unabhängig voneinander ausgewählt aus der Gruppe bestehend aus Wasserstoff, Halogen, -R^{t‴}, -OC(O)R^{t‴}, -COOH, -OR^{t‴}, -NR^{t‴}R^{tʺʺ},-SiR^{t‴}R^{tʺʺ}R^{tʺ‴} -SR^{t‴}, -SOR^{t‴}, -SO₂R^{t‴} und weiteren Donor- und Akzeptor-Gruppen, wie beispielsweise Carboxylaten und deren Estern und CF₃-Gruppen,
wobei R^{t‴}, R^{tʺʺ} und R^{tʺ‴} unabhängig von einander ausgewählt sind aus der Gruppe bestehend aus H, OH, NH₂, NHR^{a‴}, NR^{a‴}R^{aʺʺ}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{t‴}, R^{tʺʺ}, R^{tʺ‴}, R^{ub}, R^{ub'}, R^{ub"} und R^{ub"} optional auch zu anellierten Ringsystemen führen können; und
wobei mindestens einer der Reste Z oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Folgende Beispiele sollen diese Liganden N^N verdeutlichen: 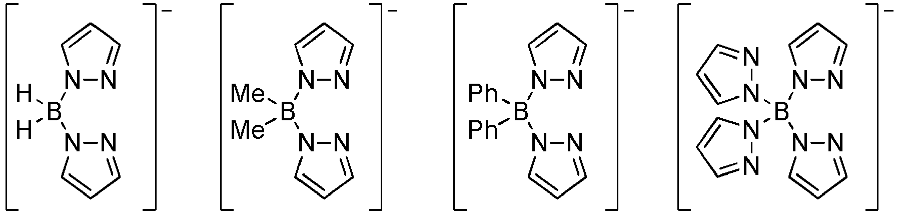 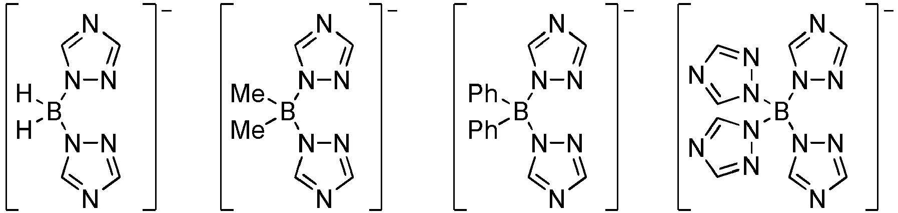 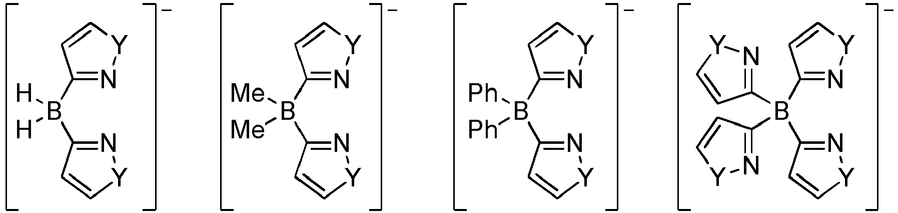 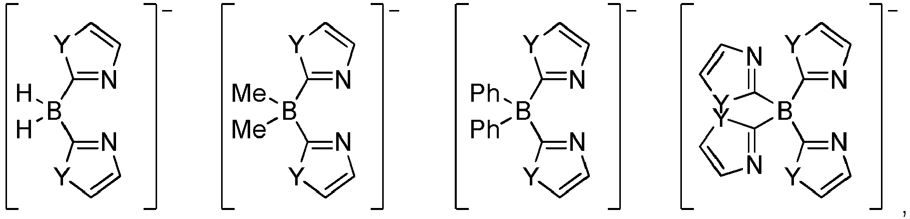 wobei Me für einen Methylrest und Ph für einen Phenylrest steht.

Ein weiterer Aspekt der Erfindung betrifft ein Verfahren gemäß der vorliegenden Erfindung, bei dem ein Metall(I)-Komplex gebildet wird, der eine Struktur gemäß der folgenden Formel C aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2014/102079 (siehe beispielsweise Formeln A und I-IX hieraus) gezeigt. 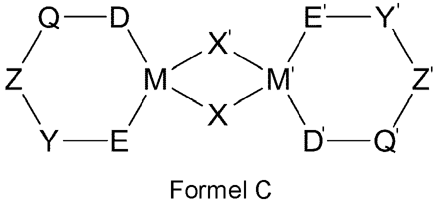
bei der M und M' unabhängig voneinander ausgewählt sind aus der Gruppe bestehend aus Cu, Ag und Au, insbesondere beide jeweils Cu sind;
bei der X und X' unabhängig voneinander ausgewählt sind aus der Gruppe bestehend aus Cl, Br, I, CN, OCN, SCN, Alkinyl und Azid;
bei der die E, Y, Z, Q und D umfassenden Liganden (E∩D) und die bei der die E', Y`, Z`, Q' und D' umfassenden Liganden (E'nD') jeweils ein zweizähniger Ligand sind,
wobei E und E' unabhängig voneinander jeweils entweder RR'E* ist, wobei E* für N, P, As oder Sb steht, wobei N ein Imin-Stickstoffatom oder Teil eines N-heteroaromatischen Rings ist oder nicht ist, oder E und E' unabhängig voneinander jeweils RE* ist, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹, - NR¹R¹', -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1"}, R und R' optional auch zu anellierten Ringsystemen führen können;
wobei D und D' unabhängig voneinander jeweils entweder R"R‴D* ist, wobei D* für N, P, As oder Sb steht, wobei N ein Imin-Stickstoffatom oder Teil eines N-heteroaromatischen Rings ist oder nicht ist, oder D und D' unabhängig voneinander jeweils R"D* ist, wobei D* für ein divalentes Carben C*, O oder S steht,
wobei R" und R‴ jeweils unabhängig voneinander ausgewählt ist aus der Gruppe bestehend aus Wasserstoff, Halogen, Deuterium, -R², -OC(O)R², -COOH, -OR², - NR²R^{2'}, -SiR²R^{2'}R^{2"} -SR², -SOR², -SO₂R² und weiteren Donor- und Akzeptor-Gruppen, wie beispielsweise Carboxylaten und deren Estern und CF₃-Gruppen,
wobei R², R^{2'} und R^{2"} unabhängig von einander ausgewählt sind aus der Gruppe bestehend aus H, OH, NH₂, NHR¹, NR¹R¹', einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R², R^{2'}, R^{2"} und R" und R‴ optional auch zu anellierten Ringsystemen führen können;
wobei D und E verschieden voneinander oder gleichartig sind;
wobei Q, Y, Z, Q', Y` und Z` unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a‴}-R^{a'}-, -R^{a}-NR^{a"}-R^{a'}-, -R^{a}-SiR^{a"}R^{a‴}-R^{a}'-, -R^{a}-SiR^{a"}R^{a‴}, -SiR^{a"}R^{a‴}-R^{a}-, -R^{a}-O-R^{a'}-, -R^{a}-CO-R^{a'}-, -R^{a}-CO-O-R^{a'}-, -R^{a}-O-CO-O-R^{a'}-, -R^{a}-O-CO-R^{a'}-, -O-R^{a'}-, -R^{a}-CS-R^{a'}-, -R^{a}-CO-S-R^{a'}-, - R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}-, -R^{a}-S-, -R^{a}-SO-R^{a'}-, -SO-R^{a'}-, -R^{a}-SO-, -R^{a}-SO₂-R^{a'}-, -SO₂-R^{a'}-, oder -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{a"} und R^{a‴} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c}, - NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR¹, NR¹R¹', einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"} und R^{a‴} optional auch zu anellierten Ringsystemen führen können; und
wobei mindestens einer der Reste Q, Z, Y, Q', Z' und/oder Y` mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Optional können auch die beiden zweizähnigen Liganden EnD und E`nD` über eine Spacereinheit S (z.B. eine C₁₋₁₀-Alkylengruppe) miteinander verbunden sein, sodass sich ein vierzähniger Ligand ergibt.

Optional kann eine Verbesserung der Löslichkeit des Metall-Komplexes erreicht werden, indem mindestens einer der Liganden EnD und E`nD` einen entsprechenden Substituenten trägt.

Ein weiterer Aspekt der Erfindung betrifft ein Verfahren gemäß der vorliegenden Erfindung, bei dem ein Metall(I)-Komplex gebildet wird, der eine Struktur gemäß der folgenden Formel D aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in der europäischen Patentanmeldung Nr. EP14164815 gezeigt. 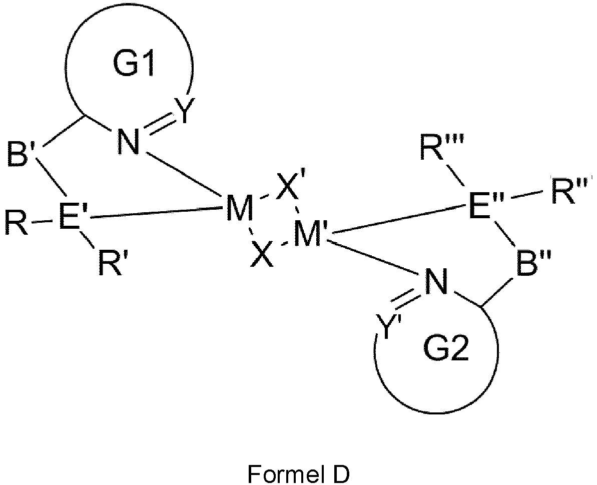
bei der M und M' unabhängig voneinander ausgewählt sind aus der Gruppe bestehend aus Cu, Ag und Au, insbesondere beide Cu sind;
bei der X und X' unabhängig von einander Halogenide, insbesondere ausgewählt aus der Gruppe bestehend aus Cl, Br, I, oder Pseudohalogenide sind;
bei der E' und E" unabhängig von einander ausgewählt sind aus der Gruppe bestehend aus P, As und Sb;
bei der R, R', R" und R‴ unabhängig von einander ausgewählt sind aus der Gruppe bestehend aus optional substituierten Alkyl-, Aryl-, Heteroaryl- und Alkoxyresten mit jeweils bis zu 20 Kohlenstoffatomen;
bei der N Stickstoff ist;
bei der Y und Y` der Ringsysteme G1 und G2 jeweils unabhängig von einander ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, =R^{a}-NR^{a"}-,=N-R^{a}-, =R^{a}-NR^{a"}-R^{a'}-, -R^{a}-SiR^{a"}R^{a‴}-R^{a'}-,-R^{a}-SiR^{a"}R^{a‴}-, =R^{a}-O-R^{a'}-, =R^{a}-CO-R^{a'}-, =R^{a}-CO-O-R^{a'}-, =R^{a}-O-CO-O-R^{a'}-, =R^{a}-O-CO-R^{a'}-, -O-R^{a'}-, =R^{a}-CS-R^{a'}-, =R^{a}-CO-S-R^{a'}-, =R^{a}-S-CO-R^{a'}-, =R^{a}-CO-NH-R^{a'}-, =R^{a}-NH-CO-R^{a'}-, =R^{a}-O-, =R^{a}-S-R^{a'}-, =R^{a}-S-, =R^{a}-SO-R^{a'}-, =R^{a}-SO-, =R^{a}-SO₂-R^{a'}- und =R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a‴} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c}, - NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"} und R^{a‴} optional auch zu anellierten Ringsystemen führen können;
bei der B und B' jeweils unabhängig von einander eine Überbrückung einer Kettenlänge von mindestens 2 und höchstens 17 Atomen sind,
wobei die Glieder aus -CH₂-, -CHR¹-, -CR¹R²-, -SiR¹R²-, -GeR¹R²-, -O-, -S-, -Se-, - NR¹-, -PR¹- and/oder -AsR¹- bestehen können,
wobei R¹ und R² jeweils unabhängig von einander ein Rest ausgewählt aus der Gruppe bestehend aus einem Alkyl-, Aryl-, Heteroarylrest, -OR³, -SR³, -SeR³, -H und -D mit jeweils bis zu 20 Kohlenstoffatomen sind,
wobei R³ ein Alkyl-, Aryl-, Heteroarylrest, mit jeweils bis zu 20 Kohlenstoffatomen , -H oder -D ist; und
wobei mindestens einer der Reste R-R‴ und/oder G1 und/oder G1 mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Bevorzugt sind die Ringsysteme G1 und G2 jeweils ein fünf- oder sechsgliedriges heteroaromatisches Ringsystem, welches optional mit weiteren Resten wie R, R`; R", R‴, R^{a"} und/oder R^{a‴} substituiert oder mit weiteren aromatischen Ringen anelliert sein kann.

Ein weiterer Aspekt der Erfindung betrifft ein Verfahren gemäß der vorliegenden Erfindung, bei dem ein Metall(I)-Komplex gebildet wird, der eine Struktur gemäß der folgenden Formel E aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/014066 (siehe beispielsweise Formel IV hieraus) gezeigt. 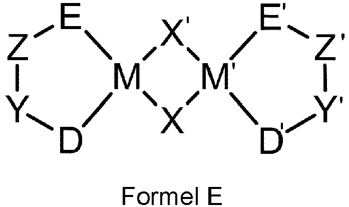
bei der M und M' unabhängig voneinander ausgewählt sind aus der Gruppe bestehend aus Cu, Ag und Au, insbesondere beide Cu sind;
bei der X und X' unabhängig von ausgewählt sind aus der Gruppe bestehend aus Cl, Br, I, CN, OCN, SCN, C₁₋₁₀-Alkinyl und Azid.
bei der die E, Y, Z und D umfassenden Liganden (E∩D) und die bei der die E', Y`, Z' und D' umfassenden Liganden (E'nD') jeweils ein zweizähniger Ligand sind;
wobei E und E' unabhängig voneinander jeweils entweder RR'E* ist, wobei E* für N, P, As oder Sb steht, wobei N ein Imin-Stickstoffatom oder Teil eines N-heteroaromatischen Rings ist oder nicht ist, oder E und E' unabhängig voneinander jeweils RE* sind, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹, - NR¹R¹', -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1"} und R und R' optional auch zu anellierten Ringsystemen führen können;
wobei D und D' unabhängig voneinander jeweils entweder R"R‴D* ist, wobei D* für N, P, As oder Sb steht, wobei N ein Imin-Stickstoffatom oder Teil eines N-heteroaromatischen Rings ist oder nicht ist, oder D und D' unabhängig voneinander jeweils R"D* ist, wobei D* für ein divalentes Carben C*, O oder S steht,
wobei R" und R‴ jeweils unabhängig voneinander ausgewählt ist aus der Gruppe bestehend aus Wasserstoff, Halogen, Deuterium, -R², -OC(O)R², -COOH, -OR², - NR²R^{2'}, -SiR²R^{2'}R^{2"} -SR², -SOR², -SO₂R² und weiteren Donor- und Akzeptor-Gruppen, wie beispielsweise Carboxylaten und deren Estern und CF₃-Gruppen,
wobei R², R^{2'} und R^{2"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R², R^{2'}, R^{2"} und R" und R‴ optional auch zu anellierten Ringsystemen führen können;
wobei D und E verschieden voneinander oder gleichartig sind;
wobei Y, Z, Y` und Z` unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a‴}-R^{a'}-, -R^{a}-NR^{a"}-R^{a'}-, -R^{a}-SiR^{a"}R^{a‴}-R^{a'}-, -R^{a}-SiR^{a"}R^{a‴}-, -SiR^{a"}R^{a‴}-R^{a}-, -R^{a}-O-R^{a'}-, -R^{a}-CO-R^{a'}-, -R^{a}-CO-O-R^{a'}-, -R^{a}-O-CO-O-R^{a'}-, -R^{a}-O-CO-R^{a'}-, -O-R^{a'}, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-CO-NR^{x}-R^{a'}-, -R^{a}-NR^{x}-CO-R^{a'}-, -R^{a}-O-, -R^{a}-S-R^{a'}-, -S-R^{a'}, -R^{a}-S-, -R^{a}-SO-R^{a'}-, -SO-R^{a'}, -R^{a}-SO-, -R^{a}-SO₂-R^{a'}-, -SO₂-R^{a'} oder -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest, der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander und/oder mit dem Rest D optional eine zyklisierte und/oder anellierte Struktur ausbilden können,
wobei R^{a"} und R^{a‴} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c}, - NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"}, R^{a‴} optional auch zu anellierten Ringsystemen führen können; und
wobei mindestens einer der Reste Z, Y, Y` oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Optional können auch die beiden zweizähnigen Liganden EnD und E`nD` über eine Spacereinheit S (z.B. eine C₁₋₁₀-Alkylengruppe) miteinander verbunden sein, sodass sich ein vierzähniger Ligand ergibt.

Optional kann eine Verbesserung der Löslichkeit des Metall-Komplexes erreicht werden, indem mindestens einer der Liganden EnD und E`nD` einen entsprechenden Substituenten trägt.

Ein weiterer Aspekt der Erfindung betrifft ein Verfahren gemäß der vorliegenden Erfindung, bei dem ein Metall(I)-Komplex gebildet wird, der eine Struktur gemäß der folgenden Formel F aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/017675 (siehe beispielsweise Formel A hieraus) gezeigt. 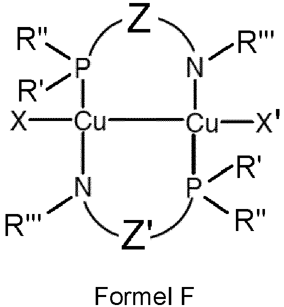
bei der X und X' jeweils unabhängig von einander ausgewählt sind aus der Gruppe bestehend aus Cl, Br, I, CN, OCN, SCN, C₁₋₁₀-Alkinyl und Azid;
bei der Z und Z' unabhängig von einander eine kovalente Verbrückung, die mindestens zwei Kohlenstoff- und/oder Stickstoffatome umfasst darstellen,
wobei P Phosphor und N Stickstoff ist;
bei der der P, Z und N umfassende Ligand (P∩N) und der P, Z` und N umfassende Ligand (PoN') jeweils ein mit einem N-Heterozyklus substituierter Phosphanligand ist, der eine Struktur gemäß Formel G aufweist: 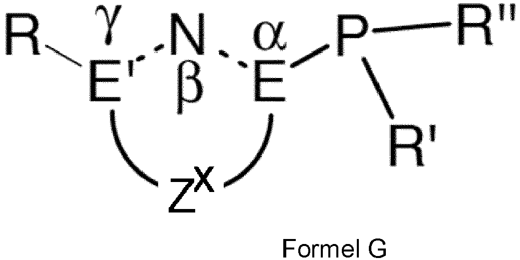
wobei P Phosphor und N Stickstoff ist;
wobei E ein Kohlenstoff- oder Stickstoffatom ist;
wobei E' ein Kohlenstoff- oder Stickstoffatom ist, das nicht an ein Wasserstoffatom gebunden ist;
wobei die gestrichelte Bindung eine Einfach- oder Doppelbindung ist;
wobei R ein optional substituierter, optional verzweigter C₁₋₂₀-Alkyl-Rest, bevorzugt ein C₆₋₂₀-Alkyl-Rest oder ein optional alkylierter C₆₋₂₀-Aryl-Rest, insbesondere Phenyl, ist, wobei eine Substitution hierbei eine Substitution mit einem oder mehreren Halogenen (z.B. F, Cl, Br und/oder I), Silangruppen, Ethergruppen oder optional ihrerseits substituierten Alkyl-, Alkenyl- und/oder Alkinyl-Gruppen sein kann;
bei der R' und R" unabhängig von einander ausgewählt sind aus der Gruppe bestehend aus Alkyl-Gruppen, bevorzugt C₆₋₂₀-Alkyl-Gruppen, sind, die auch verzweigt oder cyclisch sein können, oder
Aryl- oder Heteroarylgruppen, die optional mit Alkyl-Gruppen, Halogenen (z.B., F, Cl, Br und/oder I), Silangruppen oder Ethergruppen substituiert sein können,
wobei R' und R" jeweils direkt an dem Phosphoratom des Phosphan-Liganden gebunden sind;
bei der R‴ ausgewählt ist aus der Gruppe bestehend aus Alkyl-Gruppen, bevorzugt C₆₋₂₀-Alkyl-Gruppen, sind, die auch verzweigt oder cyclisch sein können, oder Aryl- oder Heteroarylgruppen, die optional mit Alkyl-Gruppen, Halogenen (z.B., F, Cl, Br und/oder I), Silangruppen oder Ethergruppen substituiert sein können,
wobei R‴ mit Z auch ein Ringsystem ausbinden kann, daher einen aliphatischen oder aromatischen Heterozyklus,
wobei Z, Z` und Z^{x} unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a‴}-R^{a'}-, -R^{a}-NR^{a"}-R^{a'}--R^{a}-SiR^{a"}R^{a‴}-R^{a'}-, -R^{a}-SiR^{a"}R^{a‴}-, -SiR^{a"}R^{a‴}-R^{a}-, -R^{a}-O-R^{a'}-, -R^{a}-CO-R^{a'}-, -R^{a}-CO-O-R^{a'}-, -R^{a}-O-CO-O-R^{a'}-, -R^{a}-O-CO-R^{a'}-, -O-R^{a'}-, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}, -R^{a}-S-, -R^{a}-SO-R^{a'}-, -SO-R^{a'}-, -R^{a}-SO-, -R^{a}-SO₂-R^{a'}-, , -R^{a}-CO-NR^{a"}-R^{a'}-, -R^{a}-NR^{a"}-CO-R^{a'}-,-SO₂-R^{a'} und -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a‴} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c}, - NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"} und R^{a‴} optional auch zu anellierten Ringsystemen führen können; und
wobei mindestens einer der Reste Z oder Z' mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.

Ein weiterer Aspekt der Erfindung betrifft ein Verfahren gemäß der vorliegenden Erfindung, bei dem ein Cu(I)-Komplex gebildet wird, der eine Struktur gemäß der folgenden Formel H aufweist und in Analogie zu den oben beschriebenen Komplexen, in einer lichtemittierenden Schicht S, in einer opto-elektronischen Vorrichtung und einem Verfahren zur Erzeugung von Licht wie hierin beschrieben verwendet werden kann. Beispiele für derartige Komplexe sind auch in WO 2013/072508 (siehe beispielsweise Formel A hieraus), WO 2010/149748 (siehe beispielsweise Formel A hieraus) und WO 2013/001086 (siehe beispielsweise Formel A hieraus) gezeigt. 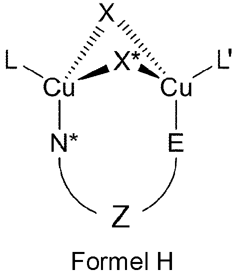
bei der X und X* jeweils unabhängig von einender ausgewählt sind aus der Gruppe bestehend aus Cl, Br, I, CN, OCN, SCN, C₁₋₁₀-Alkinyl und Azid;
bei der N* ein Stickstoffatom, das mit Cu eine Bindung eingeht ist;
wobei E RR'E* ist, wobei E* für N, P, As oder Sb steht, wobei N ein Imin-Stickstoffatom oder Teil eines N-heteroaromatischen Rings ist oder nicht ist, oder E RE* ist, wobei E* für ein divalentes Carben C*, O oder S steht,
wobei R und R' jeweils unabhängig voneinander ausgewählt ist aus der Gruppe bestehend aus Wasserstoff, Halogen, Deuterium, -R¹, -OC(O)R¹, -COOH, -OR¹, - NR¹R¹', -SiR¹R^{1'}R^{1"} -SR¹, -SOR¹, -SO₂R¹ und weiteren Donor- und Akzeptor-Gruppen, wie beispielsweise Carboxylaten und deren Estern und CF₃-Gruppen,
wobei R¹, R^{1'} und R^{1"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei der/die Reste R¹, R^{1'}, R^{1"} und R und R' optional auch zu anellierten Ringsystemen führen können;
bei der Z eine kovalente Verbrückung, die mindestens zwei Kohlenstoff- und/oder Stickstoffatome umfasst, ist;
bei der die Liganden L und L' unabhängig voneinander jeweils ein beliebiger organischer Ligand mit 1 bis 20 Kohlenstoffatomen sind, die bevorzugt eine oder mehrere Gruppen enthalten, ausgewählt aus der Gruppe bestehend aus - OC(O)R^{c}, -COOH, -OR^{c}, -NR^{c}R^{c}', -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern, CF₃-Gruppen, phosphor-, arsen- oder antimonhaltige Gruppen,
wobei R^{c}, R^{c'} und R^{c"} unabhängig von einander ausgewählt sind aus der Gruppe bestehend aus H, OH, NH₂, NHR^{a"}, NR^{a"}R^{a‴}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrestund einem C₇₋₃₂-Heteroalkylarylalkylrest,
wobei die Reste R^{c}, R^{c'}, R^{c"}, R^{d}, R^{d'}, R^{d"} und R^{d‴} optional auch zu anellierten Ringsystemen führen können, wobei L und L' auch miteinander verbunden und wie oben bei Formel A beschrieben definiert sein können oder wie unten stehend gemäß Formel K definiert sein können;
bei der der N*, Z und E umfassende Ligand (E∩N*) ein zweizähniger Ligand gemäß der Struktur nach Formel K sein kann: 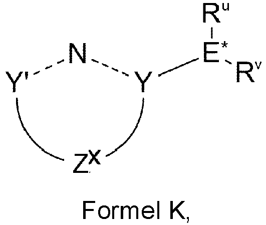
bei der Y ein Kohlenstoff- oder Stickstoffatom ist;
bei der Y' ein Kohlenstoff- oder Stickstoffatom ist, das mit einem Wasserstoffatom substituiert ist;
bei der E* ausgewählt ist aus der Gruppe bestehend aus P, N, As, Sb, einem divalenten Carben C*, O und S;
wobei die gestrichelte Bindung eine Einfach- oder Doppelbindung ist;
bei der N ein Stickstoffatom, das in eine Imin-Gruppe eingebunden ist darstellt, die Bestandteil einer heteroaromatischen Gruppe umfassend N, Y, Y'und Z^{x} darstellt,
wobei die heteroaromatische Gruppe bevorzugt ausgewählt ist aus der Gruppe bestehend aus Pyridyl, Pyrimidyl, Pyridazinyl, Triazinyl, Oxazolyl, Thiazolyl, Imidazolyl, die optional substituiert sein können (beispielsweise mit einem oder mehrerer der Substituenten der vorstehend genannten Gruppe) und/oder mit anderen Gruppen des Komplexes anelliert sein können,
bei der R^{u} und R^{v} unabhängig von einander ausgewählt sind aus der Gruppe bestehend aus Alkyl-Gruppen, bevorzugt C₆₋₂₀-Alkyl-Gruppen, sind, die auch verzweigt oder cyclisch sein können, oder Aryl- oder Heteroarylgruppen, die optional mit Alkyl-Gruppen, Halogenen (z.B., F, Cl, Br und/oder I), Silan- oder Ethergruppen substituiert sein können;
bei der Z und Z^{x} unabhängig von einander jeweils ausgewählt sind aus der Gruppe bestehend aus einem substituierten oder unsubstituierten C₁₋₉-Alkylen-, C₂₋₈-Alkenylen-, C₂₋₈-Alkinylen- oder Arylenrest, -R^{a}-NR^{a"}-, -NR^{a"}-R^{a}-, -R^{a}-NR^{a"}-R^{a'}-, -R^{a}-SiR^{a"}R^{a‴}-R^{a'}-, -R^{a}-SIR^{a"}R^{a‴}-, -SiR^{a"}R^{a‴}-R^{a}-, -R^{a}-O-R^{a'}-, -R^{a}-CO-R^{a'}-, -R^{a}-CO-O-R^{a'}-, -R^{a}-O-CO-O-R^{a'}-, -R^{a}-O-CO-R^{a'}-, -O-R^{a'}-, -R^{a}-CS-R^{a'}-, -R^{a}-CO-S-R^{a'}-, -R^{a}-S-CO-R^{a'}-, -R^{a}-CO-NH-R^{a'}-, -R^{a}-NH-CO-R^{a'}-, -R^{a}-O-, -R^{a}-S-R^{a'}-, -S-R^{a'}-, -R^{a}-S-, - R^{a}-SO-R^{a'}-, -SO-R^{a'}-, -R^{a}-SO-, -R^{a}-SO₂-R^{a'}-, -SO₂-R^{a'}- und -R^{a}-SO₂- ist,
wobei R^{a} und R^{a'} unabhängig voneinander jeweils ein Rest mit bis zu 20 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können,
wobei R^{a"} und R^{a‴} unabhängig voneinander jeweils ein Rest mit bis zu 20 Kohlenstoffatomen sind, unabhängig voneinander ausgewählt aus der Gruppe bestehend aus Wasserstoff, Deuterium, Halogen, -R^{c}, -OC(O)R^{c}, -COOH, -OR^{c}, - NR^{c}R^{c'}, -SiR^{c}R^{c'}R^{c"} -SR^{c}, -SOR^{c}, -SO₂R^{c} und weiteren Donor- und Akzeptor-Gruppen, wie beispielsweise Carboxylaten und deren Estern und CF₃-Gruppen,
wobei R^{c}, R^{c'} und R^{c"} unabhängig von einander ausgewählt sind aus der Gruppe bestehend aus H, OH, NH₂, NHR^{x}, NR^{x}R^{y}, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei R^{x} und R^{y} unabhängig von einander ausgewählt sind aus der Gruppe bestehend aus einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei die Reste R^{c}, R^{c'}, R^{c"}, R^{a}, R^{a'}, R^{a"} und R^{a‴} optional auch zu anellierten Ringsystemen führen können; und
wobei mindestens einer der Reste Z (bzw. Z^{x}) mit mindestens einer nicht-komplexierten ionischen Gruppe substituiert ist, bevorzugt mit einer Ammoniumgruppe, einer Carboxylgruppe, einer Sulfonatgruppe, einer Phosphonatgruppe, insbesondere mit -SO₃⁻ substituiert ist.
wobei die heteroaromatische Gruppe bevorzugt ausgewählt ist aus der Gruppe bestehend aus Pyridyl, Pyrimidyl, Pyridazinyl, Triazinyl, Oxazolyl, Thiazolyl, Imidazolyl, die optional substituiert sein können (beispielsweise mit einem oder mehrerer der Substituenten der vorstehend genannten Gruppe) und/oder mit anderen Gruppen des Komplexes anelliert sein können,
Bevorzugt handelt es sich bei den Liganden L und L` gemäß Formel H um einzähnige Liganden mit bis zu 42 Kohlenstoffatomen.

Die nachfolgend dargestellten Figuren und Ausführungsbeispiele und Patentansprüche dienen der näheren Darstellung und Erläuterung der Erfindung, wobei der Erfindungsgegenstand durch die Ansprüche definiert ist.

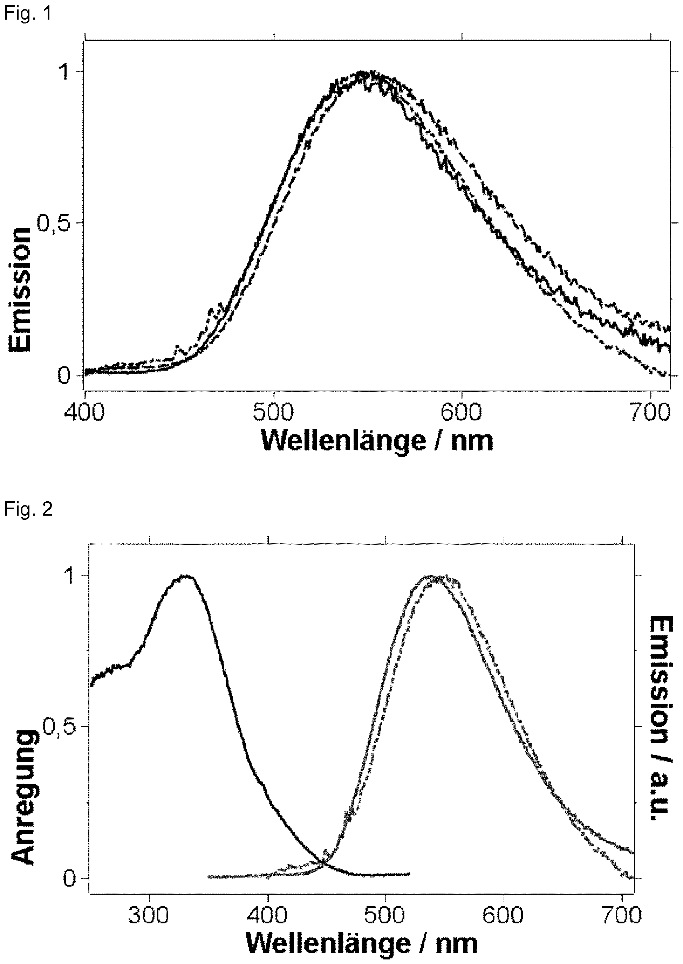

**Figur 1** stellt das Emissionsspektrum (Emission als Funktion der Wellenlänge) von lichtemittierenden Schichten S aus Metall-Komplexen MK1 dar, die unterschiedlich hergestellt wurden:

| | |
|---|---|
| durchgezogene Linie: | Herstellung von MK1 durch Bulksynthese, daher klassischer Synthese im Reaktionsgefäß in Lösung mit anschließender Aufreinigung; |
| gestrichelte Linie: | auf der Oberfläche *in situ* hergestellter MK1 mit M:L-molarem Verhältnis M:L von 2:3, daher vollständiger Komplexierung; |
| gepunktete Linie: | auf der Oberfläche *in situ* hergestellter MK1 mit M:L-molarem Verhältnis M:L von 2,1:3, daher 5 %-iger Überschuss an Metallsalz. |

Als Anregungswellenlänge wurde Licht mit einer Wellenlänge von 350 nm verwendet.

**Figur 2** stellt das Anregungs- und das Emissionsspektrum des Metall-Komplexes MK2 (durchgezogene Linie) und das Emissionsspektrum des Metall-Komplexes MK1 (gestrichelte Linie) dar.

### Beispiel 1

### Komplexierung von M und L auf einer Oberfläche

Das Konzept des Aufbringens von getrennten Zusammensetzungen Z1 und Z2 auf eine Oberfläche eines Bauteils T wird beispielhaft an der Bildung eines Cu(I)-Komplexes aus Kupferiodid (Cul) als Salz des Metalls M und 4-Methyl-2-(diphenylphosphino)-pyridin (MePyrPHOS) als Ligand L1 gezeigt. Daraus ergibt sich nach folgendem Komplexierungsschema der Metall-Komplex MK1:

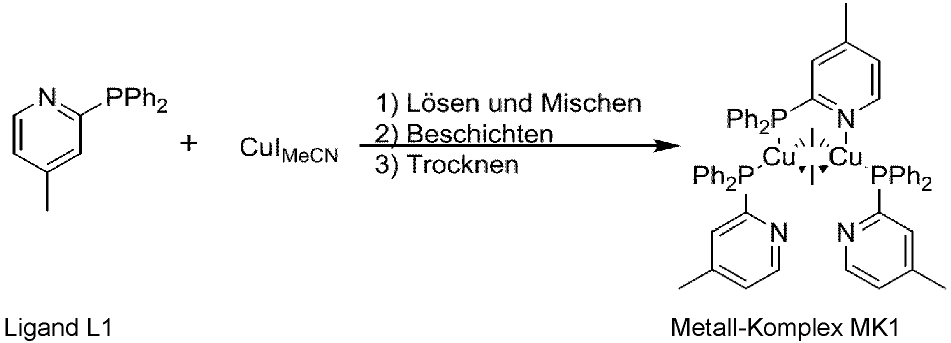

Die Synthese des Liganden L1 erfolgt analog zu WO 2013/007710. Ferner kann der Syntheseweg analog auch WO 2013/072508 und WO 2013/007709 entnommen werden.

Es entsteht demnach ein Cu₂L₃-Komplex bestehend aus zwei Cu(I) und drei Liganden. Damit das gesamte Cu(l) und der gesamte Ligand L vollständig komplexiert werden, und weder nicht-komplexiertes Metall M noch nichtkomplexierter Ligand L vorliegen, muss demnach das molare Verhältnis M:L von 2:3 gewählt werden.

Zur Bildung des Metall-Komplexes MK1 wurden eine 0,066 molare Lösung von Cul in Acetonitril (Zusammensetzung Z1) sowie eine 0,066 molare Lösung von Ligand L1 in Toluol (Zusammensetzung Z2) gemischt, so dass das molare Verhältnis M:L von 2:3 erreicht wurde.

Das Emissionsspektrum einer lichtemittierenden Schicht S, die aus einem auf diese Weise auf der Oberfläche *in situ* hergestellten Metall-Komplex MK1 bestand, wurde mit einer solchen verglichen, die aus einem durch Bulksynthese (klassischer Synthese im Reaktionsgefäß in Lösung) synthetisierten und aufgereinigten Metall-Komplexes MK1 bestand (Fig. 1). Es zeigten sich nahezu identische Spektren, was zeigt, dass die Metall-Komplexe MK1 gleichartig ausgebildet wurden.

Nach dreitägiger Standzeit bei Raumtemperatur zeigte sich keine optische Veränderung.

### Beispiel 2

Komplexierung von M und L mit einem Überschuss an Metallsalz auf einer Oberfläche

Es wurde wie oben in Beispiel 1 beschrieben verfahren, mit dem Unterschied, dass zur Bildung des Metall-Komplexes MK1 das molare Verhältnis M:L von 2,1:3 eingesetzt wurde.

Das Emissionsspektrum einer lichtemittierenden Schicht S, die aus einem auf diese Weise auf der Oberfläche *in situ* hergestellten Metall-Komplex MK1 bestand, wurde mit einer solchen verglichen, die aus einem durch Bulksynthese (klassischer Synthese im Reaktionsgefäß in Lösung) synthetisierten und aufgereinigten Metall-Komplexes MK1 bestand (Fig. 1). Es zeigten sich nahezu identische Spektren, was nachweist, dass die Metall-Komplexe MK1 gleichartig ausgebildet wurden.

Auch bei Einsatz eines Überschusses an Metallsalz wurde der gewünschte Metall-Komplexe MK1 gebildet, wobei das nicht koordinierte Kupferiodid vermutlich als nicht lumineszierende Spezies [CuI(MeCN)ₙ] in der lichtemittierenden Schicht S vorliegt.

Nach zweistündigem Lagern einer angemischten Lösung mit Cul-Überschuss bildete sich eine geringe Menge eines unlöslichen, lumineszierenden Niederschlages. Dieser konnte durch Elementaranalyse als [Cu₄I₄(MePyrPHOS)₂] identifiziert wer-den.

### Beispiel 3

Prozessierung eines schwerlöslichen Metall-Komplexes auf einer Oberfläche

Durch Mischung von Kupferiodid mit den Liganden 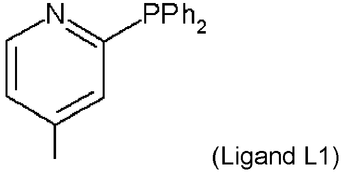 und

PPh3 (Ligand L2) wurde der Metall-Komplex MK2 einer Struktur der Formel 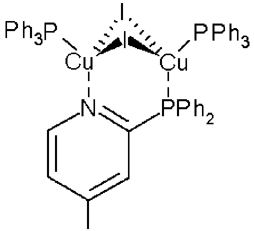 gebildet, der im Pulver vorteilhafte Eigenschaften aufwies: Die Quanteneffizienz liegt bei nahezu 100%, die Emissionsabklingdauer knapp unter 1 µs. Aufgrund seiner Unlöslichkeit in konventionellen Prozessierungs-Lösungsmitteln wie Toluol konnte er als Bulkmaterial jedoch nicht erfolgreich zur Herstellung von OLED-Bauteilen verwendet werden.

Durch das Aufbringen von voneinander getrennten Zusammensetzungen Z1 (enthaltend Cul) und Z2 (enthaltend den Liganden) konnte jedoch eine dünne lichtemittierende Schicht S aus dem Komplex hergestellt werden. Dabei wurde, analog zu Beispiel 1 das Kupferiodid in Acetonitril und die Liganden in Toluol gelöst eingesetzt und die Stöchiometrie durch die Volumina auf vollständige Komplexierung eingestellt. Es wurde jeweils eine Konzentration von 0,066 M verwendet und durch Erhitzen auf 60 °C für 45 min getrocknet. Die Emissions- und Anregungsspektren sind in Figur 2 und die Quanteneffizienzen der lichtemittierenden Schichten S in Tabelle 1 dargelegt.

**Tabelle 1. Wellenlänge des Emissionsmmaximum λ und Quantenausbeute φ der lichtemittierenden Schichten S aus MK1 und MK2**

| Metall-Komplex in der lichtemittierenden Schicht S | λ [nm] | φ |
|---|---|---|
| MK1 | 556 | 0.41 |
| MK2 | 540 | 0.97 |

Demnach wird für sowohl für den heteroleptischen als auch den homoleptischen Komplex ein Emissionsmaximum nahe bei 550 nm erreicht. Die Quanteneffizienz ist - analog zu den Pulverproben - für den heteroleptischen Komplex deutlich höher.

### Beispiel 4

### Screening von Metall-Komplexen durch Bildung auf Oberflächen

Verschiedenartige Kupfer-Komplexe und Liganden wurden direkt auf der Oberfläche, ohne vorherige Darstellung eines Bulkmaterials, hergestellt. Dabei wurde die Variation des HOMOs durch die Wahl des Kupferhalogenides sowie die Variation des LUMOs durch die Wahl des N-Donors evaluiert. Die Komplexe wurden analog zu Beispiel 1 hergestellt, wobei jedoch auch die Liganden in Acetonitril gelöst eingesetzt wurden und die Trocknung bei 50 °C für 10 min durchgeführt wurde. Die Konzentration aller Reaktanden wurde aufgrund der schlechten Löslichkeit einiger der verwendeten Kupfersalze selbst in Acetonitril auf 0,01 M reduziert.

Die Ergebnisse für verschiedene Kupfersalze sind in Tabelle 2 zusammengefasst.

**Tabelle 2. Einfluss des verwendeten Kupfersalzes auf die photophysikalischen Eigenschaften der Kupfer-Komplexe hergestellt auf der Oberfläche**

| Metall-Komplex | Metallsalz | erster Ligand (N-Donor) | zweiter Ligand (N-Donor) | Emissionsmaximum λ [nm] | PLQY Φ |
|---|---|---|---|---|---|
| MK3 | CuCl | 4-tBu-Pyridin | PPh₃ | 494 | 0,47 |
| MK4 | CuBr | 4-tBu-Pyridin | PPh₃ | 475 | 0,69 |
| MK5 | Cul | 4-tBu-Pyridin | PPh₃ | 434 | 0,18 |
| MK6 | CuSCN | 4-tBu-Pyridin | PPh₃ | 477 | 0,29 |

Die Emissionsfarbe verschiebt sich von Cl über Br nach I ins Blaue. Besonders interessant ist dabei die Emissionswellenlänge des Cul-Komplexes MK5, die mit 434 nm bei Tiefblau liegt. Die Quanteneffizienz folgt keinem einfachen Trend, der CuBr-Komplex verfügt über eine deutlich höhere Quanteneffizienz als der entsprechende Cul-Komplex. Der CuSCN-Komplex nimmt eine Mittelstellung zwischen CuCI- und CuBr-basierten Komplexen ein.

Zur Beeinflussung der LUMO-Energie der Komplexe MK3-MK6 wurden verschiedene Pyridin-Derivate als Liganden eingesetzt:

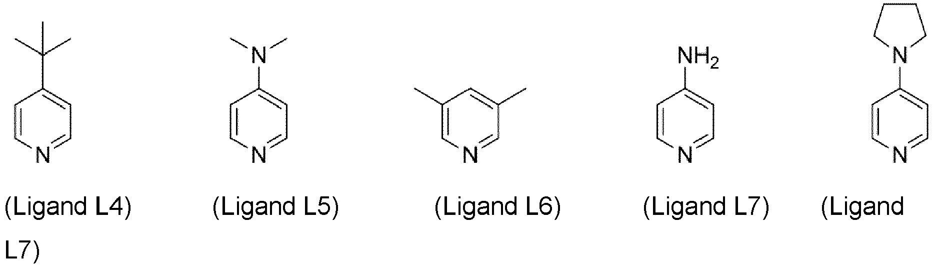

In Tabelle 3 sind die Emissionseigenschaften der erhaltenen Filme dargestellt. Ziel der Optimierung war es dabei, die Emissionsfarbe ins blaue zu verschieben, weshalb vor allem elektronenreiche Pyridine verwendet wurden. Aufgrund der zu erwarteten höheren Quanteneffizienz wurde Bromid als Gegenion gewählt.

**Tabelle 3. Einfluss des verwendeten Pyridin-Derivates auf die photophysikalischen Eigenschaften der Metall-Komplexe hergestellt auf der Oberfläche**

| Metall-Komplex | Metallsalz | erster Ligand (N-Donor) | zweiter Ligand (N-Donor) | Emissionsmaximum λ [nm] | PLQY Φ |
|---|---|---|---|---|---|
| MK4 | CuBr | 4-tBu-Pyridin | PPh3 | 475 | 0,69 |
| MK7 | CuBr | 3,5-Dimethyl-Pyridin | PPh3 | 470 | 0,66 |
| MK8 | CuBr | 4-NH2-Pyridin | PPh3 | 460 | 0,05 |
| MK9 | CuBr | 4-NMe2-Pyridin | PPh3 | 466 | 0,29 |
| MK10 | CuBr | 4-(N-Pyrolidino)-Pyridin | PPh3 | 490 | 0,48 |

Es gelang dabei, das Maximum der Emissionsbande ausgehend von dem ursprünglichen Metall-Komplex MK4 von 475 nm auf 460 nm zu verschieben, indem NH₂ als Substituent eingeführt wurde (MK8). Vermutlich infolge von intermolekularen Wasserstoffbrückenbindungen und Schwingungsquenching war die erzielte Quanteneffizienz mit 5% jedoch zu gering um eine Verwendung in einem effizienten OLED-Bauteil zu gestatten. Durch eine Alkylsubstituion am Stickstoff (MK9 und MK10) stieg zwar die Quantenffizienz signifikant an, es wurde jedoch zugleich ein bathochromer Shift der Emissionsfarbe bewirkt: Obschon die Basizität der Pyridinderivate ansteigt, sinkt durch die alkylischen Substituenten am Amin-Stickstoff die LUMO-Energie des freien Liganden ab. Die bloße Verschiebung des alkylischen Substitutionsmusters (vgl. MK4 vs. MK7) führte zu keiner nennenswerten Beeinflussung. Aminhaltige Substituenten sind aus einem weiteren Grund kein günstiges Werkzeug für die Manipulation der Emissionsfarbe:

Die Oxidationsempfindlichkeit der gelösten Komplexe ist deutlich höher als bei Amin-freien Komplexen. Bei Luftkontakt degradierten die Lösungen binnen Minuten nach Zusammengeben von Kupfersalz mit den Liganden, was durch dunkelgrüne Verfär-bungen mit dem bloßen Auge zu beobachten war. Die Zersetzung verlief dabei vermutlich durch Oxidation mit Luftsauerstoff. In Lösung destabilisieren die elektronenreichen Pyridine durch Koordination über den Amin-Stickstoff Cu(I) und begünstigen die Oxidation zu Cu(II) (HSAB-Konzept). Zusammengefasst konnte gezeigt werden, dass mithilfe der Herstellung der Metall-Komplexe direkt auf der Oberfläche *in situ* eine Untersuchung von photophysikalischen Eigenschaften auch ohne die Herstellung von Bulkmaterialien möglich ist.

### Beispiel 5

### Bildung besonders bevorzugter Metall-Komplexe

Besonders bevorzugt ist ein durch das Verfahren gebildeter Metall-Komplex ein Cu(I)-Komplex, der eine der der folgenden Strukturen (I) bis (VII) aufweist: 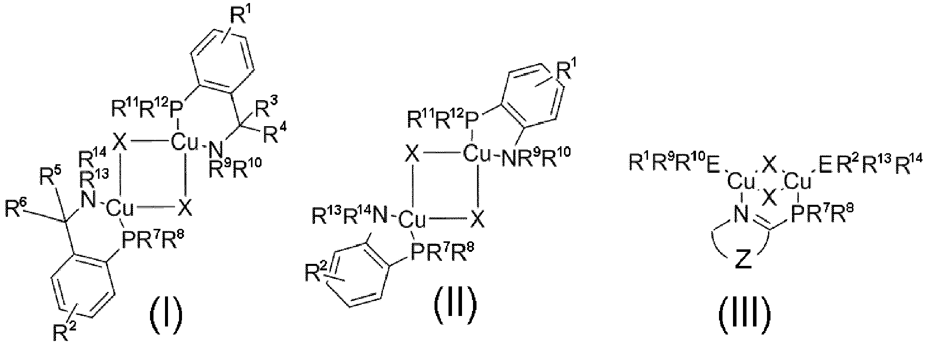 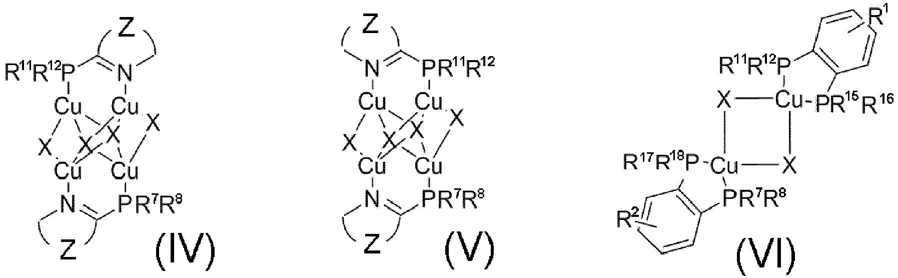 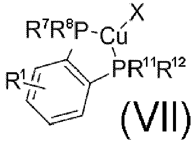
wobei X ausgewählt ist aus der Gruppe bestehend aus Halogenid (bevorzugt I, Br oder Cl), CN, SCN, OCN, SPh und einem Acetylid (bevorzugt einem Phenylacetylid), insbesondere wobei X ein Halogenid ist;
wobei die Reste R¹, R², R³, R⁴, R⁵, R⁶, R⁷, R⁸, R⁹, R¹⁰, R¹¹, R¹², R¹³, R¹⁴, R¹⁵, R¹⁶, R¹⁷ und R¹⁸ unabhängig voneinander jeweils ein Rest mit bis zu 40 Kohlenstoffatomen sind, bevorzugt solche unabhängig voneinander ausgewählt aus der Gruppe bestehend aus -R^{t‴}, -OC(O)R^{t‴}, -COOH, -OR^{t‴}, -NR^{t‴}R^{tʺʺ},-SiR^{t‴}R^{tʺʺ}R^{tʺ‴}, -GeR^{t‴}R^{tʺʺ}R^{tʺ‴} -SR^{t‴}, -SOR^{t‴}, -SO₂R^{t‴} und weiteren Donor- und Akzeptor-Gruppen, wie beispielsweise Carboxylaten und deren Estern und CF₃-Gruppen,
wobei R^{t‴}, R^{tʺʺ} und R^{tʺ‴} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest,
wobei auch zwei oder mehr der Reste miteinander substituierte oder unsubsttuierte Ringsysteme bilden können;
wobei E jeweils N, P, As oder Sb darstellt; und
wobei Z eine beliebige divalente Gruppe ist, bevorzugt eine solche ausgewählt aus der Gruppe bestehend aus -R^{ub}- -R^{ub}-NR^{ub"}-, -NR^{ub"}-R^{ub}-, -R^{ub}-NR^{ub"}-R^{ub'}-, - R^{ub}-SiR^{ub"}R^{ub‴}-R^{ub'}-, -R^{ub}-SiR^{ub"}R^{ub‴}-, -SiR^{ub"}R^{ub‴}-R^{ub}-, -R^{ub}-GeR^{ub"}R^{ub‴}-R^{ub'}-, -R^{ub}-GeR^{ub"}R^{ub‴}-, -GeR^{ub"}R^{ub‴}-R^{ub}-, -R^{ub}-O-R^{ub'}-, -R^{ub}-CO-R^{ub'}-, -R^{ub}-CO-O-R^{ub'}-, -R^{ub}-O-CO-O-R^{ub'}-, -R^{ub}-O-CO-R^{ub'}-, -O-R^{ub'}, -R^{ub}-CS-R^{ub'}-, -R^{ub}-CO-S-R^{ub'}-, -R^{ub}-S-CO-R^{ub'}-, -R^{ub}-CO-NH-R^{ub'}-, -R^{ub}-NH-CO-R^{ub'}-, -R^{ub}-CO-NR^{v‴}-R^{ub'}-, -R^{ub}-NR^{v‴}-CO-R^{ub'}-, -R^{ub}-O-, -R^{ub}-S-R^{ub'}-, -S-R^{ub'}, -R^{ub}-S-, -R^{ub}-SO-R^{ub'}-, -SO-R^{ub'}, -R^{ub}-SO-, -R^{ub}-SO₂-R^{ub'}-, -SO₂-R^{ub'} oder -R^{ub}-SO₂- ist oder Z fehlt und somit keine Bindung zwischen L und L' vorliegt,
wobei R^{ub} und R^{ub'} unabhängig voneinander jeweils ein Rest mit bis zu 40 Kohlenstoffatomen sind, ausgewählt aus der Gruppe bestehend aus einem linearen, verzweigten oder zyklischen Alkylenrest, einem linearen, verzweigten oder zyklischen Heteroalkylenrest, einem Arylenrest, einem Heteroarylenrest, einem linearen, verzweigten oder zyklischen Alkenylenrest und einem linearen, verzweigten oder zyklischen Alkinylenrest,
der jeweils optional mit einem oder mehreren der Substituenten ausgewählt aus der Gruppe bestehend aus Halogenen, Deuterium, linearen, verzweigten oder zyklischen Alkylresten, linearen, verzweigten oder zyklischen Heteroalkylresten, Arylresten, Heteroarylresten, linearen, verzweigten oder zyklischen Alkenylresten, linearen, verzweigten oder zyklischen Alkinylresten und anderen Donor- und Akzeptor-Gruppen wie beispielsweise Aminen, Phosphinen, Carboxylaten und deren Estern und CF₃-Gruppen, substituiert sein kann, wobei die Substituenten miteinander optional eine zyklisierte und/oder anellierte Struktur ausbilden können, wobei R^{ub"} und R^{ub‴} unabhängig voneinander jeweils ein Rest mit bis zu 40 Kohlenstoffatomen sind, unabhängig voneinander ausgewählt aus der Gruppe bestehend aus Wasserstoff, Halogen, -R^{t‴}, -OC(O)R^{t‴}, -COOH, -OR^{t‴}, -NR^{t‴}R^{tʺʺ},-SiR^{t‴}R^{t""}R^{t"‴}, -GeR^{t‴}R^{tʺʺ}R^{t"‴} -SR^{t‴}, -SOR^{t‴}, -SO₂R^{t‴} und weiteren Donor- und Akzeptor-Gruppen, wie beispielsweise Carboxylaten und deren Estern und CF₃-Gruppen,
wobei R^{t‴}, R^{tʺʺ} und R^{t"‴} unabhängig von einander ausgewählt sind aus der Gruppe bestehend aus H, OH, NH₂, einem Halogen, einem substituierten oder unsubstituierten, linearen, verzweigten oder zyklischen C₁₋₂₀-Alkyl-, C₁₋₂₀-Heteroalkyl-, C₂₋₂₀-Alkenyl-, C₁₋₁₀-Heteroalkenylrest und einem substituierten oder unsubstituierten C₆₋₂₀-Aryl-, C₅₋₂₀-Heteroaryl-, C₇₋₃₂-Arylalkyl-, C₆₋₃₁-Heteroarylalkyl-, C₈₋₃₃-Alkylarylalkylrest und einem C₇₋₃₂-Heteroalkylarylalkylrest.

Daher werden als Kupfersalze besonders bevorzugt eingesetzt CuCI, CuBr, Cu I, CuCN, CuSCN, CuOCN, Cu BH₄, CuSPh und Cu-C=C-Ph eingesetzt.

Der Fachmann kann erkennen welche organischen Liganden einzusetzen sind, um derartige Cu(I)-Komplexe zu erhalten.

Gemäß bevorzugten Beispielen sind die Reste in einer der Strukturen der Formeln (I) bis (VII) (sofern vorhanden) wie folgt definiert:
- R¹⁻⁶:: jeweils H oder ein C₁₋₁₀-Alkyl;
- R⁷ und R⁸:: jeweils ein Arylrest, insbesondere Phenyl;
- R⁹ und R¹⁰:: jeweils ein Alkylrest, insbesondere ein Methylrest, oder zusammen mit dem N oder E, an das sie gebunden sind, ein Ringsystem ausbildend wie beispielsweise einen Piperidyl-, Piperidyl- oder Morpholinylring;
- R¹¹ und R¹²:: jeweils Phenyl;
- R¹³ und R¹⁴:: jeweils ein Alkylrest, insbesondere ein Methylrest, oder zusammen mit dem N oder E, an das sie gebunden sind, ein Ringsystem ausbildend wie beispielsweise einen Piperidyl-, Piperidyl- oder Morpholinylring;
- R¹⁵⁻¹⁸:: jeweils ein Arylrest, insbesondere Phenyl;
- X:: jeweils ein Halogenid, insbesondere I, Br oder Cl; und
- Z:: ein C₁₋₇-Alkylen, insbesondere Butylen, oder bildet zusammen mit dem -N=C-Rest einen Pyridinylrest; und
- E:: N oder P, insbesondere N.

**Tabelle 4. Beispiele für im Sinne der Erfindung herstellbare Cu(I)-Komplexe gemäß Formel (I).**

| **R¹ und R² jeweils** | **R³, R⁴, R⁵ und R⁶ jeweils** | **R⁷, R⁸, R¹¹ und R¹² jeweils** | **R⁹, R¹⁰, R¹³ und R¹⁴** | **X jeweils** |
|---|---|---|---|---|
| H | H | Phenyl | jeweils Methyl | I |
| H | H | Phenyl | bilden zusammen mit dem N, an das sie gebunden sind, einen Pyrolidinylring | I |
| H | H | Phenyl | bilden zusammen mit dem N, an das sie gebunden sind, einen Piperidylring | I |
| H | H | Phenyl | bilden zusammen mit dem N, an das sie gebunden sind, einen Morpholinylring | I |
| H | H | Phenyl | jeweils Methyl | Cl |
| H | H | Phenyl | bilden zusammen mit dem N, an das sie gebunden sind, einen Pyrolidinylring | Cl |
| H | H | Phenyl | bilden zusammen mit dem N, an das sie gebunden sind, einen Piperidylring | Cl |
| H | H | Phenyl | bilden zusammen mit dem N, an das sie gebunden sind, einen Morpholinylring | Cl |
| H | H | Phenyl | jeweils Methyl | Br |
| H | H | Phenyl | bilden zusammen mit dem N, an das sie gebunden sind, einen Pyrolidinylring | Br |
| H | H | Phenyl | bilden zusammen mit dem N, an das sie gebunden sind, einen Piperidylring | Br |
| H | H | Phenyl | bilden zusammen mit dem N, an das sie gebunden sind, einen Morpholinylring | Br |

Beispiele für Komplexe nach Struktur der Formel (I) sind daher:

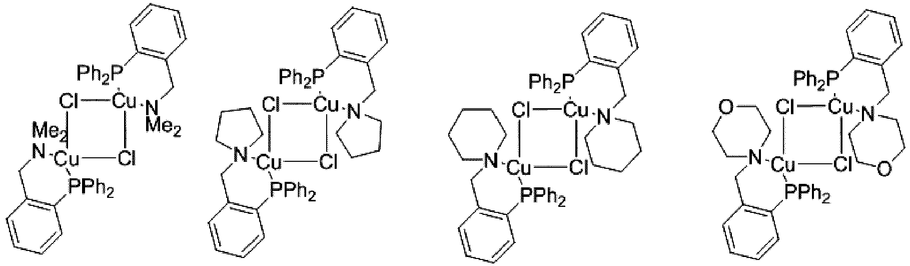

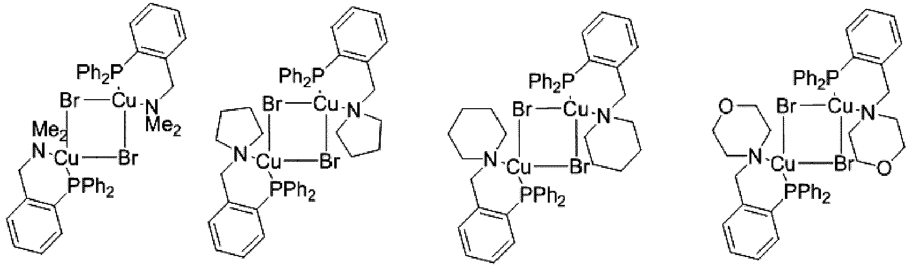

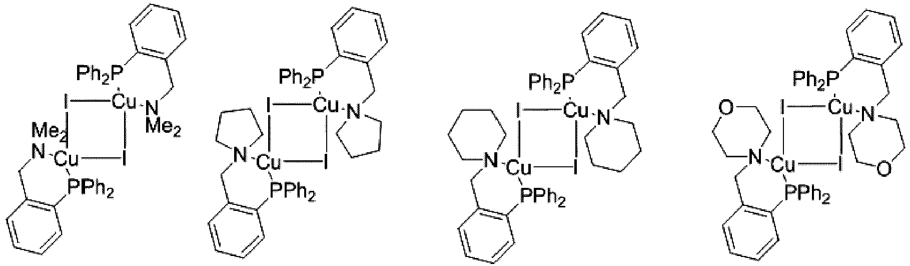

Daher können zur Erstellung eines Komplexes einer Struktur nach Struktur der Formel (I) als Liganden L beispielsweise folgende eingesetzt werden Liganden L ausgewählt aus:

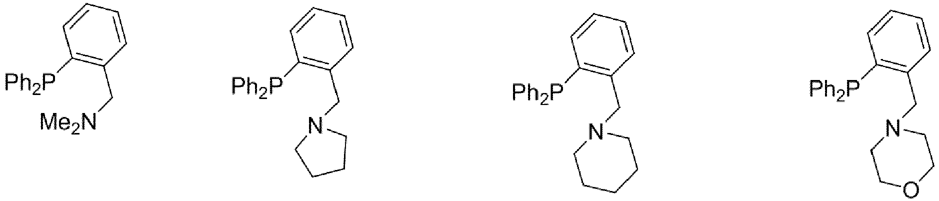

**Tabelle 5. Beispiele für im Sinne der Erfindung herstellbare Cu(I)-Komplexe gemäß Formel (II).**

| **R¹ und R² jeweils** | **R¹ und R⁸ jeweils** | **R⁹ und R¹⁰** | **R¹¹ und R12 jeweils** | **R¹³ und R¹⁴** | **X jeweils** |
|---|---|---|---|---|---|
| H | Phenyl | jeweils Methyl | Phenyl | jeweils Methyl | I |
| H | Phenyl | bilden zusammen mit dem N, an das sie gebunden sind, einen Pyrolidinylring | Phenyl | bilden zusammen mit dem N, an das sie gebunden sind, einen Pyrolidinylring | I |
| H | Phenyl | bilden zusammen mit dem N, an das sie gebunden sind, einen Piperidylring | Phenyl | bilden zusammen mit dem N, an das sie gebunden sind, einen Piperidylring | I |
| H | Phenyl | bilden zusammen mit dem N, an das sie gebunden sind, einen Morpholinylring | Phenyl | bilden zusammen mit dem N, an das sie gebunden sind, einen Morpholinylring | I |
| H | Phenyl | jeweils Methyl | Phenyl | jeweils Methyl | Cl |
| H | Phenyl | bilden zusammen mit dem N, an das sie gebunden sind, einen Pyrolidinylring | Phenyl | bilden zusammen mit dem N, an das sie gebunden sind, einen Pyrolidinylring | Cl |
| H | Phenyl | bilden zusammen mit dem N, an das sie gebunden sind, einen Piperidylring | Phenyl | bilden zusammen mit dem N, an das sie gebunden sind, einen Piperidylring | Cl |
| H | Phenyl | bilden zusammen mit dem N, an das sie gebunden sind, einen Morpholinylring | Phenyl | bilden zusammen mit dem N, an das sie gebunden sind, einen Morpholinylring | Cl |
| H | Phenyl | jeweils Methyl | Phenyl | jeweils Methyl | Br |
| H | Phenyl | bilden zusammen mit dem N, an das sie gebunden sind, einen Pyrolidinylring | Phenyl | bilden zusammen mit dem N, an das sie gebunden sind, einen Pyrolidinylring | Br |
| H | Phenyl | bilden zusammen mit dem N, an das sie gebunden sind, einen Piperidylring | Phenyl | bilden zusammen mit dem N, an das sie gebunden sind, einen Piperidylring | Br |
| H | Phenyl | bilden zusammen mit dem N, an das sie gebunden sind, einen Morpholinylring | Phenyl | bilden zusammen mit dem N, an das sie gebunden sind, einen Morpholinylring | Br |

Daher können zur Erstellung eines Komplexes einer Struktur nach Struktur der Formel (II) als Liganden L beispielsweise folgende eingesetzt werden Liganden L ausgewählt aus:

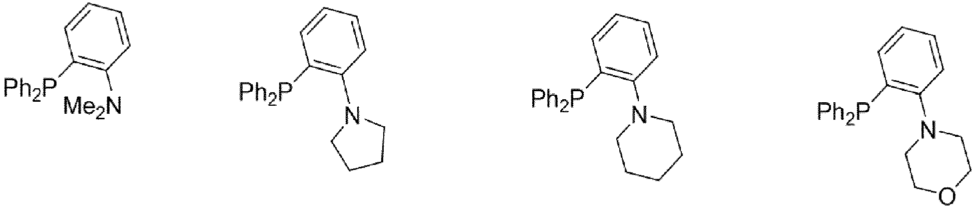

**Tabelle 6. Beispiele für im Sinne der Erfindung herstellbare Cu(I)-Komplexe gemäß Formel (III).**

| **R¹ und R² jeweils** | **R⁹, R¹⁰, R¹³ und R¹⁴** | **X jeweils** | **E** | **Z** |
|---|---|---|---|---|
| H | jeweils Methyl | I | N | Butylen |
| H | bilden zusammen mit dem E, an das sie gebunden sind, einen Pyrolidinylring | I | N | Butylen |
| H | bilden zusammen mit dem E, an das sie gebunden sind, einen Piperidylring | I | N | Butylen |
| H | jeweils Methyl | Cl | N | Butylen |
| H | bilden zusammen mit dem N, an das sie gebunden sind, einen Pyrolidinylring | Cl | N | Butylen |
| H | bilden zusammen mit dem N, an das sie gebunden sind, einen Piperidylring | Cl | N | Butylen |
| H | jeweils Methyl | Br | N | Butylen |
| H | bilden zusammen mit dem N, an das sie gebunden sind, einen Pyrolidinylring | Br | N | Butylen |
| H | bilden zusammen mit dem N, an das sie gebunden sind, einen Piperidylring | Br | N | Butylen |
| H | jeweils Methyl | I | N | bildet zusammen -N=C- einen Pyridinylrest |
| H | bilden zusammen mit dem E, an das sie gebunden sind, einen Pyrolidinylring | I | N | bildet zusammen -N=C- einen Pyridinylrest |
| H | bilden zusammen mit dem E, an das sie gebunden sind, einen Piperidylring | I | N | bildet zusammen -N=C- einen Pyridinylrest |
| H | jeweils Methyl | Cl | N | bildet zusammen -N=C- einen Pyridinylrest |
| H | bilden zusammen mit dem N, an das sie gebunden sind, einen Pyrolidinylring | Cl | N | bildet zusammen -N=C- einen Pyridinylrest |
| H | bilden zusammen mit dem N, an das sie gebunden sind, einen Piperidylring | Cl | N | bildet zusammen -N=C- einen Pyridinylrest |
| H | jeweils Methyl | Br | N | bildet zusammen -N=C- einen Pyridinylrest |
| H | bilden zusammen mit dem N, an das sie gebunden sind, einen Pyrolidinylring | Br | N | bildet zusammen -N=C- einen Pyridinylrest |
| H | bilden zusammen mit dem N, an das sie gebunden sind, einen Piperidylring | Br | N | bildet zusammen -N=C- einen Pyridinylrest |
| Methyl | jeweils Methyl | I | N | Butylen |
| Methyl | bilden zusammen mit dem E, an das sie gebunden sind, einen Pyrolidinylring | I | N | Butylen |
| Methyl | bilden zusammen mit dem E, an das sie gebunden sind, einen Piperidylring | I | N | Butylen |
| Methyl | jeweils Methyl | Cl | N | Butylen |
| Methyl | bilden zusammen mit dem N, an das sie gebunden sind, einen Pyrolidinylring | Cl | N | Butylen |
| Methyl | bilden zusammen mit dem N, an das sie gebunden sind, einen Piperidylring | Cl | N | Butylen |
| Methyl | jeweils Methyl | Br | N | Butylen |
| Methyl | bilden zusammen mit dem N, an das sie gebunden sind, einen Pyrolidinylring | Br | N | Butylen |
| Methyl | bilden zusammen mit dem N, an das sie gebunden sind, einen Piperidylring | Br | N | Butylen |
| Methyl | jeweils Methyl | I | N | bildet zusammen -N=C- einen Pyridinylrest |
| Methyl | bilden zusammen mit dem E, an das sie gebunden sind, einen Pyrolidinylring | I | N | bildet zusammen -N=C- einen Pyridinylrest |
| Methyl | bilden zusammen mit dem E, an das sie gebunden sind, einen Piperidylring | I | N | bildet zusammen -N=C- einen Pyridinylrest |
| Methyl | jeweils Methyl | Cl | N | bildet zusammen -N=C- einen Pyridinylrest |
| Methyl | bilden zusammen mit dem N, an das sie gebunden sind, einen Pyrolidinylring | Cl | N | bildet zusammen -N=C- einen Pyridinylrest |
| Methyl | bilden zusammen mit dem N, an das sie gebunden sind, einen Piperidylring | Cl | N | bildet zusammen -N=C- einen Pyridinylrest |
| Methyl | jeweils Methyl | Br | N | bildet zusammen -N=C- einen Pyridinylrest |
| Methyl | bilden zusammen mit dem N, an das sie gebunden sind, einen Pyrolidinylring | Br | N | bildet zusammen -N=C- einen Pyridinylrest |
| Methyl | bilden zusammen mit dem N, an das sie gebunden sind, einen Piperidylring | Br | N | bildet zusammen -N=C- einen Pyridinylrest |

**Tabelle 7. Beispiele für im Sinne der Erfindung herstellbare Cu(I)-Komplexe gemäß Formel (IV).**

| **R⁷ und R⁸ jeweils** | **R¹¹ und R¹² jeweils** | **X jeweils** | **Z** |
|---|---|---|---|
| Phenyl | Phenyl | I | Butylen |
| Phenyl | Phenyl | I | Butylen |
| Phenyl | Phenyl | I | Butylen |
| Phenyl | Phenyl | Cl | Butylen |
| Phenyl | Phenyl | Cl | Butylen |
| Phenyl | Phenyl | Cl | Butylen |
| Phenyl | Phenyl | Br | Butylen |
| Phenyl | Phenyl | Br | Butylen |
| Phenyl | Phenyl | Br | Butylen |
| Phenyl | Phenyl | I | bildet zusammen -N=C- einen Pyridinylrest |
| Phenyl | Phenyl | I | bildet zusammen -N=C- einen Pyridinylrest |
| Phenyl | Phenyl | I | bildet zusammen -N=C- einen Pyridinylrest |
| Phenyl | Phenyl | Cl | bildet zusammen -N=C- einen Pyridinylrest |
| Phenyl | Phenyl | Cl | bildet zusammen -N=C- einen Pyridinylrest |
| Phenyl | Phenyl | Cl | bildet zusammen -N=C- einen Pyridinylrest |
| Phenyl | Phenyl | Br | bildet zusammen -N=C- einen Pyridinylrest |
| Phenyl | Phenyl | Br | bildet zusammen -N=C- einen Pyridinylrest |
| Phenyl | Phenyl | Br | bildet zusammen -N=C- einen Pyridinylrest |

**Tabelle 8. Beispiele für im Sinne der Erfindung herstellbare Cu(I)-Komplexe gemäß Formel (V).**

| **R⁷ und R⁸ jeweils** | **R¹¹ und R¹² jeweils** | **X jeweils** | **Z** |
|---|---|---|---|
| Phenyl | Phenyl | I | Butylen |
| Phenyl | Phenyl | I | Butylen |
| Phenyl | Phenyl | I | Butylen |
| Phenyl | Phenyl | Cl | Butylen |
| Phenyl | Phenyl | Cl | Butylen |
| Phenyl | Phenyl | Cl | Butylen |
| Phenyl | Phenyl | Br | Butylen |
| Phenyl | Phenyl | Br | Butylen |
| Phenyl | Phenyl | Br | Butylen |
| Phenyl | Phenyl | I | bildet zusammen -N=C- einen Pyridinylrest |
| Phenyl | Phenyl | I | bildet zusammen -N=C- einen Pyridinylrest |
| Phenyl | Phenyl | I | bildet zusammen -N=C- einen Pyridinylrest |
| Phenyl | Phenyl | Cl | bildet zusammen -N=C- einen Pyridinylrest |
| Phenyl | Phenyl | Cl | bildet zusammen -N=C- einen Pyridinylrest |
| Phenyl | Phenyl | Cl | bildet zusammen -N=C- einen Pyridinylrest |
| Phenyl | Phenyl | Br | bildet zusammen -N=C- einen Pyridinylrest |
| Phenyl | Phenyl | Br | bildet zusammen -N=C- einen Pyridinylrest |
| Phenyl | Phenyl | Br | bildet zusammen -N=C- einen Pyridinylrest |

**Tabelle 9. Beispiele für im Sinne der Erfindung herstellbare Cu(I)-Komplexe gemäß Formel (VI).**

| **R¹ und R² jeweils** | **R⁷, R⁸, R¹¹, R¹², R¹⁵, R¹⁸, R¹⁷ und R¹⁸ jeweils** | **X jeweils** |
|---|---|---|
| H | Phenyl | I |
| H | Phenyl | Cl |
| H | Phenyl | Br |

Daher kann ein Ligand L der folgenden Formel eingesetzt werden:

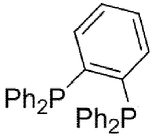

**Tabelle 10. Beispiele für im Sinne der Erfindung herstellbare Cu(I)-Komplexe gemäß Formel (VII).**

| **R¹ und R² jeweils** | **R⁷, R⁸, R¹¹ und R¹² jeweils** | **X jeweils** |
|---|---|---|
| H | Phenyl | I |
| H | Phenyl | Cl |
| H | Phenyl | Br |

Daher kann ein Ligand L der folgenden Formel eingesetzt werden:

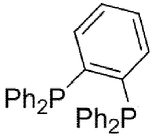

### Referenzen

DE 102011017572
europäische Patentanmeldung Nr. EP14164815
WO 2010/031485
WO 2010/149748
WO 2012/016074
WO 2012/130571
WO 2013/001086
WO 2013/007707
WO 2013/007709
WO 2013/007710
WO 2013/014066
WO 2013/017675
WO 2013/072508
WO 2014/102079
Liu, Z.; Qayyum, M. F.; Wu, C.; Whited, M. T.; Djurovich, P. I.; Hodgson, K. O.; Hedman, B.; Solomon, E. I.; Thompson, M. E.; A Codeposition Route to Cul-Pyridine Coordination Complexes for Organic Light-Emitting Diodes; J. Am. Chem. Soc. 2011, 133, 3700-3703;
Liu, Z.; Qiu, J.; Wei, F.; Wang, J.; Liu, X.; Helander, M. G.; Rodney, S.; Wang, Z.; Bian, Z.; Lu, Z.; Thompson, M. E.; Huang, C.; Simple and High Efficiency Phosphorescence Organic Light-Emitting Diodes with Codeposited Copper(I) Emitter; Chem. Mater. 2014, 26(7), 2368-2373;
So, F. and Kondakov, D.; Degradation Mechanism in Small-Molecule and Polymer Organic Light-Emitting Diodes; Adv. Mater. 2010, 22, 3762-3777;
Yamamoto, H.; Adachi, C.; Weaver, M. S.; Brown, J. J.; Identification of device degradation positions in multi-layered phosphorescent organic light emitting devices using water probes; Appl. Phys. Lett. 2012, 100, 183306);
Schmid, G.; Wemken, J. H.; Maltenberger, A.; Diez, C.; Jaeger, A.; Dobbertin, T.; Hietsoi, O.; Dubceac, C.; Petrukhina, M. A.; Fluorinated Copper(I) Carboxylates as Advanced Tunable p-Dopants for Organic Light-Emitting Diodes; Adv. Mater. 2014, 26, 878-885.

## Patentansprüche

1. Verfahren zur Aufbringung einer lichtemittierenden Schicht S auf der Oberfläche eines Bauteils T, umfassend die Schritte:
(i) Bereitstellen von:
(a) einer Zusammensetzung Z1 enthaltend mindestens ein Salz eines nicht-komplexierten Metalls M und mindestens ein koordinierendes Lösungsmittel,
(b) einer Zusammensetzung Z2 enthaltend mindestens einen nicht-komplexierten Liganden L, der das Metall M komplexieren kann, und optional
(c) einer Zusammensetzung Z3 enthaltend mindestens ein Wirtsmolekül W, das eine Matrix für die lichtemittierende Schicht S bilden kann;
(ii) Aufbringen der Zusammensetzungen Z1, Z2 und optional Z3 in flüssiger Phase auf die Oberfläche des Bauteils T; und optional
(iii) Trocknen und/oder Aushärten der durch das Aufbringen erhaltenen Schicht S auf der Oberfläche des Bauteils T,
**dadurch gekennzeichnet, dass** die Zusammensetzungen Z1 und Z2 als zwei separate Zusammensetzungen gleichzeitig auf die Oberfläche des Bauteils T aufgebracht werden, wobei sich die Zusammensetzungen Z1, Z2 und optional Z3 auf der Oberfläche selbst mischen.

2. Verfahren gemäß Anspruch 1, **dadurch gekennzeichnet, dass** die Zusammensetzungen Z1 und Z2 so gewählt werden, dass ein Überschuss von mindestens 0,1 Mol-%, bevorzugt mindestens 0,5 Mol-%, stärker bevorzugt mindestens 1 Mol-%, insbesondere mindestens 5 Mol-% an Metall M gegenüber Ligand L auf die Oberfläche des Bauteils T aufgebracht wird.

3. Verfahren gemäß einem der Ansprüche 1 oder 2, **dadurch gekennzeichnet, dass** die Zusammensetzungen Z1 und Z2 so gewählt werden, dass ein Überschuss von mindestens 1 Mol-%, bevorzugt mindestens 5 Mol-%, stärker bevorzugt mindestens 10 Mol-%, insbesondere mindestens 20 Mol-% an Ligand L gegenüber Metall M auf die Oberfläche des Bauteils T aufgebracht wird.

4. Verfahren gemäß einem der Ansprüche 1 bis 3, **dadurch gekennzeichnet, dass** der Schritt (ii) des Aufbringens der Zusammensetzungen Z1, Z2 und optional Z3 auf die Oberfläche des Bauteils T mittels Rotationsbeschichtung durchgeführt wird.

5. Verfahren gemäß einem der Ansprüche 1 bis 4, **dadurch gekennzeichnet, dass** das Metall M ausgewählt ist aus der Gruppe bestehend aus Cu, Ag und Au, bevorzugt ein Metall(I) ausgewählt aus der Gruppe bestehend aus Cu(I), Ag(I) und Au(I), insbesondere Cu(I).

## Claims

1. A method of applying a light-emitting layer S to the surface of a component T, comprising the steps:
(i) providing:
(a) a composition Z1 comprising at least one salt of a non-complexed metal M and at least one coordinating solvent,
(b) a composition Z2 comprising at least one non-complexed ligand L capable of complexing the metal M, and optionally
(c) a composition Z3 comprising at least one host molecule W capable of forming a matrix for the light-emitting layer S;
(ii) applying the compositions Z1, Z2 and optionally Z3 in liquid phase to the surface of the component T; and optionally
(iii) drying and/or curing the layer S obtained by the application on the surface of the component T,
**characterized in that** the compositions Z1 and Z2 are applied as two separate compositions simultaneously to the surface of the component T, the compositions Z1, Z2 and optionally Z3 mixing themselves on the surface.

2. The process according to claim 1, **characterized in that** the compositions Z1 and Z2 are chosen such that an excess of at least 0.1 mol%, preferably at least 0.5 mol%, more preferably at least 1 mol%, in particular at least 5 mol% of metal M over ligand L is applied to the surface of the component T.

3. The process according to one of claims 1 or 2, **characterized in that** the compositions Z1 and Z2 are chosen such that an excess of at least 1 mol%, preferably at least 5 mol%, more preferably at least 10 mol%, in particular at least 20 mol% of ligand L over metal M is applied to the surface of the component T.

4. The process according to any one of claims 1 to 3, **characterized in that** step (ii) of applying the compositions Z1, Z2 and optionally Z3 to the surface of the component T is carried out by means of spin coating.

5. The process according to any one of claims 1 to 4, **characterized in that** the metal M is selected from the group consisting of Cu, Ag and Au, preferably a metal (I) selected from the group consisting of Cu(I), Ag(I) and Au(I), in particular Cu(I).

## Revendications

1. Procédé d'application d'une couche électroluminescente S sur la surface d'une pièce T, comprenant les étapes suivantes :
(i) fourniture
(a) d'une composition Z1 contenant au moins un sel d'un métal non complexé M et au moins un solvant coordinant,
(b) d'une composition Z2 contenant au moins un ligand non complexé L, qui peut complexer le métal M, et éventuellement
(c) d'une composition Z3 contenant au moins une molécule hôte W, qui peut former une matrice pour la couche électroluminescente S ;
(ii) application des compositions Z1, Z2 et éventuellement Z3 en phase liquide sur la surface de la pièce T ; et éventuellement
(iii) séchage et/ou durcissement, sur la surface de la pièce T, de la couche S obtenue par l'application,
**caractérisé en ce que** les compositions Z1 et Z2 sont appliquées sous forme de deux compositions distinctes simultanément sur la surface de la pièce T, les compositions Z1, Z2 et éventuellement Z3 se mélangeant sur la surface même.

2. Procédé selon la revendication 1, **caractérisé en ce que** les compositions Z1 et Z2 sont choisies de façon qu'un excès d'au moins 0,1 % en moles, de préférence d'au moins 0,5 % en moles, plus préférentiellement d'au moins 1 % en moles, en particulier d'au moins 5 % en moles du métal M, par rapport au ligand L, soit appliqué sur la surface de la pièce T.

3. Procédé selon l'une des revendications 1 ou 2, **caractérisé en ce que** les compositions Z1 et Z2 sont choisies de façon qu'un excès d'au moins 1 % en moles, de préférence d'au moins 5 % en moles, plus préférentiellement d'au moins 10 % en moles, en particulier d'au moins 20 % en moles du ligand L, par rapport au métal M, soit appliqué sur la surface de la pièce T.

4. Procédé selon l'une des revendications 1 à 3, **caractérisé en ce que** l'étape (ii) d'application des compositions Z1, Z2 et éventuellement Z3 sur la surface de la pièce T est mise en oeuvre par application à la tournette.

5. Procédé selon l'une des revendications 1 à 4, **caractérisé en ce que** le métal M est choisi dans le groupe consistant en Cu, Ag et Au, de préférence en un métal(I) choisi dans le groupe consistant en Cu(I), Ag(I) et Au(I), en particulier Cu(I).
